# EUROPEAN PATENT APPLICATION

(11) **EP 2 806 643 A1**
(43) Date of publication of application: **26.11.2014**
(21) Application number: 13738950.8
(22) Date of filing: 08.01.2013
(51) Int. Cl.: H04N 9/07, H01L 27/14, H04N 5/225, H04N 5/232, H04N 5/335, H04N 5/369, H04N 13/02, H04N 101/00

(54) **SOLID-STATE IMAGE SENSOR AND CAMERA SYSTEM**

(30) Priority: 16.01.2012 JP 2012006162
(71) Applicant: Sony Corporation, Tokyo 108-0075 (JP)
(72) Inventor: HIROTA Isao, Tokyo 1080075 (JP)
(74) Representative: MFG Patentanwälte Meyer-Wildhagen Meggle-Freund Gerhard PartG mbB
(86) International application number: PCT/JP2013/050092
(87) International publication number: WO 2013/108656

(57) **Abstract**

A solid-state image pickup device includes: a pixel array section including a plurality of color pixels and a plurality of main component pixels for luminance that are arranged in an array, the color pixels and the main component pixels for luminance each having a photoelectric conversion function, in which the pixel array section includes first and second pixel groups each including a plurality of pixels, and the main component pixels for luminance are assigned to the first pixel group, and the color pixels are assigned to the second pixel group.

## Description

### Technical Field

The present technology relates to a solid-state image pickup device applicable to, for example, a stereo camera or a monocular or compound-eye three-dimensional (3D) stereo camera that adopt light field technology, and a camera system.

### Background Art

As light field cameras, techniques disclosed in PTL 1 and PTL 2 are known.

In the technique disclosed in PTL 1, color coding (color arrangement) of a color filter array has a checkerboard-like arrangement (a zigzag arrangement) that is obtained by rotating an RBG Bayer arrangement by 45° and allows four pixels vertically and horizontally adjacent to one another to have a same color. In other words, color coding in which respective filters of RGB are arranged in a square arrangement based on a unit of four pixels with a same color is achieved.

Further, one multi-lens array is shared by a unit of four pixels (two pixels on the top and bottomxtwo pixels on the right and left) with different colors so as to be disposed over the four pixels.

Moreover, also in the technique disclosed in PTL 2, pixels are two-dimensionally arranged in a zigzag arrangement along two directions rotated by 45° from a horizontal direction and a vertical direction.

With the use of a microlens array, light rays from an object that is to be subjected to image pickup are recorded by an image pickup device as light-ray vectors having perspectives different from one another, and parallax information is obtained accordingly. Since the image pickup device has the above-described pixel arrangement, pixel pitches in the horizontal direction and the vertical direction are smaller, compared to a case where pixels with a same size are two-dimensionally arranged along the horizontal and vertical directions.

### Citation list

### Patent Literature

[PTL 1] Japanese Unexamined Patent Application Publication No. 2010-239337
[PTL 2] Japanese Unexamined Patent Application Publication No. 2010-154493

### Summary

However, in the techniques disclosed in PTL 1 and PTL 2, basically, main component (green or white) pixels for luminance for obtaining resolution are divided into L/R for stereo; therefore, resolution is reduced to half.

Moreover, in a frame sequential system that avoids deterioration in resolution, storage time is reduced to 1/2, thereby reducing sensitivity to 1/2.

Further, in a method of division into two, i.e., L/R, a data amount is doubled, thereby causing a twofold increase in speed and electric power.

In the techniques disclosed in PTL 1 and PTL 2, to obtain full resolution, it is desirable to have a complicated configuration and to perform complicated signal processing.

Therefore, it is desirable to provide a solid-state image pickup device capable of suppressing deterioration in resolution and sensitivity caused by stereo, and reduction in speed and electric power without need for a complicated configuration and complicated signal processing, and a camera system.

A solid-state image pickup device according to a first aspect of an embodiment of the present technology includes: a pixel array section including a plurality of color pixels and a plurality of main component pixels for luminance that are arranged in an array, the color pixels and the main component pixels for luminance each having a photoelectric conversion function, in which the pixel array section includes first and second pixel groups each including a plurality of pixels, the first and second pixel groups having parallax therebetween, and the main component pixels for luminance are assigned to the first pixel group, and the color pixels are assigned to the second pixel group.

A camera system according to a second aspect of an embodiment of the present technology is provided with a solid-state image pickup device and an optical system configured to form an image of an object on the solid-state image pickup device, the solid-state image pickup device including: a pixel array section including a plurality of color pixels and a plurality of main component pixels for luminance that are arranged in an array, the color pixels and the main component pixels for luminance each having a photoelectric conversion function, in which the pixel array section includes first and second pixel groups each including a plurality of pixels, the first and second pixel groups having parallax therebetween, and the main component pixels for luminance are assigned to the first pixel group, and the color pixels are assigned to the second pixel group.

In the solid-state image pickup device according to the first aspect of the embodiment of the present technology and the camera system according to the second aspect, deterioration in resolution and sensitivity caused by stereo, and reduction in speed and electric power are allowed to be suppressed without need for a complicated configuration and complicated signal processing.

### Brief Description of Diagrams

[FIG. 1] FIG. 1 is a system configuration diagram illustrating an outline of a configuration of a solid-state image pickup device (CMOS image sensor) according to the present embodiment.
[FIG. 2] FIG. 2 is a circuit diagram illustrating an example of a circuit configuration of a unit pixel.
[FIG. 3] FIG. 3 is a diagram illustrating a basic pixel configuration example of a back-illuminated type solid-state image pickup device.
[FIG. 4] FIG. 4 is a diagram illustrating a well structure example of a semiconductor substrate in FIG. 3.
[FIG. 5] FIG. 5 is a circuit diagram illustrating an example of a circuit configuration in a case where adjacent four-pixel addition is performed in a pixel.
[FIG. 6] FIG. 6 is a diagram illustrating a Bayer arrangement as a pixel arrangement example.
[FIG. 7] FIG. 7 is a conceptual diagram of pixel division according to the present embodiment.
[FIG. 8] FIG. 8 is a diagram illustrating a first characteristic configuration example of the solid-state image pickup device (CMOS image sensor) according to the present embodiment.
[FIG. 9] FIG. 9 is a diagram illustrating a second characteristic configuration example of the solid-state image pickup device (CMOS image sensor) according to the present embodiment.
[FIG. 10] FIG. 10 is a diagram illustrating a third characteristic configuration example of the solid-state image pickup device (CMOS image sensor) according to the present embodiment.
[FIG. 11] FIG. 11 is a diagram illustrating a fourth characteristic configuration example of the solid-state image pickup device (CMOS image sensor) according to the present embodiment.
[FIG. 12] FIG. 12 is a diagram illustrating a configuration example of a monocular 3D-ready signal processing system in a case where main component pixels for luminance are W pixels.
[FIG. 13] FIG. 13 is an enlarged view illustrating a process of dividing pixels for luminance and color pixels in a monocular 3D-ready solid-state image pickup device in a case where main component pixels for luminance are G pixels.
[FIG. 14] FIG. 14 is a diagram illustrating a configuration example of a monocular 3D-ready signal processing system in a case where main component pixels for luminance are G pixels.
[FIG. 15] FIG. 15 is a diagram illustrating another configuration example of the monocular 3D-ready signal processing system in the case where the main component pixels for luminance are W pixels.
[FIG. 16] FIG. 16 is a diagram illustrating another configuration example of the monocular 3D-ready signal processing system in the case where the main component pixels for luminance are G pixels.
[FIG. 17] FIG. 17 is a diagram illustrating a pixel arrangement of a polarization system corresponding to the configurations in FIGs. 12 and 15.
[FIG. 18] FIG. 18 is a diagram illustrating a pixel arrangement of a polarization system corresponding to the configurations in FIGs. 14 and 16.
[FIG. 19A] FIG. 19A is a diagram illustrating a configuration example of a solid-state image pickup device (monocular 3D-ready) in which IR pixels are mixed with main component pixels (W pixels) for luminance.
[FIG. 19B] FIG. 19B is a diagram illustrating a configuration example of the solid-state image pickup device (monocular 3D-ready) in which IR pixels are mixed with main component pixels (W pixels) for luminance.
[FIG. 19C] FIG. 19C is a characteristic diagram illustrating luminance and a spectrum distribution of each color light.
[FIG. 20A] FIG. 20A is a diagram illustrating a configuration example of the solid-state image pickup device (monocular 3D-ready) in which IR pixels are mixed with main component pixels (W pixels) for luminance.
[FIG. 20B] FIG. 20B is a diagram illustrating a configuration example of the solid-state image pickup device (monocular 3D-ready) in which IR pixels are mixed with main component pixels (W pixels) for luminance.
[FIG. 21A] FIG. 21A is a diagram illustrating a configuration example of a solid-state image pickup device (monocular 3D-ready) in which IR pixels are mixed with main component pixels (G pixels) for luminance.
[FIG. 21B] FIG. 21B is a diagram illustrating a configuration example of the solid-state image pickup device (monocular 3D-ready) in which IR pixels are mixed with main component pixels (G pixels) for luminance.
[FIG. 22A] FIG. 22A is a diagram illustrating a configuration example of the solid-state image pickup device (monocular 3D-ready) in which IR pixels are mixed with main component pixels (G pixels) for luminance.
[FIG. 22B] FIG. 22B is a diagram illustrating a configuration example of the solid-state image pickup device (monocular 3D-ready) in which IR pixels are mixed with main component pixels (G pixels) for luminance.
[FIG. 23A] FIG. 23A is a diagram illustrating a configuration example of a solid-state image pickup device (monocular 3D-ready) using W pixels and G pixels as main component pixels for luminance.
[FIG. 23B] FIG. 23B is a diagram illustrating a configuration example of the solid-state image pickup device (monocular 3D-ready) using W pixels and G pixels as main component pixels for luminance.
[FIG. 24A] FIG. 24A is a diagram illustrating a configuration example of a solid-state image pickup device (monocular 3D-ready) in which IR pixels are mixed with main component pixels (W and G pixels) for luminance.
[FIG. 24B] FIG. 24B is a diagram illustrating a configuration example of a solid-state image pickup device (monocular 3D-ready) in which IR pixels are mixed with main component pixels (W and G pixels) for luminance.
[FIG. 25] FIG. 25 is a diagram illustrating a first configuration example of a solid-state image pickup device (binocular 2-chip 3D-ready) in a case where main component pixels for luminance are W pixels.
[FIG. 26] FIG. 26 is a diagram conceptually illustrating a process of performing space phase displacement on L/R images after being subjected to a parallax shift by the solid-state image pickup device in FIG. 25.
[FIG. 27] FIG. 27 is a diagram illustrating a second configuration example of the solid-state image pickup device (binocular 2-chip 3D-ready) in the case where main component pixels for luminance are W pixels.
[FIG. 28] FIG. 28 is a diagram illustrating a third configuration example of the solid-state image pickup device (binocular 2-chip 3D-ready) in the case where main component pixels for luminance are G pixels.
[FIG. 29] FIG. 29 is a diagram illustrating a fourth configuration example of the solid-state image pickup device (binocular 2-chip 3D-ready) in the case where main component pixels for luminance are G pixels.
[FIG. 30] FIG. 30 is a diagram illustrating a configuration example of a solid-state image pickup device (binocular 2-chip 3D-ready/square arrangement) in which IR pixels are mixed with main component pixels (W pixels) for luminance.
[FIG. 31] FIG. 31 is a diagram illustrating a configuration example of the solid-state image pickup device (binocular 2-chip 3D-ready/square arrangement) in which IR pixels are mixed with main component pixels (W pixels) for luminance.
[FIG. 32] FIG. 32 is a diagram illustrating a configuration example of a solid-state image pickup device (binocular 2-chip 3D-ready/zigzag arrangement) in which IR pixels are mixed with main component pixels (W pixels) for luminance.
[FIG. 33] FIG. 33 is a diagram illustrating a configuration example of the solid-state image pickup device (binocular 2-chip 3D-ready/zigzag arrangement) in which IR pixels are mixed with main component pixels (W pixels) for luminance.
[FIG. 34] FIG. 34 is a diagram illustrating a configuration example of the solid-state image pickup device (binocular 2-chip 3D-ready/zigzag arrangement) in which IR pixels are mixed with main component pixels (W pixels) for luminance.
[FIG. 35] FIG. 35 is a diagram illustrating a configuration example of the solid-state image pickup device (binocular 2-chip 3D-ready/zigzag arrangement) in which IR pixels are mixed with main component pixels (W pixels) for luminance.
[FIG. 36] FIG. 36 is a diagram illustrating a configuration example of a solid-state image pickup device (binocular 2-chip 3D-ready/square arrangement) in which IR pixels are mixed with main component pixels (G pixels) for luminance.
[FIG. 37] FIG. 37 is a diagram illustrating a configuration example of the solid-state image pickup device (binocular 2-chip 3D-ready/square arrangement) in which IR pixels are mixed with main component pixels (G pixels) for luminance.
[FIG. 38] FIG. 38 is a diagram illustrating a configuration example of a solid-state image pickup device (binocular 2-chip 3D-ready/zigzag arrangement) in which IR pixels are mixed with main component pixels (G pixels) for luminance.
[FIG. 39] FIG. 39 is a diagram illustrating a configuration example of the solid-state image pickup device (binocular 2-chip 3D-ready/zigzag arrangement) in which IR pixels are mixed with main component pixels (G pixels) for luminance.
[FIG. 40] FIG. 40 is a diagram illustrating a configuration example of the solid-state image pickup device (binocular 2-chip 3D-ready/zigzag arrangement) in which IR pixels are mixed with main component pixels (G pixels) for luminance.
[FIG. 41A] FIG. 41A is a diagram illustrating a configuration example of a solid-state image pickup device (binocular 2-chip 3D-ready/square arrangement) using W pixels and G pixels as main component pixels for luminance.
[FIG. 41B] FIG. 41B is a schematic diagram for describing a signal processing example in the solid-state image pickup device illustrated in FIG. 41A.
[FIG. 42] FIG. 42 is a diagram illustrating a configuration example of a solid-state image pickup device (binocular 2-chip 3D-ready/zigzag arrangement) using W pixels and G pixels as main component pixels for luminance.
[FIG. 43] FIG. 43 is a diagram illustrating a configuration example of the solid-state image pickup device (binocular 2-chip 3D-ready/zigzag arrangement) using W pixels and G pixels as main component pixels for luminance.
[FIG. 44] FIG. 44 is a diagram illustrating a configuration example of a solid-state image pickup device (binocular 2-chip 3D-ready/square arrangement) in which IR pixels are mixed with main component pixels (W and G pixels) for luminance.
[FIG. 45] FIG. 45 is a diagram illustrating a configuration example of the solid-state image pickup device (binocular 2-chip 3D-ready/square arrangement) in which IR pixels are mixed with main component pixels (W and G pixels) for luminance.
[FIG. 46] FIG. 46 is a diagram illustrating a configuration example of a solid-state image pickup device (binocular 2-chip 3D-ready/zigzag arrangement) in which IR pixels are mixed with main component pixels (W and G pixels) for luminance.
[FIG. 47] FIG. 47 is a diagram illustrating a configuration example of the solid-state image pickup device (binocular 2-chip 3D-ready/zigzag arrangement) in which IR pixels are mixed with main component pixels (W and G pixels) for luminance.
[FIG. 48] FIG. 48 is a diagram illustrating a configuration example of the solid-state image pickup device (binocular 2-chip 3D-ready/zigzag arrangement) in which IR pixels are mixed with main component pixels (W and G pixels) for luminance.
[FIG. 49] FIG. 49 is a diagram illustrating a configuration example of the solid-state image pickup device (binocular 2-chip 3D-ready/zigzag arrangement) in which IR pixels are mixed with main component pixels (W and G pixels) for luminance.
[FIG. 50] FIG. 50 is a diagram conceptually illustrating a process in which super-resolution technology is applied to a signal processing system of the solid-state image pickup device (MOS image sensor) in FIG. 25.
[FIG. 51] FIG. 51 is a diagram conceptually illustrating a process in which super-resolution technology is applied to a signal processing system of the solid-state image pickup device (MOS image sensor) in FIG. 28.
[FIG. 52] FIG. 52 is a diagram illustrating an example of a configuration of a camera system to which the solid-state image pickup device according to the present embodiment is applied.

### Description of Embodiments

Some embodiments of the present invention will be described below referring to the accompanying drawings.

It is to be noted that description will be given in the following order.
1. Configuration Example of Solid-state Image Pickup Device (Example of CMOS Image Sensor)
2. Characteristic Configuration of Present Embodiment
   2-1. First Characteristic Configuration Example
   2-2. Second Characteristic Configuration Example
   2-3. Third Characteristic Configuration Example
   2-4. Fourth Characteristic Configuration Example
3. Signal Processing System in Monocular Case
   3-1. First Configuration Example of Signal Processing System
   3-2. Second Configuration Example of Signal Processing System
   3-3. Third Configuration Example of Signal Processing System
   3-4. Fourth Configuration Example of Signal Processing System
   3-5. Another Configuration Example in Monocular Case
4. Binocular or Monocular 2-chip Signal Processing System
   4-1. First Configuration Example of Binocular 2-chip 3D-ready Solid-state Image Pickup Device
   4-2. Second Configuration Example of Binocular 2-chip 3D-ready Solid-state Image Pickup Device
   4-3. Third Configuration Example of Binocular 2-chip 3D-ready Solid-state Image Pickup Device
   4-4. Fourth Configuration Example of Binocular 2-chip 3D-ready Solid-state Image Pickup Device
   4-5. Another Configuration Example in Binocular 2-chip Case
   4-6. First Example of Binocular 2-chip 3D-ready Signal Processing System to which Super-resolution Technology is Applied
   4-7. Second Example of Binocular 2-chip 3D-ready Signal Processing System to which Super-resolution Technology is Applied
5. Configuration Example of Camera System

### (1. Configuration Example of Solid-state Image Pickup Device)

### [System Configuration]

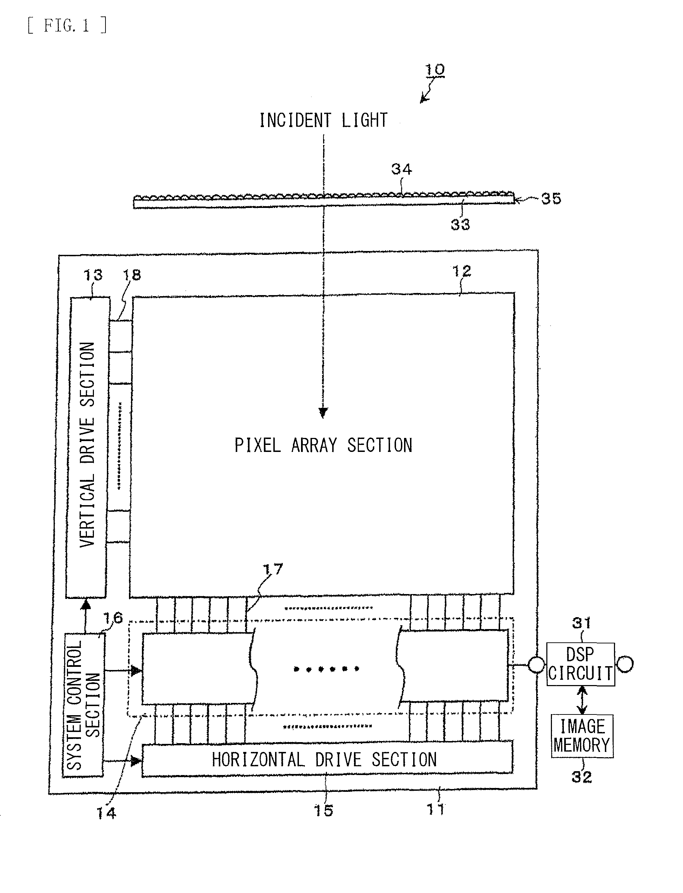

FIG. 1 is a system configuration example illustrating an outline of a configuration of a solid-state image pickup device according to the present embodiment, for example, a CMOS image sensor as a kind of an X-Y address type solid-state image pickup unit.

A CMOS image sensor 10 according to the present embodiment includes a pixel array section 12 formed on a semiconductor substrate (hereinafter, may be simply referred to as "sensor chip") 11 and a peripheral circuit section integrated on the same semiconductor substrate 11 where the pixel array section 12 is disposed.

As the peripheral circuit section, for example, a vertical drive section 13, a column processing section 14, a horizontal drive section 15, and a system control section 16 are provided. Moreover, a DSP (Digital Signal Processor) circuit 31 and an image memory 32 are provided outside the sensor chip 11.

In the pixel array section 12, unit pixels (hereinafter, may be simply referred to as "pixels") that are not illustrated and each include a photoelectric conversion device or a photoelectric conversion film photoelectrically converting incident visible light into an electric charge amount corresponding to a light amount of the light are arranged in an array.

A specific circuit configuration and a specific laminate configuration of the unit pixel will be described later. In an example in FIG. 1, a color filter array 33 and a photoelectric conversion film are formed on a light reception surface (a light incident surface) of the pixel array section 12, and a multi-lens array (MLA) 34 is arranged above the color filter array 33 and the photoelectric conversion film. Moreover, an on-chip lens OCL is arranged on the color filter array 33 and the photoelectric conversion film.

Basically, in the present embodiment, as will be described later, a configuration in which LR parallax separation is performed with the use of a multi-lens array (MLA) is adopted as a light field stereo version.

Further, as will be described later, the present embodiment is configured so as to allow a 2D (two-dimensional) image or a 3D stereo WDR image to be obtained by a monocular or compound-eye (binocular) configuration while suppressing deterioration in resolution and sensitivity caused by stereo and reduction in speed and electric power.

In the present embodiment, as will be described later, main component pixels (W or/and G) for luminance are assigned to one channel (ch) of L/R for stereo, and color pixels (G, R, and B) are assigned to the other channel.

Thus, deterioration in luminance resolution and color resolution is allowed to be avoided.

It is to be noted that, "channel" in the present embodiment (and the following embodiments and the like) corresponds to one perspective (one direction) in a so-called stereo system. In this description, L and R channels corresponding to a left perspective and a right perspective are examples. Moreover, a "pixel group" in a solid-state image pickup device of the present technology corresponds to a group of pixels for obtaining an image taken from a direction corresponding to one channel. In other words, a "first pixel group" and a "second pixel group" have a parallax therebetween (a parallax is provided between images obtained by the first and second pixel groups). Here, main component pixels (for example, W or G) for luminance are assigned to the R channel corresponding to such a "first pixel group", and color pixels (for example, R, G, B and the like) are assigned to the L channel corresponding to the "second pixel group". However, the "first pixel group" and the "second pixel group" in the present technology are not limited to groups corresponding to the above-described left perspective and the above-described right perspective, and are applicable to pixel groups corresponding to other various perspectives (directions), as long as the pixel groups have a parallax therebetween.

In the pixel array section 12, as an example, basically, some of the unit pixels are arranged in a checkerboard-like zigzag arrangement in which each unit pixel is rotated by, for example, 45° from a square (rectangular) arrangement as a reference.

Each unit pixel is configured to receive incident light and to have a photoelectric conversion function for received light, an electric charge storing function, and an electric charge storing function of detecting a stored electric charge.

As will be described later, each unit pixel is configured by laminating (superimposing) a first pixel section that has at least a light reception function and a second pixel section that is formed so as to face the first pixel section and has at least an electric charge detection function.

As a configuration of the pixel, for example, a configuration of a back-illuminated type solid-state image pickup device in which light enters from one surface (a back surface) of a substrate, and devices such as a transistor for electric charge detection are formed on the other surface (a front surface) of the substrate, or a configuration of a laminated type solid-state image pickup device in which a photoelectric conversion film is formed in a light reception section may be adopted.

It is to be noted that the present technology is applicable to not only the zigzag arrangement but also a normal square arrangement.

Further, pixel drive lines 18 are wired to respective rows of a pixel arrangement in a matrix form in the pixel array section 12 along a lateral direction in the diagram (a pixel arrangement direction in pixel rows/a horizontal direction), and vertical signal lines 17 are formed for respective columns of the pixel arrangement along a top-to-bottom direction in the diagram (a pixel arrangement direction in pixel columns/a vertical direction).

One end of the pixel drive line 18 is connected to an output terminal corresponding to each row of the vertical drive section 13. In FIG. 1, each pixel drive line 18 is illustrated as, but not limited to, one line.

The vertical drive section 13 is configured of a shift register, an address decoder, and the like. Although a specific configuration is not illustrated here, the vertical drive section 13 has a configuration including a read-out scanning system and a sweep-out scanning system. The read-out scanning system sequentially performs selection scanning on the unit pixels from which a signal is to be read from one row to another.

On the other hand, the sweep-out scanning system performs sweep-out scanning on read-out rows on which read-out scanning is to be performed by the read-out scanning system prior to the read-out scanning by the time of shutter speed, thereby sweeping (resetting) unnecessary electric charges from the photoelectric conversion devices of the unit pixels in the read-out row.

A so-called electronic shutter operation is performed by sweeping (resetting) unnecessary electric charge by the sweep-out scanning system.

As used herein, the term "electronic shutter operation" refers to an operation to discard a photoelectric charge in the photoelectric conversion device or the like and to start new exposure (to start storing a photoelectric charge).

Signals read by a read-out operation by the read-out scanning system corresponds to an amount of light incident after a read-out operation or an electronic shutter operation immediately prior to that read-out operation.

Further, a time period from a read-out timing by an immediately preceding read-out operation or a sweep-out timing by an immediately preceding electronic shutter operation to a read-out timing by a current read-out operation is electric charge storage time (exposure time) in the unit pixel.

In the present embodiment, as will be described later, a wide dynamic range is obtainable by adopting a device for controlling of this exposure time or changing of transmittance of the color filter.

A signal output from each unit pixel in a pixel row on which the selection scanning is performed by the vertical drive section 13 is supplied to the column processing section 14 through each of the vertical signal lines 17.

The column processing section 14 performs predetermined signal processing on analog pixel signals output from respective pixel in a selected row from one pixel column of the pixel array section 12 to another.

Examples of the signal processing in the column processing section 14 may include CDS (Correlated Double Sampling) processing.

The CDS processing is a process to capture a reset level and a signal level that are output from each pixel in the selected row and determine a difference between these levels to obtain signals of pixels in one row, and to remove fixed pattern noise of the pixels.

The column processing section 14 may have an A/D conversion function to convert an analog signal into digital form.

The horizontal drive section 15 is configured of a shift register, an address decoder, and the like, and sequentially performs selection scanning on circuit sections corresponding to the pixel columns in the column processing section 14.

Through the selection scanning by this horizontal drive section 15, pixel signals subjected to signal processing by the column processing section 14 for respective pixel columns are sequentially output to the outside of the sensor chip 11.

In other words, the pixel signals corresponding to color coding (a color arrangement) of the color filter array 33, the photoelectric conversion films, or the like are output as they are as RAW data (raw data) from the sensor chip 11.

The system control section 16 receives a clock, data indicating an operation mode, and the like that are provided from the outside of the sensor chip 11, and outputs data such as internal information of this CMOS image sensor 10.

The system control section 16 includes a timing generator that generates various timing signals, and performs drive control of the vertical drive section 13, the column processing section 14, the horizontal drive section 15, and the like, based on the various timing signals generated by the timing generator.

The DSP circuit 31 that is an external circuit of the sensor chip 11 may temporally store, for example, image data for one frame output from the sensor chip 11 in the image memory 32, and may execute demosaic processing or the like, based on pixel information stored in the image memory 32.

The demosaic processing is a process to complement color information with respect to a signal of each pixel that only has single-color information by collecting necessary color information from signals of peripheral pixels and providing the information to the signal of each pixel, thereby generating a full color image.

The DSP circuit 31 further performs a process to generate a 2D image and a 3D image by remosaic processing or interphase processing.

Signal processing by the DSP 31 will be described in detail later.

### (First Configuration Example of Unit Pixel)

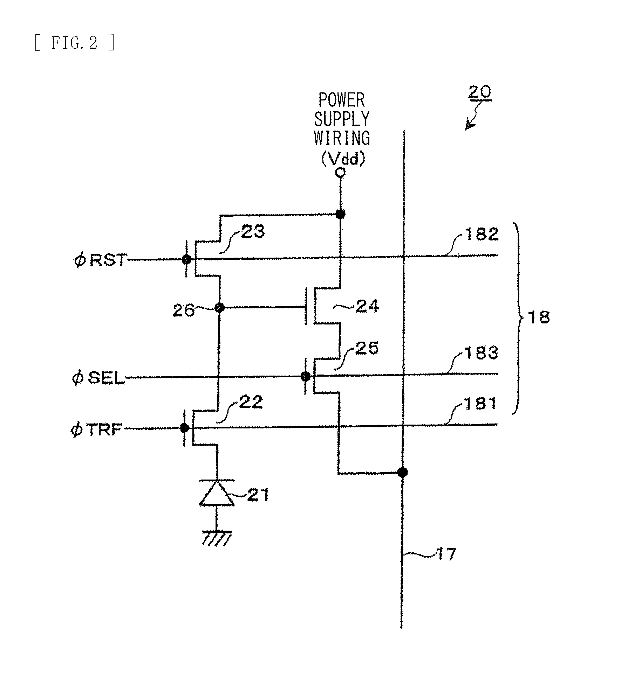

FIG. 2 is a circuit diagram illustrating an example of a circuit configuration of the unit pixel 20.

As illustrated in FIG. 2, the unit pixel 20 according to the present embodiment may include a photoelectric conversion device, for example, a photodiode (PD) 21, and four transistors, for example, a transfer transistor 22, a reset transistor 23, an amplification transistor 24, and a selection transistor 25.

In this case, as the four transistors, i.e., the transfer transistor 22, the reset transistor 23, the amplification transistor 24, and the selection transistor 25, for example, N-channel MOS transistors may be used. However, a combination of conductivity types of the transfer transistor 22, the reset transistor 23, the amplification transistor 24, and the selection transistor 25 described here as an example is merely one example, the combination of the four transistors is not limited thereto.

For this unit pixel 20, for example, three drive lines that may be a transfer line 181, a reset line 182, and a selection line 183 are wired as the pixel drive line 18 to be shared by the respective pixels in a same pixel row.

One end of each of the transfer line 181, the reset line 182, and the selection line 183 is connected to an output terminal corresponding to each pixel row of the vertical drive section 13 on a pixel row-by-pixel row basis.

An anode electrode of the photodiode 21 is connected to a negative power supply (such as a ground), and photoelectrically converts received light into a photoelectric charge (here, photoelectrons) having an electric charge amount corresponding to a light amount of the received light.

A cathode electrode of the photodiode 21 is electrically connected to a gate electrode of the amplification transistor 24 through the transfer transistor 22.

A node 26 electrically connected to the gate electrode of the amplification transistor 24 is referred to as FD (Floating Diffusion) section.

The transfer transistor 22 is connected between the cathode electrode of the photodiode 21 and the FD section 26.

A transfer pulse φTRF at a high level (for example, a Vdd level) that is active (hereinafter, referred to as "High-active") is supplied to a gate electrode of the transfer transistor 22 through the transfer line 181.

The transfer transistor 22 is turned to an ON state by being provided with the transfer pulse φTRF, and transfers, to the FD section 26, the photoelectric charge obtained by photoelectric conversion in the photodiode 21.

A drain electrode and a source electrode of the reset transistor 23 are connected to a pixel power supply Vdd and the FD section 26, respectively.

A High-active reset pulse φRST is supplied to a gate electrode of the reset transistor 23 through the reset line 182 before transfer of a signal electric charge from the photodiode 21 to the FD section 26.

The reset transistor 23 is turned to an ON state by being provided with the reset pulse φRST, and resets the FD section 25 by discarding the electric charge of the FD section to the pixel power supply Vdd.

The gate electrode and a drain electrode of the amplification transistor 24 are connected to the FD section 26 and the pixel power supply Vdd, respectively.

Then, the amplification transistor 24 outputs, as a reset signal (a reset level) Vreset, a potential of the FD section 26 that has been reset by the reset transistor 23.

The amplification transistor 24 outputs, as a light storage signal (a signal level) Vsig, a potential of the FD section 26 to which a signal electric charge has been transferred by the transfer transistor 22.

A drain electrode and a source electrode of the selection transistor 25 may be connected to, for example, a source electrode of the amplification transistor 24 and the vertical signal line 17, respectively.

A High-active selection pulse φSEL is supplied to a gate electrode of the selection transistor 25 through the selection line 183.

The selection transistor 25 is turned to an ON state by being provided with the selection pulse φSEL to turn the unit pixel 20 to a selected state, and to relay a signal output from the amplification transistor 24 to the vertical signal line 17.

It is to be noted that the selection transistor 25 may adopt a circuit configuration in which the selection transistor 25 is connected between the pixel power supply Vdd and the drain of the amplification transistor 24.

Moreover, the unit pixel 20 is not limited to the pixel configuration configured of four transistors with the above-described configurations.

For example, the unit pixel 20 may have, for example, a pixel configuration configured of three transistors, one of which serves as both the amplification transistor 24 and the selection transistor 25, and a pixel circuit configuration of the unit pixel 20 is not limited.

### (Back-illuminated Type Pixel Configuration)

A solid-state image pickup device including unit pixels with the above-described configuration may be formed, for example, as a back-illuminated type solid-state image pickup device in which light enters from one surface (a back surface) of a substrate, and devices such as a transistor for electric charge detection are formed on the other surface (a front surface) of the substrate.

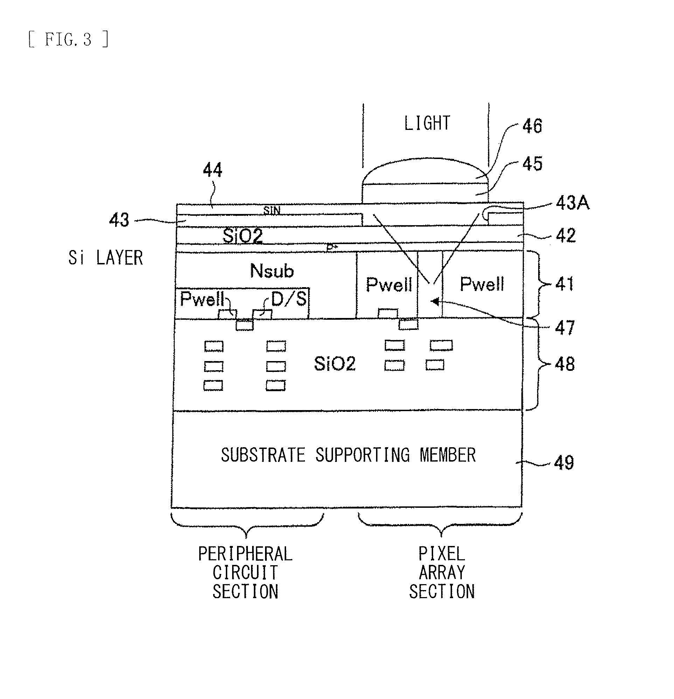

FIG. 3 is a diagram illustrating a basic pixel configuration example of the back-illuminated type solid-state image pickup device.

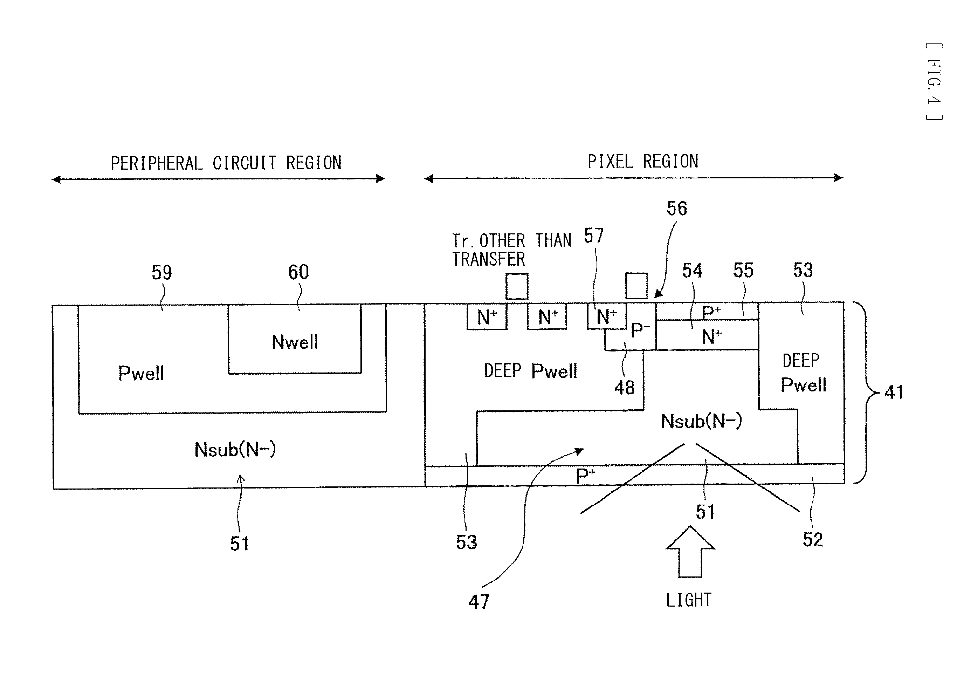

FIG. 4 is a diagram illustrating a well structure example of a semiconductor substrate in FIG. 3.

FIGs. 3 and 4 simply illustrate a configuration in which a pixel region (a pixel array section) where pixels are formed and a peripheral circuit region (a peripheral circuit section) are formed side by side. Moreover, for the sake of simplification of the diagrams, only one pixel is illustrated in the pixel region, and the back-illuminated type pixel configuration illustrated here is merely one example, and any of pixel configurations of various types may be adopted.

In FIG. 3, a wafer is polished by CMP (Chemical Mechanical Polishing) to form a silicon (Si) layer (device layer) 41 with a thickness of about 10 µm to about 20 µm both inclusive. A desirable range of the thickness is from 5 µm to 15 µm both inclusive with respect to visible light, from 15 µm to 50 µm both inclusive with respect to infrared light, and from 3 µm to 7 µm both inclusive with respect to a ultraviolet region. A light-shielding film 43 (BLD) is formed on one surface (a back surface) of the silicon layer 41 with a SiO2 film 42 in between.

The light-shielding film 43 is laid out in consideration of only an optical factor, unlike wiring. An opening section 43A is formed in the light-shielding film 43. A silicon nitride film (SiN) 44 is formed as a passivation film on further a back surface of the light-shielding film 43, and a color filter 45 and an on-chip lens (microlens) 46 are further formed on a light incident path on a back surface of the opening section 43.

In other words, a pixel configuration in which light incident from one surface of the silicon layer 41 is guided to a light reception surface of a photodiode (PD) 47 formed on the silicon layer 41 through the on-chip lens (microlens) 46 and the color filter 45 is adopted.

The photodiode 47 corresponds to the photodiode 21 in FIG. 2, and has a photoelectric conversion function and an electric charge storing function, and configures a light reception section (a first pixel section) together with the on-chip lens 46 and the color filter 45.

A wiring layer 48 in which a transistor and a metal wiring line are formed is formed on the other surface (a front surface) of the silicon layer 41, and a substrate supporting member 49 is further bonded below the wiring layer 48.

A typical CMOS image sensor adopts a front-side light reception type pixel configuration in which a wiring layer side is considered as a front side and incident light is captured from the wiring layer side.

On the other hand, the CMOS image sensor according to the present embodiment captures incident light from a surface (a back surface) opposite to the wiring layer 48; therefore, the CMOS image sensor adopts a back-illuminated (light reception) type pixel configuration.

As can be clearly seen from the back-illuminated (light reception) type pixel configuration, only the light-shielding film 43 exists as a metal layer between the on-chip lens (microlens) 46 and the photodiode 47. Moreover, since a height of the light-shielding film 43 from the photodiode 47 is as low as a film thickness (for example, about 0.5 µm) of the SiO2 film 42, limitation in light concentration due to vignetting by the metal layer is allowed to be eliminated.

FIG. 4 is a schematic sectional configuration diagram illustrating an example of a well structure of the silicon layer 41 in FIG. 3, and in this diagram, like components are denoted by like numerals as of FIG. 3.

In this example, an N- type substrate 51 is used. As described above, the thickness of the silicon layer 41 may be preferably from 5 µm to 15 µm both inclusive with respect to visible light, and is set to 10 µm in this example. This allows favorable photoelectric conversion of visible light. A shallow P+ layer 52 is formed over an entire surface of the pixel section on the one surface of the silicon layer 41. A pixel separation region is formed of a deep P well 53, and is connected to the P+ layer 52 on the one surface.

The photodiode 47 does not form a P well; therefore, the photodiode 47 is formed with use of the N- type substrate 51. The N- type region (substrate) 51 is a photoelectric conversion region, and has a small area and a low concentration; therefore, the N- type region (substrate) 51 is completely depleted.

On the photodiode 47, an N+ region 54 that stores a signal electric charge (in this example, electron) is formed, and a P+ layer 55 is further formed on the N+ region 54 to form an embedded photodiode.

It is to be noted that, as can be clearly seen from FIG. 4, the photodiode 47 is formed so as to allow a surface area on the light reception surface side to be wider than a surface area on the wiring layer 48 side. Thus, incident light is allowed to be efficiently captured.

The signal electric charge that has been subjected to photoelectric conversion in this photodiode 47 and is stored in the N+ region 54 is transferred to an FD (Floating Diffusion) 57 of an N+ type region by a transfer transistor 56 (the transfer transistor 22 in FIG. 2).

The photodiode 47 side is electrically separated from the FD 57 by a P- layer (48).

The transistors (the amplification transistor 24, the selection transistor 25, and the reset transistor 23 in FIG. 2) other than the transfer transistor 22 in the pixel are formed in a typical manner in the deep P well 53.

On the other hand, in the peripheral circuit region, a P well 59 is formed at a depth that does not reach the P+ layer 52 on the back surface, an N well 60 is formed inside this P well 59, and a CMOS circuit is formed in a region of these wells 59 and 60.

### (Pixel Addition)

By the way, typically, when moving images are picked up, a frame rate is increased, and pixel addition in which signals of a plurality of adjacent pixels are added to one another and then read out is performed to achieve high-speed picking up of moving images.

The pixel addition is allowed to be performed in a pixel, on the vertical signal line 19, by the column processing unit 14, by a signal processing unit in a following stage, and the like.

Here, as an example, a pixel configuration in a case where, for example, signals of four pixels vertically and horizontally adjacent to one another in a 2x2 square arrangement are added in a pixel will be described below.

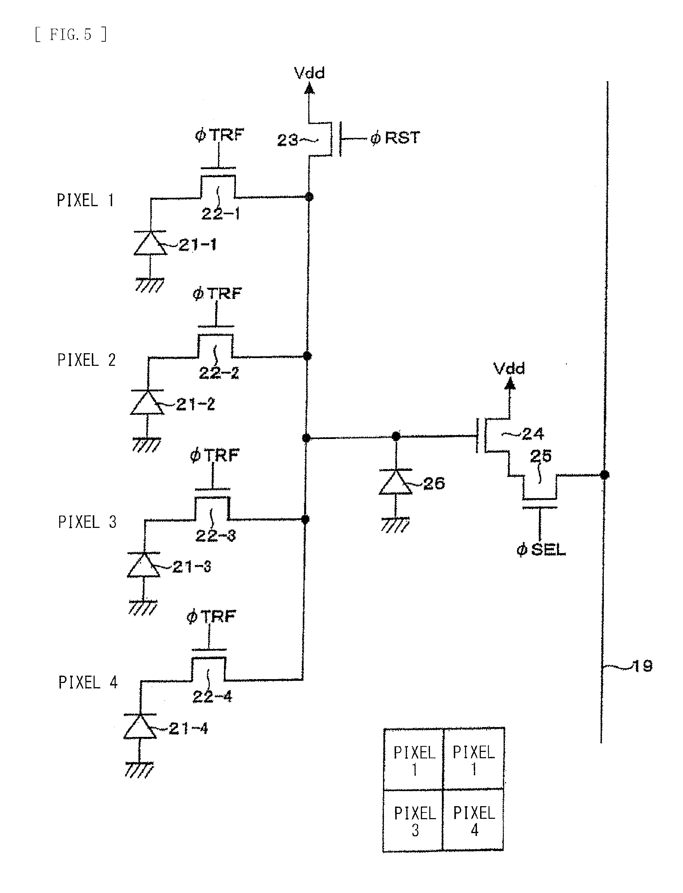

FIG. 5 is a circuit diagram illustrating an example of a circuit configuration in a case where adjacent four-pixel addition is performed in a pixel, and in this diagram, like components are denoted by like numerals as of FIG. 2.

In FIG. 5, the photodiodes 21 of four pixels vertically and horizontally adjacent to one another are referred to as photodiodes 21-1, 21-2, 21-3, and 21-4.

Four transfer transistors 22-1, 22-2, 22-3, and 22-4 are provided to these photodiodes 21-1, 21-2, 21-3, and 21-4, respectively, and one reset transistor 23, one amplification transistor 24, and one selection transistor 25 are provided to these photodiodes 21-1, 21-2, 21-3, and 21-4.

In other words, one electrode of the transfer transistor 22-1, one electrode of the transfer transistor 22-2, one electrode of the transfer transistor 22-3, and one electrode of the transfer transistor 22-4 are connected to cathode electrodes of the photodiodes 21-1, 21-2, 21-3, and 21-4, respectively, and the other electrodes of the transfer transistors 22-1 to 22-4 are connected to the gate electrode of the common amplifier transistor 24.

The common FD section 26 for the photodiodes 21-1, 21-2, 21-3, and 21-4 is electrically connected to the gate electrode of the amplification transistor 24.

The drain electrode and the source electrode of the reset transistor 23 are connected to the pixel power supply Vdd and the FD section 26, respectively.

In the pixel configuration corresponding to addition of adjacent four pixels with the above-described configuration, pixel addition of the adjacent four pixels is achievable by supplying the transfer pulse φTRF to the four transfer transistors 22-1, 22-2, 22-3, and 22-4 at a same timing.

In other words, signal electric charges transferred from the photodiodes 21-1, 21-2, 21-3, and 21-4 to the FD section 26 by the transfer transistors 22-1, 22-2, 22-3, and 22-4 are added in the FD section 26 (that may be also referred to as "FD addition").

On the other hand, signal output on a pixel-by-pixel basis is achievable by applying the transmission pulse φTRF to the transfer transistors 22-1, 22-2, 22-3, and 22-4 at different timings.

In other words, when moving images are picked up, an enhancement of the frame rate is achievable by performing pixel addition, but on the other hand, when a still image is picked up, an enhancement of resolution is achievable by independently reading out signals of all pixels.

### [Pixel Arrangement]

As described above, basically, the pixel array section 12 is configured by arranging a plurality of pixels in a matrix form (in rows and columns).

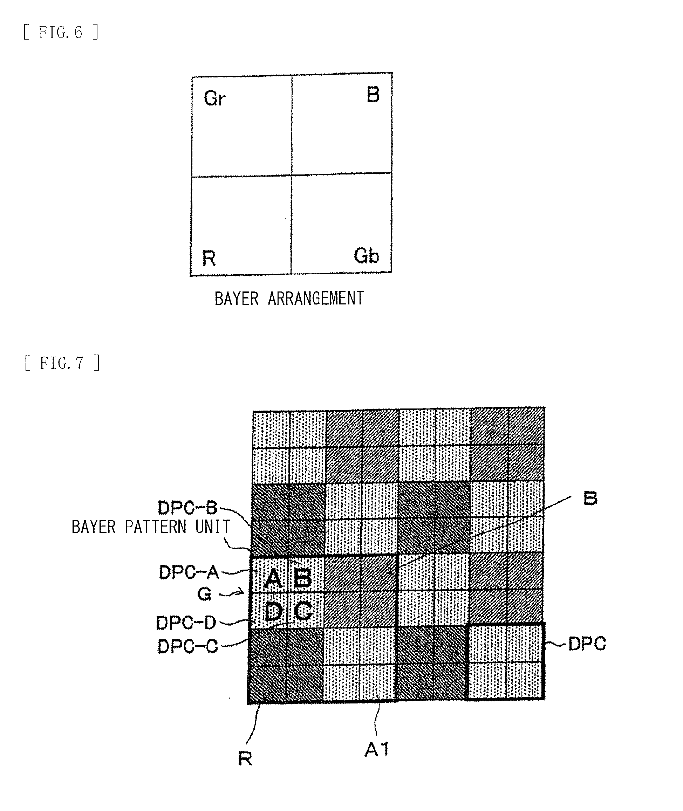

The pixel array section 12 may adopt, for example, a Bayer arrangement as illustrated in FIG. 6 as a pixel arrangement thereof.

In the pixel array section 12 in the present embodiment, one pixel is divided into a plurality of divided pixel cells DPC including a photoelectric conversion device formed of a photodiode.

More specifically, in the solid-state image pickup device (CMOS image sensor) 10, one pixel under a same color filter in the Bayer arrangement is divided into two or more divided pixel cells DPC. In this case, the two or more divided pixel cells DPC divided with varying sensitivity or with varying storage time may be divided so as to have varying sensitivity or varying storage time (exposure time).

In the following description, a case where one pixel is divided into four divided pixel cells DPC-A to DPC-D will be described as an example.

FIG. 7 is a conceptual diagram of pixel division according to the present embodiment.

FIG. 7 illustrates a division method in the Bayer arrangement in an example in which one pixel under a same color filter (one pixel disposed to face the color filter) is divided into four, and, for example, the respective divided pixels may have sensitivity or storage time different from one another.

In FIG. 7, a case in which a G (green) pixel PCG is divided into four pixels DPC-A, DPC-B, DPC-C, and DPC-D is illustrated as an example. For example, the G pixel PCG may be divided into two pixels DPC-A and DPC-B.

### (2. Characteristic Configuration of Present Embodiment)

In the present embodiment, the CMOS image sensor 10 with the above-described configuration is configured as a solid-state image pickup device applicable to a stereo camera and a monocular or binocular three-dimensional (3D) stereo camera that adopt light field technology.

A characteristic configuration of the solid-state image pickup device applicable to the stereo camera or the monocular or binocular three-dimensional (3D) stereo camera will be specifically described below.

For the sake of easy understanding, a basic configuration example of a square arrangement (a rectangular arrangement) will be described below, and then, a configuration example of a checkerboard-like zigzag arrangement will be described.

It is to be noted that, in the following description, in X-Y coordinates illustrated in the diagram, an X direction corresponds to a first direction, a Y direction corresponds to a second direction, the X direction may be referred to as a horizontal direction or a lateral direction, and the Y direction may be referred to as a vertical direction or a longitudinal direction.

### (2-1. First Characteristic Configuration Example)

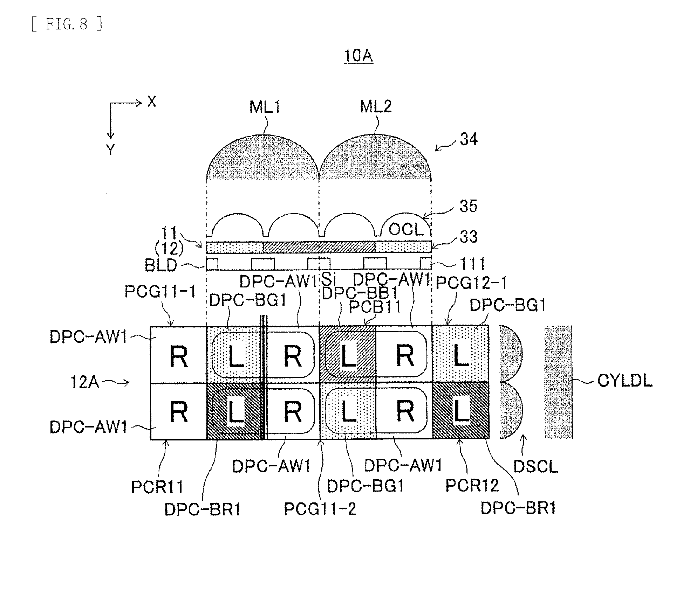

FIG. 8 is a diagram illustrating a first characteristic configuration example of the solid-state image pickup device (CMOS image sensor) according to the present embodiment.

A CMOS image sensor 10A in FIG. 8 is applicable to a stereo camera, and performs LR parallax separation with a multi-lens array 34 as a light field stereo version.

Since this configuration matches a side-by-side recording scheme, this configuration is useful.

Here, L indicates left for stereo, and R indicates right for stereo. L and R may be reversed depending on optical characteristics, and in such a case, the present example is applicable by considering L and R to be reversed.

In the CMOS image sensor 10A, a pixel array section 12A adopts a division method for each pixel in the square arrangement (rectangular arrangement) as well as the Bayer arrangement.

In FIG. 8, the color filter array 33 is formed so as to allow a G pixel PCG11-1, an R pixel PCR11, a G pixel PCG11-2, and a B pixel PCB11 as complex pixels each including a W pixel as a main component pixel for luminance to form a 2x2 Bayer arrangement. This arrangement is formed in rows and columns.

In the example in FIG. 8, only a part is illustrated, and an example in which a G pixel PCG12-1 in an adjacent Bayer arrangement is arranged adjacent to the B pixel PCB11 in the lateral direction, and an R pixel PCR12 in the adjacent Bayer arrangement is arranged adjacent to the G pixel PCG11-2 in the lateral direction.

In the example in FIG. 8, the G pixel PCG11-1, the B pixel PCB11, and the G pixel PCG12-1 are arranged in a first row, and the R pixel PCR11, the G pixel PCG11-2, and the R pixel PCR12 are arranged in a second row.

In the example in FIG. 8, each of the G pixel PCG11-1, the R pixel PCR11, the G pixel PCG11-2, the B pixel PCB 11, the G pixel PCG11-2, and the R pixel PCR12 is divided into two, i.e., each color pixel R, G, or B and a W pixel as a main component for luminance in the first direction (X direction).

The G pixel PCG11-1 includes two divided pixels, i.e., a W pixel DPC-AW1 as a main component for luminance and a G pixel DPC-BG1 as a color pixel. In this example, the W pixel DPC-AW1 is assigned to R for stereo, and the G pixel DPC-BG1 is assigned to L for stereo.

The R pixel PCR11 includes two divided pixels, i.e., the W pixel DPC-AW1 as a main component for luminance and an R pixel DPC-BR1 as a color pixel. In this example, the W pixel DPC-AW1 is assigned to R for stereo, and the G pixel DPC-BR1 is assigned to L for stereo.

The B pixel PCB11 includes two divided pixels, i.e., the W pixel DPC-AW1 as a main component for luminance and a B pixel DPC-BB1 as a color pixel. In this example, the W pixel DPC-AW1 is assigned to R for stereo, and the B pixel DPC-BB1 is assigned to L for stereo.

The G pixel PCG11-2 includes two divided pixels, i.e., the W pixel DPC-AW1 as a main component for luminance and the G pixel DPC-BG1 as a color pixel. In this example, the W pixel DPC-AW1 is assigned to R for stereo, and the G pixel DPC-BG1 is assigned to L for stereo.

The G pixel PCG12-1 includes two divided pixels, i.e., the W pixel DPC-AW1 as a main component for luminance and the G pixel DPC-BG1 as a color pixel. In this example, the W pixel DPC-AW1 is assigned to R for stereo, and the G pixel DPC-BG1 is assigned to L for stereo.

The R pixel PCR12 includes two divided pixels, i.e., the W pixel DPC-AW1 as a main component for luminance and the R pixel DPC-BR1 as a color pixel. In this example, the W pixel DPC-AW1 is assigned to R for stereo, and the R pixel DPC-BR1 is assigned to L for stereo.

Thus, in this example, the W pixel as a main component pixel for luminance is assigned to one channel (R in this example) of L/R for stereo, and the color pixel R, G, or B is assigned to the other channel (L in this example).

With such a configuration, deterioration in luminance resolution and color resolution is allowed to be avoided.

Moreover, in a monocular 3D sensor, when L/R separation filters are arranged in a checkerboard-like pattern, the arrangement of the L/R separation filters is allowed to match a checkerboard-like luminance pixel arrangement.

In particular, the MLA with a zigzag arrangement allows efficient parallax separation.

Moreover, in this example, a same R or L function for stereo is assigned to respective divided pixels in a same column (an arrangement in the Y direction that is the second direction) of the pixel arrangement.

In other words, the R function and the L function for stereo are alternately assigned to respective divided pixels in a same row (an arrangement in the Y direction) of the pixel arrangement.

As illustrated in FIG. 8, a light shielding section BLD, a wiring line, and the like are formed in the semiconductor substrate 11, and the color filter array 33 is formed thereabove, and an on-chip lens (OCL) array 35 is formed above the color filter array 33.

Respective on-chip lenses OCL in the on-chip lens array 35 are formed in rows and columns so as to correspond to the respective divided pixels in the pixel array section 12A.

Further, the multi-lens array 34 in which multi-lenses ML are formed in rows and columns is arranged so as to face a light incident side of the on-chip lens array 35.

In the example in FIG. 8, the pixels sharing each multi-lens ML in the multi-lens array 34 in the first direction (the lateral direction or the X direction) are arranged to have not a same color but different colors including W, unlike a typical arrangement.

In the example in FIG. 8, two multi-lens systems, i.e., a first multi-lens system ML1 and a second multi-lens system ML2 are illustrated.

The first multi-lens system ML1 is arranged so as to be shared by the G pixel DPC-BG1 assigned to L for stereo in the G pixel PCG11-1 and the W pixel DPC-AW1 assigned to R for stereo in the B pixel PCB11 adjacent to the G pixel PCG11-1 in a first row.

Similarly, the first multi-lens system ML1 is arranged so as to be shared by the R pixel DPC-BR1 assigned to L for stereo in the R pixel PCR11 and the W pixel DPC-AW1 assigned to R for stereo in the G pixel PCG11-2 adjacent to the R pixel PCR11 in a second row.

The second multi-lens system ML2 is arranged so as to be shared by the B pixel DPC-BB1 assigned to L for stereo in the B pixel PCB11 and the W pixel DPC-AW1 assigned to R for stereo in the G pixel PCG12-1 adjacent to the B pixel PCB11 in the first row.

Similarly, the second multi-lens system ML2 is arranged so as to be shared by the G pixel DPC-BG1 assigned to L for stereo in the G pixel PCG11-2 and the W pixel DPC-AW1 assigned to R for stereo in the R pixel PCR12 adjacent to the G pixel PCG11-2 in the second row.

When the color pixels sharing one multi-lens ML are allowed to have not a same color but different colors in such a way, color mixture (extinction ratio) of L and R for stereo is allowed to be improved by a lens gap and this different color separation.

Moreover, it is selectable whether a discrete lens DSCL or a cylindrical lens CYLDL is arranged in the vertical direction (Y direction).

In a case where there is no on-chip lens OCL, a light condensing ratio is improved by adopting the discrete lens DSCL.

It is to be noted that, in the example in FIG. 8, the lens provided over two divided pixels has a flat shape extending in the lateral direction (X direction) to avoid an influence by a lens that is adjacent thereto in the vertical direction (Y direction) and is shared by divided pixels.

### (2-2. Second Characteristic Configuration Example)

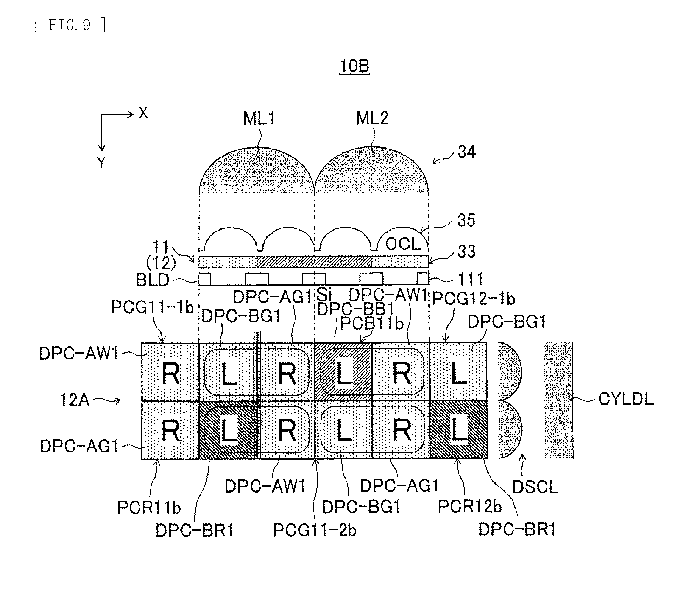

FIG. 9 is a diagram illustrating a second characteristic configuration example of the solid-state image pickup device (CMOS image sensor) according to the present embodiment.

A CMOS image sensor 10B in FIG. 9 differs from the CMOS image sensor 10A in FIG. 8 in that, instead of the W pixels, the G pixels are applied as main component pixels for luminance. In other words, in the CMOS image sensor 10B in FIG. 9, the G pixel and the R, G, or B pixel are separated for L and R, and parallax information is detected only by the G pixels.

A G pixel PCG11-1b includes two divided pixels, i.e., a G pixel DPC-AG1 as a main component for luminance and the G pixel DPC-BG1 as a color pixel. In this example, the G pixel DPC-AG1 is assigned to R for stereo, and the G pixel DPC-BG1 is assigned to L for stereo.

An R pixel PCR11b includes two divided pixels, i.e., the G pixel DPC-AG1 as a main component for luminance and the R pixel DPC-BR1 as a color pixel. In this example, the G pixel DPC-AG1 is assigned to R for stereo, and the G pixel DPC-BR1 is assigned to L for stereo.

A B pixel PCB11b includes two divided pixels, i.e., the G pixel DPC-AG1 as a main component for luminance and the B pixel DPC-BB1 as a color pixel. In this example, the G pixel DPC-AG1 is assigned to R for stereo, and the B pixel DPC-BB1 is assigned to L for stereo.

A G pixel PCG11b-2 includes two divided pixels, i.e., the G pixel DPC-AG1 as a main component for luminance and the G pixel DPC-BG1 as a color pixel. In this example, the G pixel DPC-AG1 is assigned to R for stereo, and the G pixel DPC-BG1 is assigned to L for stereo.

A G pixel PCG12-1b includes two divided pixels, i.e., the G pixel DPC-AG1 as a main component for luminance and the G pixel DPC-BG1 as a color pixel. In this example, the G pixel DPC-AG1 is assigned to R for stereo, and the G pixel DPC-BG1 is assigned to L for stereo.

An R pixel PCR12b includes two divided pixels, i.e., the G pixel DPC-AG1 as a main component for luminance and the R pixel DPC-BR1 as a color pixel. In this example, the G pixel DPC-AG1 is assigned to R for stereo, and the R pixel DPC-BR1 is assigned to L for stereo.

Thus, in this example, the G pixel as a main component pixel for luminance is assigned to one channel (R in this example) of L/R for stereo, and the color pixel R, G, or B is assigned to the other channel (L in this example), thereby detecting parallax information only by the G pixels.

With such a configuration, parallax (Depth) calculation is easy, and since a same color is used, precision is high. Resolution is actually reduced; however, typically, low Depth resolution does not cause an issue.

Moreover, G as the color pixel is allowed to be used for a luminance signal, thereby leading to high resolution.

### (2-3. Third Characteristic Configuration Example)

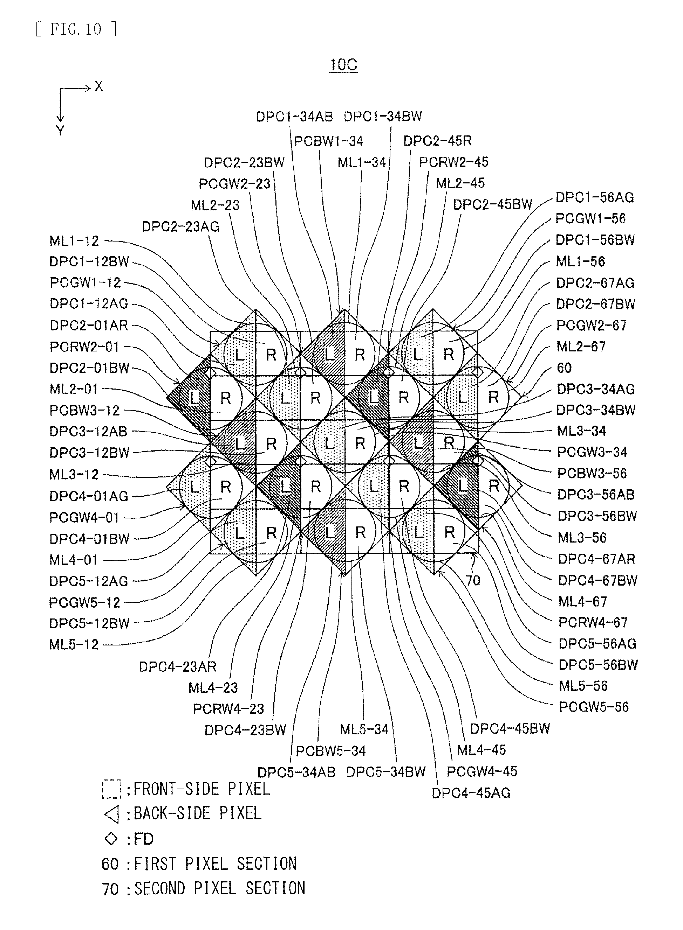

FIG. 10 is a diagram illustrating a third characteristic configuration example of the solid-state image pickup device (CMOS image sensor) according to the present embodiment.

In a CMOS image sensor 10C in FIG. 10, instead of the square arrangement (the rectangular arrangement), a part of the pixel arrangement adopts a checkerboard-like zigzag arrangement in which each unit pixel is transitioned (rotated) by, for example, 45° from the square arrangement (the rectangular arrangement) as a reference.

Then, each unit pixel is configured by laminating (superimposing) a first pixel section 60 that has at least a light reception function and a second pixel section 70 that is formed so as to face the first pixel section and has at least a stored electric charge detection function.

Here, the first pixel section 60 is arranged on a back surface, and may include, for example, the color filter 45 and the on-chip lens 46 in FIG. 3, or may include the color filter 45 and the on-chip lens 46 (the photodiode 47).

The second pixel section 70 is arranged on a front surface, and may include, for example, the photodiode 47 and the wiring layer 48 in FIG. 3, or may include an electric charge detection transistor (such as an amplification transistor) and the wiring layer 48.

Then, in the present embodiment, the first pixel section 60 is formed as a zigzag arrangement, and the second pixel section 70 is formed as a square arrangement (a rectangular arrangement).

It is to be noted that, in FIG. 10, for the sake of simplification of the diagram, the color fitter array, the on-chip lens array, and the like are not illustrated.

In an example in FIG. 10, the second pixel section 70 is formed as a five-row by six-column square arrangement with five rows from a pth row to a (p+4)th row and six columns from a qth column to a (q+5)th column.

In the example in FIG. 10, a zigzag arrangement with five rows from the pth row to the (p+4)th row and eight columns from a (q-1)th column to a (q+6)th column is illustrated.

The row arrangement and the column arrangement in the first pixel section 60 and the row arrangement and the column arrangement in the second pixel section 70 are formed so as to correspond to each other.

In the example in FIG. 10, as with the example in FIG. 8, the W pixel as a main component pixel for luminance is assigned to one channel (R in this example) of L/R for stereo, and the color pixel R, G, or B is assigned to the other channel (L in this example).

With such a configuration, deterioration in luminance resolution and color resolution is allowed to be avoided.

Moreover, in a monocular 3D sensor, when L/R separation filters are arranged in a checkerboard-like pattern, the arrangement of the L/R separation filters is allowed to match a checkerboard-like luminance pixel arrangement.

In particular, the MLA with a zigzag arrangement allows efficient parallax separation.

In the first pixel section 60, the W pixels as main component pixels for luminance, G pixels, R pixels, and B pixels as color pixels are arranged in the following manner.

For the sake of easy understanding, description here will be given assuming p=q=1.

In a first row, a complex pixel PCGW1-12 with the G pixel and the W pixel is formed over a first column and a second column in a state rotated by, for example, 45° from the Y direction to the X direction from the square arrangement as a reference.

The complex pixel PCGW1-12 includes a G pixel DPC1-12AG and a W pixel DPC1-12BW as two triangular divided pixels that are divided by a Y axis as a center. The divided G pixel DPC1-12AG is arranged in the first column, and the divided W pixel DPC1-12BW is arranged in the second column.

The divided G pixel DPC1-12AG is assigned to L for stereo, and the divided W pixel DPC1-12BW is assigned to R for stereo.

Further, a multi-lens ML1-12 is arranged over the two divided pixels, i.e., the divided G pixel DPC1-12AG and the divided W pixel DPC1-12BW so as to be shared thereby.

In the first row, a complex pixel PCBW1-34 with the B pixel and the W pixel is formed over a third column and a fourth column in a state rotated by, for example, 45° from the Y direction to the X direction from the square arrangement as a reference.

The complex pixel PCGW1-34 includes a B pixel DPC1-34AB and a W pixel DPC1-34BW as two triangular divided pixels that are divided by the Y axis as a center. The divided B pixel DPC1-34AB is arranged in the third column, and the divided W pixel DPC1-34BW is arranged in the fourth column.

The divided B pixel DPC1-34AG is assigned to L for stereo, and the divided W pixel DPC1-34BW is assigned to R for stereo.

Further, a multi-lens ML1-34 is arranged over the two divided pixels, i.e., the divided B pixel DPC1-34AB and the divided W pixel DPC1-34BW so as to be shared thereby.

In the first row, a complex pixel PCGW1-56 with the G pixel and the W pixel is formed over a fifth column and a sixth column in a state rotated by, for example, 45° from the Y direction to the X direction from the square arrangement as a reference.

The complex pixel PCGW1-56 includes a G pixel DPC1-56AG and a W pixel DPC1-56BW as two triangular divided pixels that are divided by the Y axis as a center. The divided G pixel DPC1-56AG is arranged in the fifth column, and the divided W pixel DPC1-56BW is arranged in the sixth column.

The divided G pixel DPC1-56AG is assigned to L for stereo, and the divided W pixel DPC1-56BW is assigned to R for stereo.

Further, a multi-lens ML1-56 is arranged over the two divided pixels, i.e., the divided G pixel DPC1-56AG and the divided W pixel DPC1-56BW so as to be shared thereby.

In a second row, a complex pixel PCRW2-01 with the R pixel and the W pixel is formed over a zeroth column and the first column in a state rotated by, for example, 45° from the Y direction to the X direction from the square arrangement as a reference.

The complex pixel PCRW2-01 includes an R pixel DPC2-01AR and a W pixel DPC2-01BW as two triangular divided pixels that are divided by the Y axis as a center. The divided R pixel DPC2-01AR is arranged in the zeroth column, and the divided W pixel DPC2-01BW is arranged in the first column.

The divided R pixel DPC2-01AR is assigned to L for stereo, and the divided W pixel DPC2-01BW is assigned to R for stereo.

Further, a multi-lens ML2-01 is arranged over the two divided pixels, i.e., the divided R pixel DPC2-01AR and the divided W pixel DPC2-01BW so as to be shared thereby.

In the second row, a complex pixel PCGW2-23 with the G pixel and the W pixel is formed over the second column and the third column in a state rotated by, for example, 45° from the Y direction to the X direction from the square arrangement as a reference.

The complex pixel PCGW2-23 includes a G pixel DPC2-23AG and a W pixel DPC2-23BW as two triangular divided pixels that are divided by the Y axis as a center. The divided G pixel DPC2-23AG is arranged in the second column, and the divided W pixel DPC2-23BW is arranged in the third column.

The divided G pixel DPC2-23AG is assigned to L for stereo, and the divided W pixel DPC2-23BW is assigned to R for stereo.

Further, a multi-lens ML2-23 is arranged over the two divided pixels, i.e., the divided G pixel DPC2-23AG and the divided W pixel DPC2-23BW so as to be shared thereby.

In the second row, a complex pixel PCRW2-45 with the R pixel and the W pixel is formed over the fourth column and the fifth column in a state rotated by, for example, 45° from the Y direction to the X direction from the square arrangement as a reference.

The complex pixel PCRW2-45 includes an R pixel DPC2-45AR and a W pixel DPC2-45BW as two triangular divided pixels that are divided by the Y axis as a center. The divided R pixel DPC2-45AR is arranged in the fourth column, and the divided W pixel DPC2-45BW is arranged in the fifth column.

The divided R pixel DPC2-45AR is assigned to L for stereo, and the divided W pixel DPC2-45BW is assigned to R for stereo.

Further, a multi-lens ML2-45 is arranged over the two divided pixels, i.e., the divided R pixel DPC2-45AR and the divided W pixel DPC2-45BR so as to be shared thereby.

In the second row, a complex pixel PCGW2-67 with the G pixel and the W pixel is formed over the sixth column and a seventh column in a state rotated by, for example, 45° from the Y direction to the X direction from the square arrangement as a reference.

The complex pixel PCGW2-67 includes a G pixel DPC2-67AG and a W pixel DPC2-67BW as two triangular divided pixels that are divided by the Y axis as a center. The divided G pixel DPC2-67AG is arranged in the sixth column, and the divided W pixel DPC2-67BW is arranged in the seventh column.

The divided G pixel DPC2-67AG is assigned to L for stereo, and the divided W pixel DPC2-67BW is assigned to R for stereo.

Further, a multi-lens ML2-67 is arranged over the two divided pixels, i.e., the divided G pixel DPC2-67AG and the divided W pixel DPC2-67BW so as to be shared thereby.

In a third row, a complex pixel PCBW3-12 with the B pixel and the W pixel is formed over the first column and the second column in a state rotated by, for example, 45° from the Y direction to the X direction from the square arrangement as a reference.

The complex pixel PCBW3-12 includes a B pixel DPC3-12AB and a W pixel DPC3-12BW as two triangular divided pixels that are divided by the Y axis as a center. The divided B pixel DPC3-12AB is arranged in the first column, and the divided W pixel DPC3-12BW is arranged in the second column.

The divided B pixel DPC3-12AB is assigned to L for stereo, and the divided W pixel DPC3-12BW is assigned to R for stereo.

Further, a multi-lens ML3-12 is arranged over the two divided pixels, i.e., the divided B pixel DPC3-12AB and the divided W pixel DPC3-12BW so as to be shared thereby.

In the third row, a complex pixel PCGW3-34 with the G pixel and the W pixel is formed over the third column and the fourth column in a state rotated by, for example, 45° from the Y direction to the X direction from the square arrangement as a reference.

The complex pixel PCGW3-34 includes a G pixel DPC3-34AG and a W pixel DPC3-34BW as two triangular divided pixels that are divided by the Y axis as a center. The divided G pixel DPC3-34AG is arranged in the third column, and the divided W pixel DPC3-34BW is arranged in the fourth column.

The divided G pixel DPC3-34AG is assigned to L for stereo, and the divided W pixel DPC3-34BW is assigned to R for stereo.

Further, a multi-lens ML3-34 is arranged over the two divided pixels, i.e., the divided G pixel DPC3-34AG and the divided W pixel DPC3-34BW so as to be shared thereby.

In the third row, a complex pixel PCGW3-56 with the B pixel and the W pixel is formed over the fifth column and the sixth column in a state rotated by, for example, 45° from the Y direction to the X direction from the square arrangement as a reference.

The complex pixel PCGW3-56 includes a B pixel DPC3-56AB and a W pixel DPC3-56BW as two triangular divided pixels that are divided by the Y axis as a center. The divided B pixel DPC3-56AB is arranged in the fifth column, and the divided W pixel DPC3-34BW is arranged in the sixth column.

The divided B pixel DPC3-56AB is assigned to L for stereo, and the divided W pixel DPC3-56BW is assigned to R for stereo.

Further, a multi-lens ML3-56 is arranged over the two divided pixels, i.e., the divided B pixel DPC3-56AB and the divided W pixel DPC3-56BW so as to be shared thereby.

In a fourth row, a complex pixel PCGW4-01 with the G pixel and the W pixel is formed over the zeroth column and the first column in a state rotated by, for example, 45° from the Y direction to the X direction from the square arrangement as a reference.

The complex pixel PCGW4-01 includes a G pixel DPC4-01AG and a W pixel DPC4-01BW as two triangular divided pixels that are divided by the Y axis as a center. The divided G pixel DPC4-01AG is arranged in the zeroth column, and the divided W pixel DPC4-01BW is arranged in the first column.

The divided G pixel DPC4-01AG is assigned to L for stereo, and the divided W pixel DPC4-01BW is assigned to R for stereo.

Further, a multi-lens ML4-01 is arranged over the two divided pixels, i.e., the divided G pixel DPC4-01AG and the divided W pixel DPC4-01BW so as to be shared thereby.

In the fourth row, a complex pixel PCGW4-23 with the R pixel and the W pixel is formed over the second column and the third column in a state rotated by, for example, 45° from the Y direction to the X direction from the square arrangement as a reference.

The complex pixel PCGW4-23 includes an R pixel DPC4-23AR and a W pixel DPC4-23BW as two triangular divided pixels that are divided by the Y axis as a center. The divided R pixel DPC4-23AR is arranged in the second column, and the divided W pixel DPC4-23BW is arranged in the third column.

The divided R pixel DPC4-23AR is assigned to L for stereo, and the divided W pixel DPC4-23BW is assigned to R for stereo.

Further, a multi-lens ML4-23 is arranged over the two divided pixels, i.e., the divided R pixel DPC4-23AR and the divided W pixel DPC4-23BW so as to be shared thereby.

In the fourth row, a complex pixel PCGW4-45 with the G pixel and the W pixel is formed over the fourth column and the fifth column in a state rotated by, for example, 45° from the Y direction to the X direction from the square arrangement as a reference.

The complex pixel PCGW4-45 includes a G pixel DPC2-45AG and a W pixel DPC4-45BW as two triangular divided pixels that are divided by the Y axis as a center. The divided G pixel DPC4-45AG is arranged in the fourth column, and the divided W pixel DPC4-45BW is arranged in the fifth column.

The divided G pixel DPC4-45AG is assigned to L for stereo, and the divided W pixel DPC4-45BW is assigned to R for stereo.

Further, a multi-lens ML4-45 is arranged over the two divided pixels, i.e., the divided G pixel DPC4-45AG and the divided W pixel DPC4-45BW so as to be shared thereby.

In the fourth row, a complex pixel PCRW4-67 with the R pixel and the W pixel is formed over the sixth column and the seventh column in a state rotated by, for example, 45° from the Y direction to the X direction from the square arrangement as a reference.

The complex pixel PCRW4-67 includes an R pixel DPC4-67AR and a W pixel DPC4-67BW as two triangular divided pixels that are divided by the Y axis as a center. The divided R pixel DPC4-67AR is arranged in the sixth column, and the divided W pixel DPC4-67BW is arranged in the seventh column.

The divided R pixel DPC4-67AR is assigned to L for stereo, and the divided W pixel DPC4-67BW is assigned to R for stereo.

Further, a multi-lens ML4-67 is arranged over the two divided pixels, i.e., the divided R pixel DPC4-67AR and the divided W pixel DPC4-67BW so as to be shared thereby.

In a fifth row, a complex pixel PCGW5-12 with the G pixel and the W pixel is formed over the first column and the second column in a state rotated by, for example, 45° from the Y direction to the X direction from the square arrangement as a reference.

The complex pixel PCGW5-12 includes a G pixel DPC5-12AG and a W pixel DPC5-12BW as two triangular divided pixels that are divided by the Y axis as a center. The divided G pixel DPC5-12AG is arranged in the first column, and the divided W pixel DPC5-12BW is arranged in the second column.

The divided G pixel DPC5-12AG is assigned to L for stereo, and the divided W pixel DPC5-12BW is assigned to R for stereo.

Further, a multi-lens ML5-12 is arranged over the two divided pixels, i.e., the divided G pixel DPC5-12AG and the divided W pixel DPC5-12BW so as to be shared thereby.

In the fifth row, a complex pixel PCBW5-34 with the B pixel and the W pixel is formed over the third column and the fourth column in a state rotated by, for example, 45° from the Y direction to the X direction from the square arrangement as a reference.

The complex pixel PCBW5-34 includes a B pixel DPC5-34AB and a W pixel DPC5-34BW as two triangular divided pixels that are divided by the Y axis as a center. The divided B pixel DPC5-34AB is arranged in the third column, and the divided W pixel DPC5-34BW is arranged in the fourth column.

The divided B pixel DPC5-34AB is assigned to L for stereo, and the divided W pixel DPC5-34BW is assigned to R for stereo.

Further, a multi-lens ML5-34 is arranged over the two divided pixels, i.e., the divided B pixel DPC5-34AB and the divided W pixel DPC5-34BW so as to be shared thereby.

In the fifth row, a complex pixel PCGW5-56 with the G pixel and the W pixel is formed over the fifth column and the sixth column in a state rotated by, for example, 45° from the Y direction to the X direction from the square arrangement as a reference.

The complex pixel PCGW5-56 includes a G pixel DPC5-56AG and a W pixel DPC5-56BW as two triangular divided pixels that are divided by the Y axis as a center. The divided G pixel DPC5-56AG is arranged in the fifth column, and the divided W pixel DPC5-56BW is arranged in the sixth column.

The divided G pixel DPC5-56AG is assigned to L for stereo, and the divided W pixel DPC5-56BW is assigned to R for stereo.

Further, a multi-lens ML5-56 is arranged over the two divided pixels, i.e., the divided G pixel DPC5-56AG and the divided W pixel DPC5-56BW so as to be shared thereby.

In the pixel arrangement in FIG. 10, the complex pixels with the G pixel and the W pixel and the complex pixels with the B pixel and the W pixel are alternately arranged in the first row, the third row, and the fifth row. The complex pixels with the G pixel and the W pixel and the complex pixels with the R pixel and the W pixel are alternately arranged in the second row and the fourth row.

The configuration in FIG. 10 does not have an unnecessary pixel arrangement; therefore, deterioration in resolution caused by stereo is allowed to be suppressed.

Moreover, a detection transistor, wiring, and the like are allowed to be provided based on a square unit; therefore, miniaturization is allowed to be performed.

Further, the light reception surface is allowed to detect two parallaxes of LR in a configuration in which a zigzag honeycomb is vertically divided into two; therefore, even if the number of pixels is decreased to 1/2, zigzag honeycomb processing allows the record pixel number to be restored to be doubled, thereby compensating for deterioration in resolution caused by stereo.

Then, as described above, in the example in FIG. 10, as with the example in FIG. 8, the W pixel as a main component pixel for luminance is assigned to one channel (R in this example) of L/R for stereo, and the color pixel R, G, or B is assigned to the other channel (L in this example).

With such a configuration, deterioration in luminance resolution and color resolution is allowed to be avoided.

Moreover, in a monocular 3D sensor, when L/R separation filters are arranged in a checkerboard-like pattern, the arrangement of the L/R separation filters is allowed to match a checkerboard-like luminance pixel arrangement.

In particular, the MLA with a zigzag arrangement allows efficient parallax separation.

Even in the pixel arrangement in FIG. 10, a thinning operation is allowed to be performed.

Read-out pixel signals corresponding to the pixel arrangement in FIG. 10 are subjected to demosaic processing in which a zigzag arrangement (a checkerboard-like arrangement) obtained by rotating a square arrangement (a rectangular arrangement) by 45° is converted into a square arrangement (a rectangular arrangement) in the DSP circuit 31 based on pixel signals temporally recorded in the image memory 32.

### (2-4. Fourth Characteristic Configuration Example)

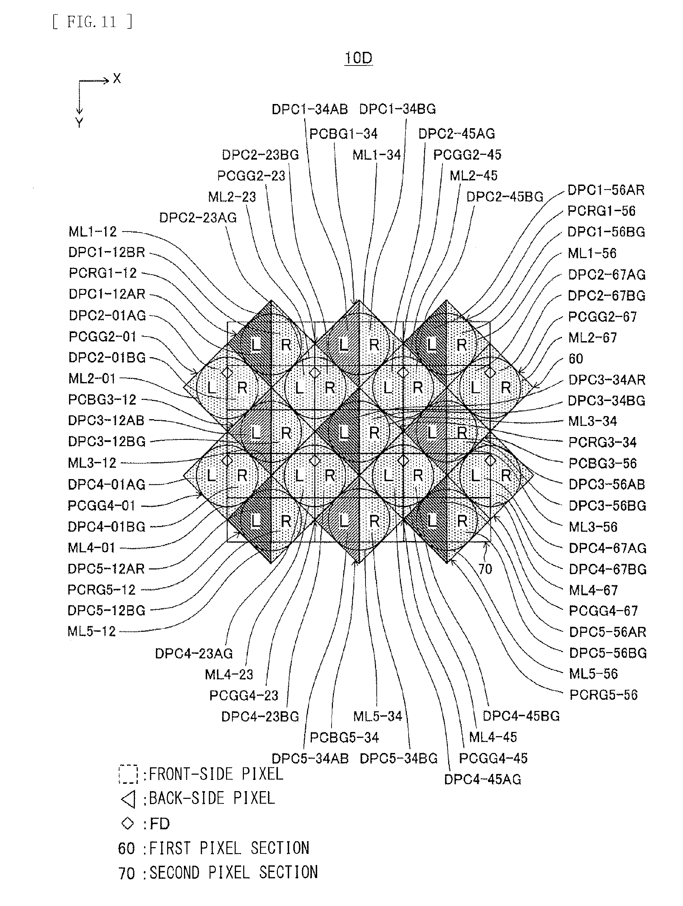

FIG. 11 is a diagram illustrating a fourth characteristic configuration example of the solid-state image pickup device (CMOS image sensor) according to the present embodiment.

A CMOS image sensor 10D in FIG. 11 basically differs from the CMOS image sensor 10C in FIG. 10 in that, instead of the W pixels, the G pixels are applied as main component pixels for luminance.

In other words, in the CMOS image sensor 10D in FIG. 11, as with the example in FIG. 9, the G pixel and the R, G, or B pixel are separated for L and R, and parallax information is detected only by the G pixels.

With such a configuration, parallax (Depth) calculation is easy, and since a same color is used, precision is high. Resolution is actually reduced; however, typically, low Depth resolution does not cause an issue.

Moreover, G as the color pixel is allowed to be used for a luminance signal, thereby leading to high resolution.

In the first pixel section 60, the G pixels as main component pixels for luminance, and G pixels, R pixels, and B pixels as color pixels are arranged in the following manner.

As with the example in FIG. 10, for the sake of easy understanding, description here will be given assuming p=q=1, and like components are denoted by like numerals as of FIG. 10.

In the first row, a complex pixel PCRG1-12 with the R pixel and the G pixel is formed over the first column and the second column in a state rotated by, for example, 45° from the Y direction to the X direction from the square arrangement as a reference.

The complex pixel PCRG1-12 includes an R pixel DPC1-12AR and a G pixel DPC1-12BG as two triangular divided pixels that are divided by the Y axis as a center. The divided R pixel DPC1-12AR is arranged in the first column, and the divided G pixel DPC1-12BG is arranged in the second column.

The divided R pixel DPC1-12AR is assigned to L for stereo, and the divided G pixel DPC1-12BG is assigned to R for stereo.

Further, the multi-lens ML1-12 is arranged over the two divided pixels, i.e., the divided R pixel DPC1-12AR and the divided G pixel DPC1-12BG so as to be shared thereby.

In the first row, a complex pixel PCBG1-34 with the B pixel and the G pixel is formed over the third column and the fourth column in a state rotated by, for example, 45° from the Y direction to the X direction from the square arrangement as a reference.

The complex pixel PCBG1-34 includes a B pixel DPC1-34AB and a G pixel DPC1-34BG as two triangular divided pixels that are divided by the Y axis as a center. The divided B pixel DPC1-34AB is arranged in the third column, and the divided G pixel DPC1-34BG is arranged in the fourth column.

The divided R pixel DPC1-34AB is assigned to L for stereo, and the divided G pixel DPC1-34BG is assigned to R for stereo.

Further, the multi-lens ML1-34 is arranged over the two divided pixels, i.e., the divided B pixel DPC1-34AB and the divided G pixel DPC1-34BG so as to be shared thereby.

In the first row, a complex pixel PCRG1-56 with the R pixel and the G pixel is formed over the fifth column and the sixth column in a state rotated by, for example, 45° from the Y direction to the X direction from the square arrangement as a reference.

The complex pixel PCRG1-56 includes an R pixel DPC1-56AR and a G pixel DPC1-56BG as two triangular divided pixels that are divided by the Y axis as a center. The divided R pixel DPC1-56AR is arranged in the fifth column, and the divided G pixel DPC1-56BG is arranged in the sixth column.

The divided R pixel DPC1-56AR is assigned to L for stereo, and the divided G pixel DPC1-56BG is assigned to R for stereo.

Further, the multi-lens ML1-56 is arranged over the two divided pixels, i.e., the divided R pixel DPC1-56AR and the divided G pixel DPC1-56BG so as to be shared thereby.

In the second row, a complex pixel PCGG2-01 with the G pixel and the G pixel is formed over the zeroth column and the first column in a state rotated by, for example, 45° from the Y direction to the X direction from the square arrangement as a reference.

The complex pixel PCGG2-01 includes a G pixel DPC2-01AG and a G pixel DPC2-01BG as two triangular divided pixels that are divided by the Y axis as a center. The divided G pixel DPC2-01AG is arranged in the zeroth column, and the divided G pixel DPC2-01BG is arranged in the first column.

The divided G pixel DPC2-01AG is assigned to L for stereo, and the divided G pixel DPC2-01BG is assigned to R for stereo.

Further, the multi-lens ML2-01 is arranged over the two divided pixels, i.e., the divided G pixel DPC2-01AG and the divided G pixel DPC2-01BG so as to be shared thereby.

In the second row, a complex pixel PCGG2-23 with the G pixel and the G pixel is formed over the second column and the third column in a state rotated by, for example, 45° from the Y direction to the X direction from the square arrangement as a reference.

The complex pixel PCGG2-23 includes a G pixel DPC2-23AG and a G pixel DPC2-23BG as two triangular divided pixels that are divided by the Y axis as a center. The divided G pixel DPC2-23AG is arranged in the second column, and the divided G pixel DPC2-23BG is arranged in the third column.

The divided G pixel DPC2-23AG is assigned to L for stereo, and the divided G pixel DPC2-23BG is assigned to R for stereo.

Further, the multi-lens ML2-23 is arranged over the two divided pixels, i.e., the divided G pixel DPC2-23AG and the divided G pixel DPC2-23BG so as to be shared thereby.

In the second row, a complex pixel PCGG2-45 with the G pixel and the G pixel is formed over the fourth column and the fifth column in a state rotated by, for example, 45° from the Y direction to the X direction from the square arrangement as a reference.

The complex pixel PCGG2-45 includes a G pixel DPC2-45AG and a G pixel DPC2-45BG as two triangular divided pixels that are divided by the Y axis as a center. The divided G pixel DPC2-45AG is arranged in the fourth column, and the divided G pixel DPC2-45BG is arranged in the fifth column.

The divided G pixel DPC2-45AG is assigned to L for stereo, and the divided G pixel DPC2-45BG is assigned to R for stereo.

Further, the multi-lens ML2-45 is arranged over the two divided pixels, i.e., the divided G pixel DPC2-45AG and the divided G pixel DPC2-45BG so as to be shared thereby.

In the second row, a complex pixel PCGG2-67 with the G pixel and the G pixel is formed over the sixth column and the seventh column in a state rotated by, for example, 45° from the Y direction to the X direction from the square arrangement as a reference.

The complex pixel PCGG2-67 includes a G pixel DPC2-67AG and a G pixel DPC2-67BG as two triangular divided pixels that are divided by the Y axis as a center. The divided G pixel DPC2-67AG is arranged in the sixth column, and the divided G pixel DPC2-67BG is arranged in the seventh column.

The divided G pixel DPC2-67AG is assigned to L for stereo, and the divided G pixel DPC2-67BG is assigned to R for stereo.

Further, the multi-lens ML2-67 is arranged over the two divided pixels, i.e., the divided G pixel DPC2-67AG and the divided G pixel DPC2-67BG so as to be shared thereby.

In the third row, a complex pixel PCBG3-12 with the B pixel and the G pixel is formed over the first column and the second column in a state rotated by, for example, 45° from the Y direction to the X direction from the square arrangement as a reference.

The complex pixel PCBG3-12 includes a B pixel DPC3-12AB and a G pixel DPC3-12BG as two triangular divided pixels that are divided by the Y axis as a center. The divided B pixel DPC3-12AB is arranged in the first column, and the divided G pixel DPC3-12BG is arranged in the second column.

The divided B pixel DPC3-12AB is assigned to L for stereo, and the divided G pixel DPC3-12BG is assigned to R for stereo.

Further, the multi-lens ML3-12 is arranged over the two divided pixels, i.e., the divided B pixel DPC3-12AB and the divided G pixel DPC3-12BG so as to be shared thereby.

In the third row, a complex pixel PCRG3-34 with the R pixel and the G pixel is formed over the third column and the fourth column in a state rotated by, for example, 45° from the Y direction to the X direction from the square arrangement as a reference.

The complex pixel PCRG3-34 includes an R pixel DPC3-34AR and a G pixel DPC3-34BG as two triangular divided pixels that are divided by the Y axis as a center. The divided R pixel DPC3-34AR is arranged in the third column, and the divided G pixel DPC3-34BG is arranged in the fourth column.

The divided R pixel DPC3-34AR is assigned to L for stereo, and the divided G pixel DPC3-34BG is assigned to R for stereo.

Further, the multi-lens ML3-34 is arranged over the two divided pixels, i.e., the divided R pixel DPC3-34AR and the divided G pixel DPC3-34BG so as to be shared thereby.

In the third row, a complex pixel PCBG3-56 with the B pixel and the G pixel is formed over the fifth column and the sixth column in a state rotated by, for example, 45° from the Y direction to the X direction from the square arrangement as a reference.

The complex pixel PCBG3-56 includes a B pixel DPC3-56AB and a G pixel DPC3-56BG as two triangular divided pixels that are divided by the Y axis as a center. The divided B pixel DPC3-56AB is arranged in the fifth column, and the divided G pixel DPC3-34BG is arranged in the sixth column.

The divided B pixel DPC3-56AB is assigned to L for stereo, and the divided G pixel DPC3-56BG is assigned to R for stereo.

Further, the multi-lens ML3-56 is arranged over the two divided pixels, i.e., the divided B pixel DPC3-56AB and the divided G pixel DPC3-56BG so as to be shared thereby.

In the fourth row, a complex pixel PCGG4-01 with the G pixel and the G pixel is formed over the zeroth column and the first column in a state rotated by, for example, 45° from the Y direction to the X direction from the square arrangement as a reference.

The complex pixel PCGG4-01 includes a G pixel DPC4-01AG and a G pixel DPC4-01BG as two triangular divided pixels that are divided by the Y axis as a center. The divided G pixel DPC4-01AG is arranged in the zeroth column, and the divided G pixel DPC4-01BG is arranged in the first column.

The divided G pixel DPC4-01AG is assigned to L for stereo, and the divided G pixel DPC4-01BG is assigned to R for stereo.

Further, the multi-lens ML4-01 is arranged over the two divided pixels, i.e., the divided G pixel DPC4-01AG and the divided G pixel DPC4-01BG so as to be shared thereby.

In the fourth row, a complex pixel PCGG4-23 with the G pixel and the G pixel is formed over the second column and the third column in a state rotated by, for example, 45° from the Y direction to the X direction from the square arrangement as a reference.

The complex pixel PCGG4-23 includes a G pixel DPC4-23AG and a G pixel DPC4-23BG as two triangular divided pixels that are divided by the Y axis as a center. The divided G pixel DPC4-23AG is arranged in the second column, and the divided G pixel DPC4-23BG is arranged in the third column.

The divided G pixel DPC4-23AB is assigned to L for stereo, and the divided G pixel DPC4-23BG is assigned to R for stereo.

Further, the multi-lens ML4-23 is arranged over the two divided pixels, i.e., the divided G pixel DPC4-23AG and the divided G pixel DPC4-23BG so as to be shared thereby.

In the fourth row, a complex pixel PCGG4-45 with the G pixel and the G pixel is formed over the fourth column and the fifth column in a state rotated by, for example, 45° from the Y direction to the X direction from the square arrangement as a reference.

The complex pixel PCGG4-45 includes a G pixel DPC2-45AG and a G pixel DPC4-45BG as two triangular divided pixels that are divided by the Y axis as a center. The divided G pixel DPC4-45AG is arranged in the fourth column, and the divided G pixel DPC4-45BG is arranged in the fifth column.

The divided G pixel DPC4-45AG is assigned to L for stereo, and the divided G pixel DPC4-45BG is assigned to R for stereo.

Further, the multi-lens ML4-45 is arranged over the two divided pixels, i.e., the divided G pixel DPC4-45AG and the divided G pixel DPC4-45BG so as to be shared thereby.

In the fourth row, a complex pixel PCGG4-67 with the G pixel and the G pixel is formed over the sixth column and the seventh column in a state rotated by, for example, 45° from the Y direction to the X direction from the square arrangement as a reference.

The complex pixel PCGG4-67 includes a G pixel DPC4-67AG and a G pixel DPC4-67BG as two triangular divided pixels that are divided by the Y axis as a center. The divided G pixel DPC4-67AG is arranged in the sixth column, and the divided G pixel DPC4-67BG is arranged in the seventh column.

The divided G pixel DPC4-67AG is assigned to L for stereo, and the divided G pixel DPC4-67BG is assigned to R for stereo.

Further, the multi-lens ML4-67 is arranged over the two divided pixels, i.e., the divided G pixel DPC4-67AG and the divided G pixel DPC4-67BG so as to be shared thereby.

In the fifth row, a complex pixel PCRG5-12 with the R pixel and the G pixel is formed over the first column and the second column in a state rotated by, for example, 45° from the Y direction to the X direction from the square arrangement as a reference.

The complex pixel PCRG5-12 includes an R pixel DPC5-12AR and a G pixel DPC5-12BG as two triangular divided pixels that are divided by the Y axis as a center. The divided R pixel DPC5-12AR is arranged in the first column, and the divided G pixel DPC5-12BG is arranged in the second column.

The divided R pixel DPC5-12AR is assigned to L for stereo, and the divided G pixel DPC5-12BG is assigned to R for stereo.

Further, the multi-lens ML5-12 is arranged over the two divided pixels, i.e., the divided R pixel DPC5-12AR and the divided G pixel DPC5-12BG so as to be shared thereby.

In the fifth row, a complex pixel PCBG5-34 with the B pixel and the G pixel is formed over the third column and the fourth column in a state rotated by, for example, 45° from the Y direction to the X direction from the square arrangement as a reference.

The complex pixel PCBG5-34 includes a B pixel DPC5-34AB and a G pixel DPC5-34BG as two triangular divided pixels that are divided by the Y axis as a center. The divided B pixel DPC5-34AB is arranged in the third column, and the divided G pixel DPC5-34BG is arranged in the second column.

The divided B pixel DPC5-34AB is assigned to L for stereo, and the divided G pixel DPC5-34BG is assigned to R for stereo.

Further, the multi-lens ML5-34 is arranged over the two divided pixels, i.e., the divided B pixel DPC5-34AB and the divided G pixel DPC5-34BG so as to be shared thereby.

In the fifth row, a complex pixel PCRG5-56 with the R pixel and the G pixel is formed over the fifth column and the sixth column in a state rotated by, for example, 45° from the Y direction to the X direction from the square arrangement as a reference.

The complex pixel PCRG5-56 includes an R pixel DPC5-56AR and a G pixel DPC5-56BG as two triangular divided pixels that are divided by the Y axis as a center. The divided R pixel DPC5-56AR is arranged in the fifth column, and the divided G pixel DPC5-56BG is arranged in the sixth column.

The divided R pixel DPC5-56AR is assigned to L for stereo, and the divided G pixel DPC5-56BG is assigned to R for stereo.

Further, the multi-lens ML5-56 is arranged over the two divided pixels, i.e., the divided R pixel DPC5-56AR and the divided G pixel DPC5-56BG so as to be shared thereby.

In the pixel arrangement in FIG. 11, the complex pixels with the R pixel and the G pixel and the complex pixels with the B pixel and the G pixel are alternately arranged in the first row, the third row, and the fifth row. The complex pixels with the G pixel and the G pixel are arranged in the second row and the fourth row.

The configuration in FIG. 11 does not have an unnecessary pixel arrangement; therefore, deterioration in resolution caused by stereo is allowed to be suppressed.

Moreover, a detection transistor, wiring, and the like are allowed to be provided based on a square unit; therefore, miniaturization is allowed to be performed.

Further, the light reception surface is allowed to detect two parallaxes of LR in a configuration in which a zigzag honeycomb is vertically divided into two; therefore, even if the number of pixels is decreased to 1/2, zigzag honeycomb processing allows the record pixel number to be restored to be doubled, thereby compensating for deterioration in resolution caused by stereo.

Then, as described above, in this example, the G pixel as a main component pixel for luminance is assigned to one channel (R in this example) of L/R for stereo, and the color pixel R, G, or B is assigned to the other channel (L in this example); therefore, parallax information is detected in by the G pixels.

With such a configuration, parallax (Depth) calculation is easy, and since a same color is used, precision is high. Resolution is actually reduced; however, typically, low Depth resolution does not cause an issue.

Moreover, G as the color pixel is allowed to be used for a luminance signal, thereby leading to high resolution.

### (3. Signal Processing System)

Next, a signal processing system in a case where main component (W or/and G) pixels for luminance are assigned to one channel (ch) of L/R for above-described stereo, and the color pixels (R, G, and B) are assigned to the other channel will be described below.

A signal processing system corresponding to the zigzag arrangement in FIGs. 10 and 11 will be described below.

### (3-1. First Configuration Example of Signal Processing System)

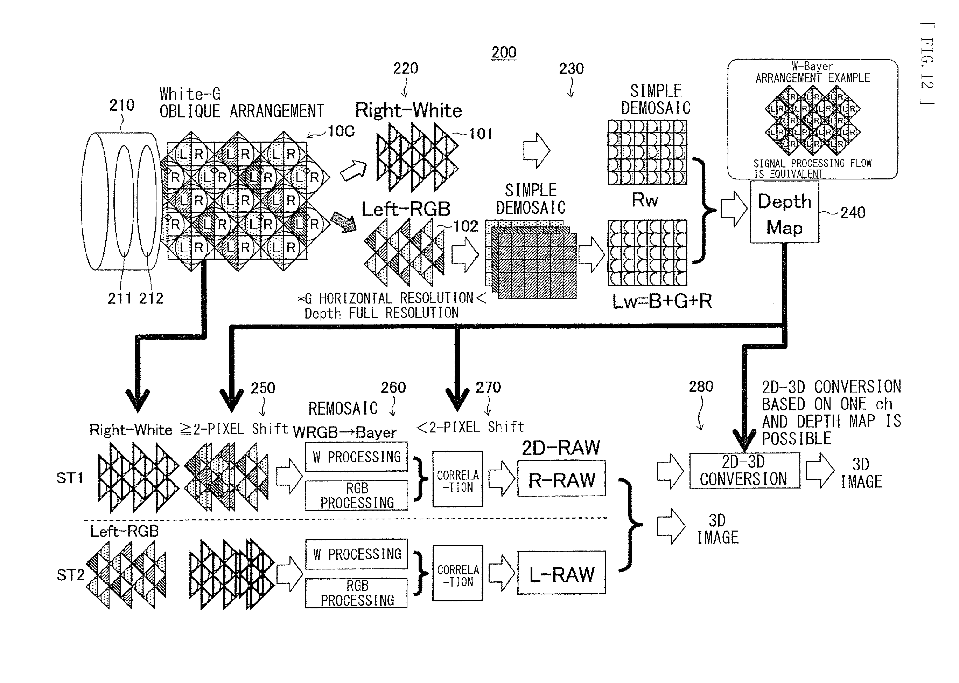

FIG. 12 is a diagram illustrating a configuration example of a monocular 3D-ready signal processing system in a case where the main component pixels for luminance are the W pixels.

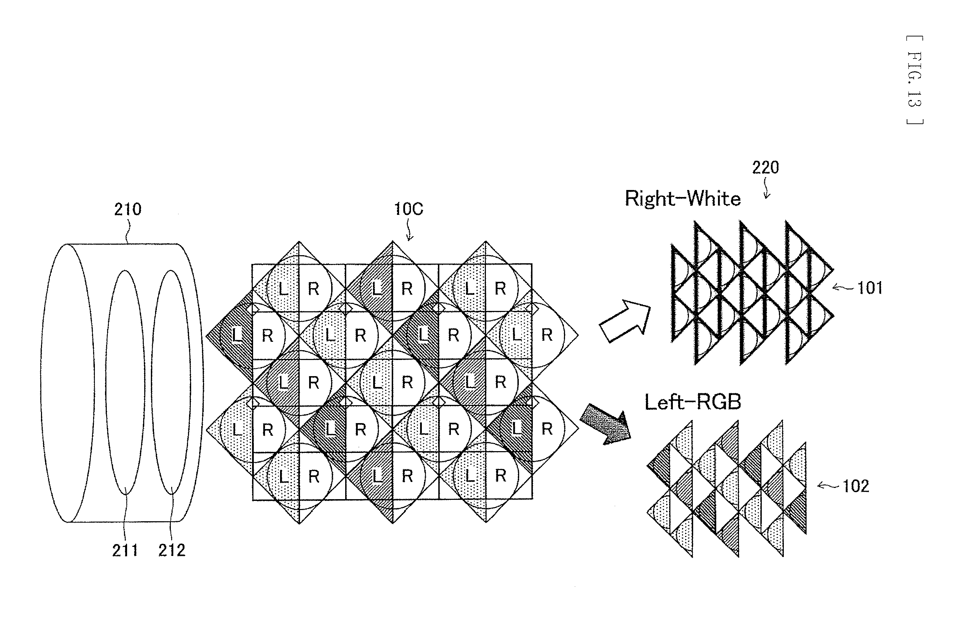

FIG. 13 is an enlarged view illustrating a process of dividing pixels for luminance and color pixels in a monocular 3D-ready solid-state image pickup device in a case where the main component pixels for luminance are the G pixels.

As a monocular 3D signal processing system 200 in FIGs. 12 and 13, an example in which a monocular optical system 210 is disposed on a light reception surface of a solid-state image pickup device 10C with a pixel arrangement having the W pixels as the main component pixels for luminance is illustrated.

The optical system 210 includes lenses 211 and 212.

The signal processing system 200 includes an LR separation section 220, a demosaic section 230, a parallax (Depth) map generation section 240, a parallax correction processing section (pixel shift section) 250, a remosaic section 260, a correlation processing section 270, and an image generation section 280.

In these components, the parallax correction processing section 250, the remosaic section 260, and the correlation processing section 270 are allowed to perform a first process ST1 and a second process ST2.

The LR separation section 220 separates W pixels 101 assigned to an R channel for stereo and RGB pixels 102 as color pixels assigned to an L channel from each other.

The demosaic section 230 performs simple demosaic processing on the separated W pixel 101 to generate a full pixel luminance signal Rw of an R-W pixel.

The demosaic section 230 performs simple demosaic processing on the separated RGB pixels 102 to generate a signal Lw (=R+G+B) obtained by addition of RGB.

The parallax map generation section 240 detects parallax displacement by the luminance signal Rw and the signal Lw by the demosaic section 230 to generate a high-precision parallax map.

The parallax correction processing section 250 shifts the RGB pixels 102 as color pixels based on parallax information by the parallax map generation section 240 in the first process ST1 to perform parallax correction processing. In this case, it is necessary to shift the RGB pixels 102 by two or more pixels for color matching.

The parallax correction processing section 250 shifts the W pixels 101 as the luminance pixels based on parallax information by the parallax map generation section 240 in the second process ST2 to perform parallax correction processing. In this case, it is not necessary to shift the W pixels by two or more pixels.

The remosaic section 260 performs remosaic processing on the W pixels and the shifted RGB pixels by the parallax correction processing section 250 in the first process ST1 to convert WRGB into, for example, a Bayer arrangement.

The remosaic section 260 performs remosaic processing on the shifted W pixels and the RGB pixels by the parallax correction processing section 250 in the second process ST2 to convert WRGB into, for example, a Bayer arrangement.

The correlation processing section 270 performs correlation processing on the W pixels and the RGB pixels by the remosaic section 260 in the first process ST1 to combine the W pixels and the RGB pixels with each other, thereby generating 2D raw data R-RAW.

The correlation processing section 270 performs correlation processing on the W pixels and the RGB pixels by the remosaic section 260 in the second process ST2 to combine the W pixels and the RGB pixels with each other, thereby generating 2D raw data L-RAW.

In the correlation processing, for example, processing based on G=Wx(mG)/(mW) is basically performed on the G pixels. In this case, "m" indicates an average.

Likewise, for example, processing based on R=Wx(mR)/(mW) is basically performed on the R pixels. Processing based on B=Wx(mB)/(mW) is basically performed on the B pixels.

The image generation section 280 directly generates a 3D image from the raw data R-RAW and L-RAW by the correlation processing section 270.

The image generation section 280 generates a 3D image by performing, on the raw data R-RAW by the correlation processing section 270, 2D-3D conversion processing based on the parallax map.

As described above, in the signal processing system 200 in FIG. 12, a 2D image with no deterioration in luminance resolution is obtainable by shifting the RGB pixels 102 as the color pixels based on the parallax (Depth) information.

Typically, since color resolution is recorded as 1/2 of luminance resolution, a side effect by parallax correction is less likely to be produced.

A 3D image is allowed to be generated by performing 2D-3D conversion on this high-image-quality 2D image based on the parallax map (Depth Map).

Moreover, in the signal processing system 200, when the W pixels 101 as the luminance pixels are shifted based on the parallax (Depth) information to be combined with the RGB pixels 102 as the color pixels, another parallax image is allowed to be generated, and a 3D image is allowed to be directly generated accordingly.

In this case, 2D-3D conversion is not necessary.

Moreover, in this channel, a color arrangement is not parallax-shifted; therefore, it is advantageous in that normal color signal processing is allowed to be performed.

Moreover, in the signal processing system 200, in a case where a parallax shift amount is smaller than a horizontal color arrangement cycle, parallax correction is allowed to be performed precisely by controlling weighting of a correlation filter coefficient when the luminance pixels and color pixels are combined with each other.

Thus, parallax displacement between luminance and color is allowed to be minimized.

It is to be noted that, in a binocular system, one parallax is a high-resolution luminance signal; therefore, resolution is easily increased to double in the vertical and lateral directions by super-resolution technology, and alignment by vertical 1/2 displacement is allowed to be performed without optical vertical spatial displacement.

Thus, an improvement in resolution is achievable.

### (3-2. Second Configuration Example of Signal Processing System)

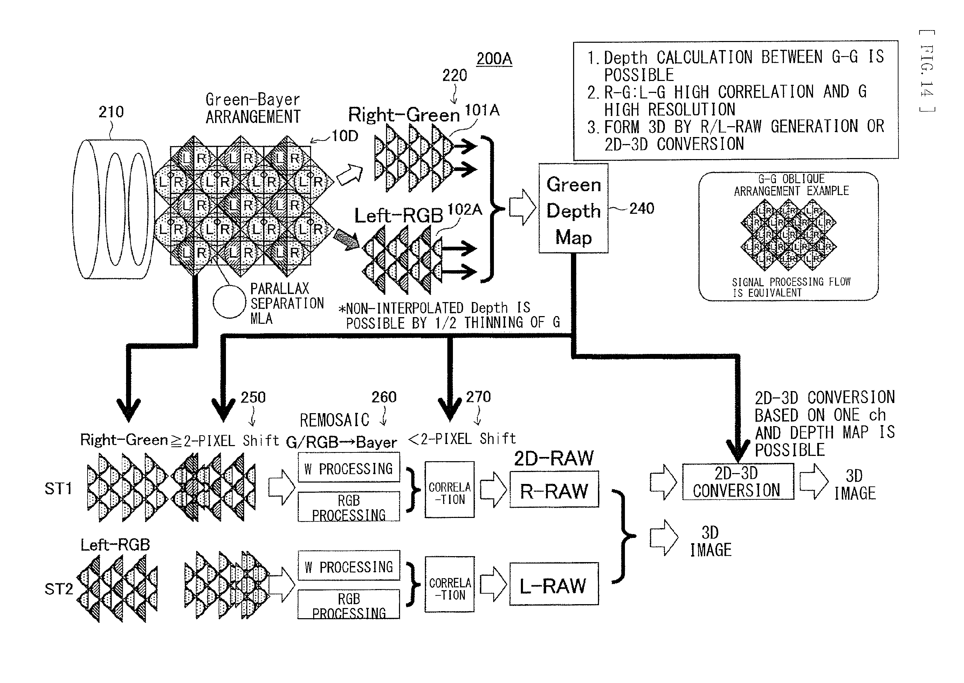

FIG. 14 is a diagram illustrating a configuration example of a monocular 3D-ready signal processing system in a case where the main component pixels for luminance are G pixels.

A signal processing system 200A in FIG. 14 is a monocular 3D-ready signal processing system in a case where the main component pixels for luminance are G pixels, and like components are denoted by like numerals as of FIG. 12.

In the signal processing system 200A in FIG. 14, the demosaic section in the signal processing system in FIG. 12 is not necessary. Other configurations are similar to those in FIG. 12.

In a pixel arrangement of G pixels 101A as separated main components for luminance and RGB pixels 102A as color pixels, only G pixels are arranged in a second row and a fourth row.

As a result, parallax (Depth) calculation between G-G is possible, and parallax information is allowed to be detected only by G pixels.

Moreover, since R-G and L-G have a high correlation relationship, and G pixels as the color pixels are allowed to be used, high resolution is obtained.

### (3-3. Third Configuration Example of Signal Processing System)

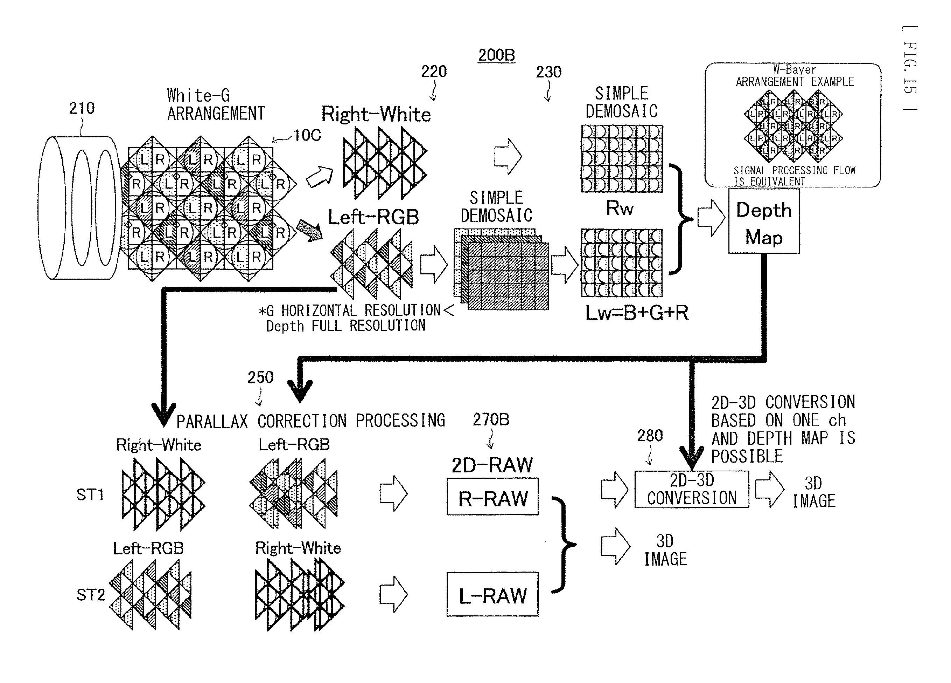

FIG. 15 is a diagram illustrating another configuration example of the monocular 3D-ready signal processing system in the case where the main component pixels for luminance are W pixels.

A signal processing system 200B in FIG. 15 differs from the signal processing system 200 in FIG. 12 in that remosaic processing and correlation processing are omitted.

Thus, even in a case where remosaic processing and correlation processing are not performed, a 2D image with less deterioration in luminance resolution is allowed to be obtained, and a high-resolution 3D image is allowed to be obtained.

### (3-4. Fourth Configuration Example of Signal Processing System)

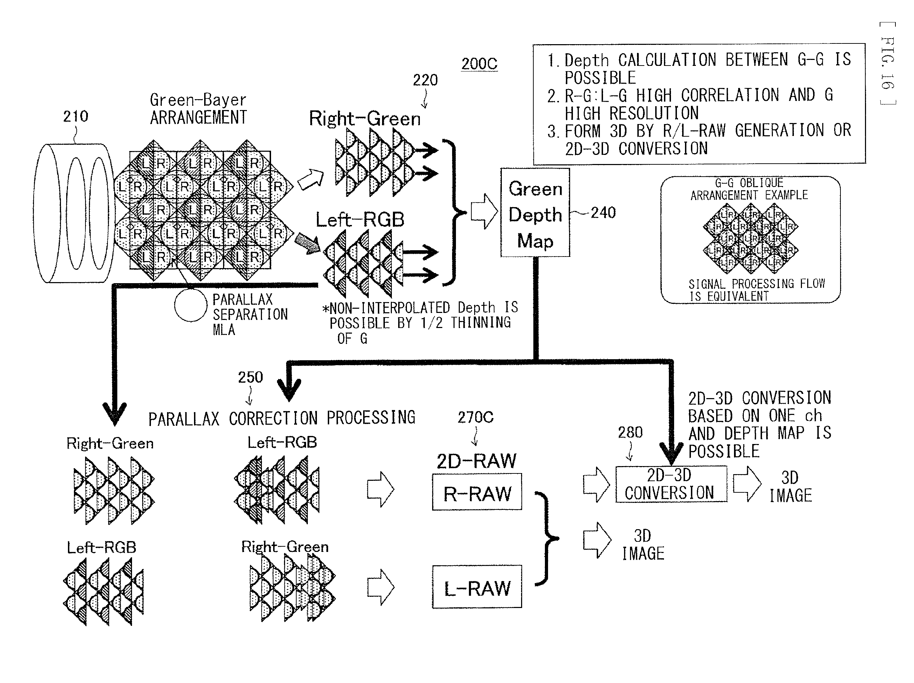

FIG. 16 is a diagram illustrating another configuration example of the monocular 3D-ready signal processing system in the case where the main component pixels for luminance are G pixels.

A signal processing system 200C in FIG. 16 differs from the signal processing system 200A in FIG. 14 in that remosaic processing and correlation processing are omitted.

Thus, even in a case where remosaic processing and correlation processing are not performed, a 2D image with less deterioration in luminance resolution is allowed to be obtained, and a high-resolution 3D image is allowed to be obtained.

It is to be noted that, in FIGs. 12 and 15, and FIGs. 14 and 16, as a parallax separation system, a multi-lens array is described as an example.

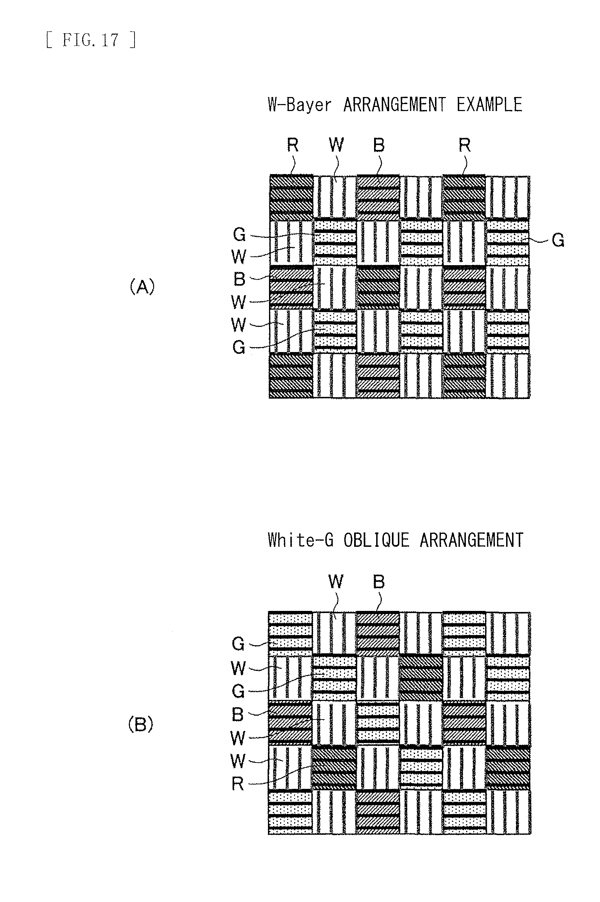

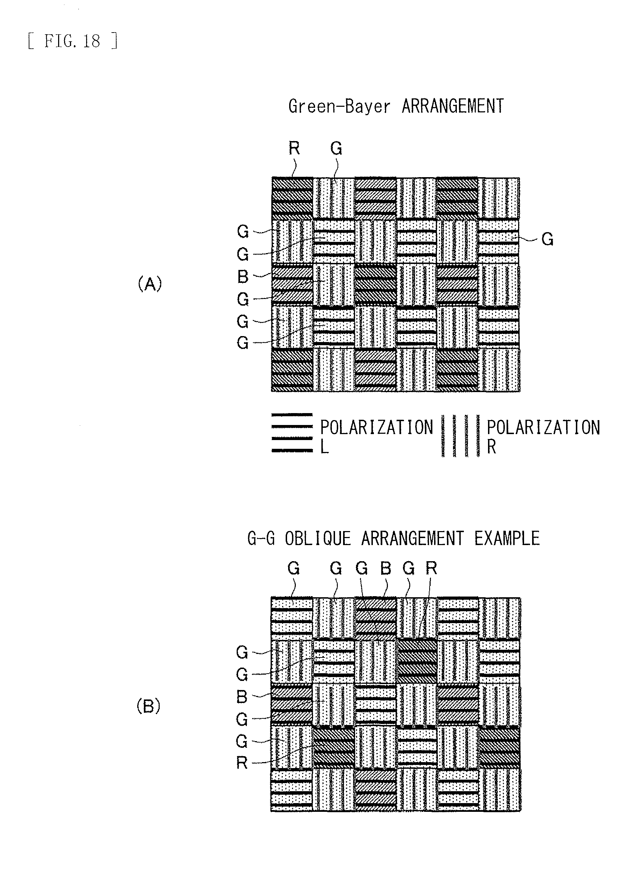

The present technology is not limited to the multi-lens array, and is applicable to a polarization system using polarization as illustrated in FIGs. 17(A) and (B), and FIGs. 18(A) and (B).

FIGs. 17(A) and (B) illustrate a polarization system pixel arrangement corresponding to configurations in FIGs. 12 and 15, and FIGs. 18(A) and (B) illustrate a polarization system pixel arrangement corresponding to configurations in FIGs. 14 and 16.

### (3-5. Another Configuration Example in Monocular Case (Example Using IR pixel))

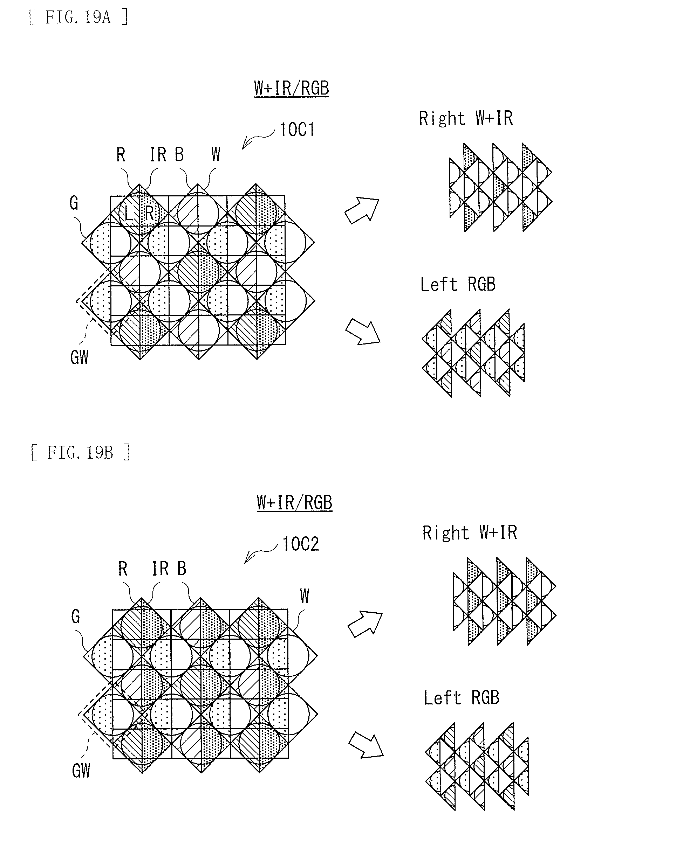

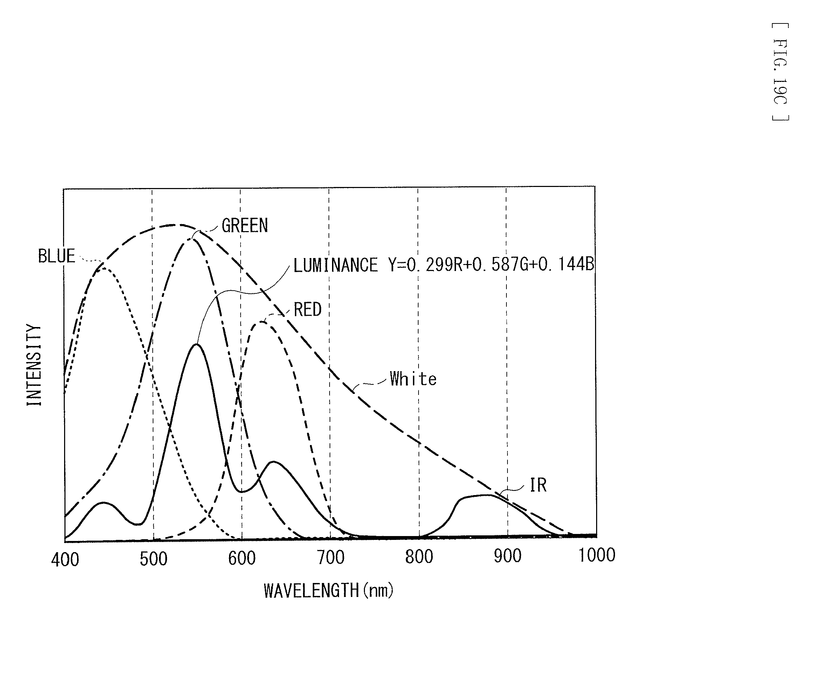

In the above-described configuration example, a case where W pixels or G pixels are assigned as the main component pixels for luminance is described; however, pixels having sensitivity to a wavelength with a different optical spectrum from that in the main component pixels for luminance may be further assigned to a same channel as the channel to which the main component pixels for luminance are assigned. In other words, pixels capable of receiving light with a wavelength that does not have a spectrum peak in a band that is the main component for luminance may be assigned to the same channel as the channel to which the main component pixels for luminance are assigned. FIGs. 19A to 24B illustrate examples of such a configuration. Moreover, in FIG. 19C, luminance and optical spectra of respective wavelengths of R (red), G (green), B (blue), W (white), and IR (near-infrared) are illustrated. As illustrated in FIG. 19C, the main component pixels for luminance are pixels having a sensitivity characteristic that has a peak or a sub-peak around a peak wavelength (for example, a wavelength of 550 nm) of luminance Y. It is to be noted that a range around the wavelength of 550 nm may be, for example, a wavelength within a range from 500 nm to 600 nm both inclusive. However, the range is not strictly limited to that range, and may be deviated from that range by about several tens of nm. As examples of such a main component pixel for luminance, the above-described W pixel and the above-described G pixel are adopted. For example, a W pixel having a peak on a low wavelength side around 500 nm may be adopted, or in a case where long-wavelength sensitivity is high, a W pixel having a peak on a long wavelength side around 600 nm may be adopted. Moreover, a G pixel having, for example, a peak around 540 nm may be adopted. In this configuration example, a case where pixels (IR pixels) capable of receiving IR are used will be described below as an example of a wavelength having an optical spectrum different from that in the main component pixels for luminance. Moreover, a case where mixing of the IR pixels and the main component pixels for luminance is assigned to the R channel will be described as an example.

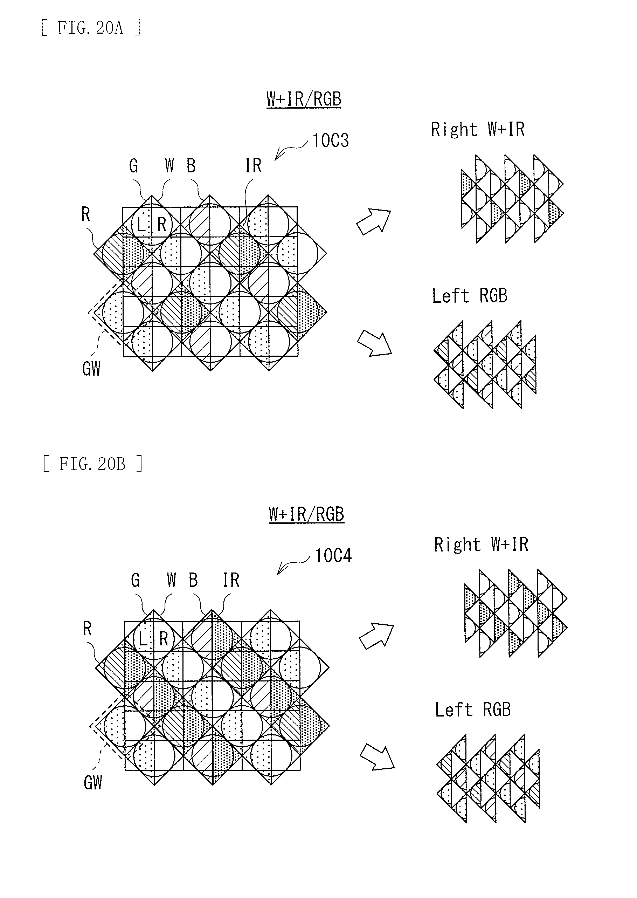

More specifically, in image sensors 10C1 and 10C2 illustrated in FIGs. 19A and 19B, respective pixels of W, IR, R, G, and B are arranged so as to allow W pixels and IR pixels to be assigned to the R channel, and so as to allow R pixels, G pixels, and B pixels to be assigned to the L channel. Moreover, in this example, a pixel pair GW in which the G pixel and the W pixel are arranged on the left and the right, respectively, is provided. Since such a pixel pair GW is provided, even if some of the W pixels are replaced with the IR pixels, reduction in Depth precision is allowed to be suppressed. It is to be noted that an arrangement of the IR pixels and the W pixels is not limited to such an arrangement, and, for example, pixel arrangements in image sensors 10C3, and 10C4 illustrated in FIGs. 20A and 20B may be adopted.

With a configuration in which the W pixels and the IR pixels are assigned to the R channel, an image is allowed to be taken even in, for example, darkness or the like while obtaining effects (suppression of deterioration in resolution, suppression of deterioration in sensitivity, and the like) similar to those of the image sensor 10C illustrated in FIG. 10; therefore, higher sensitivity in darkness is achievable.

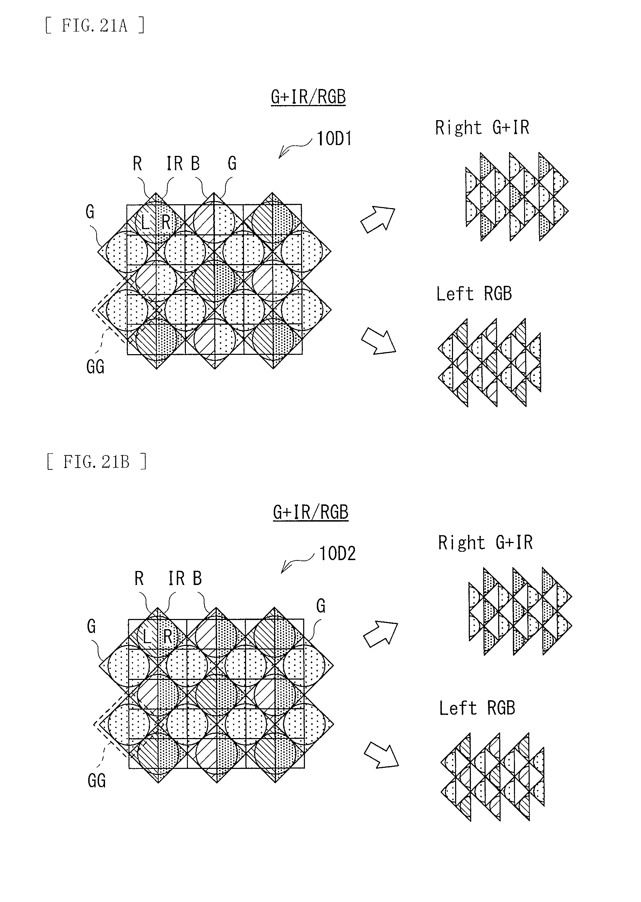

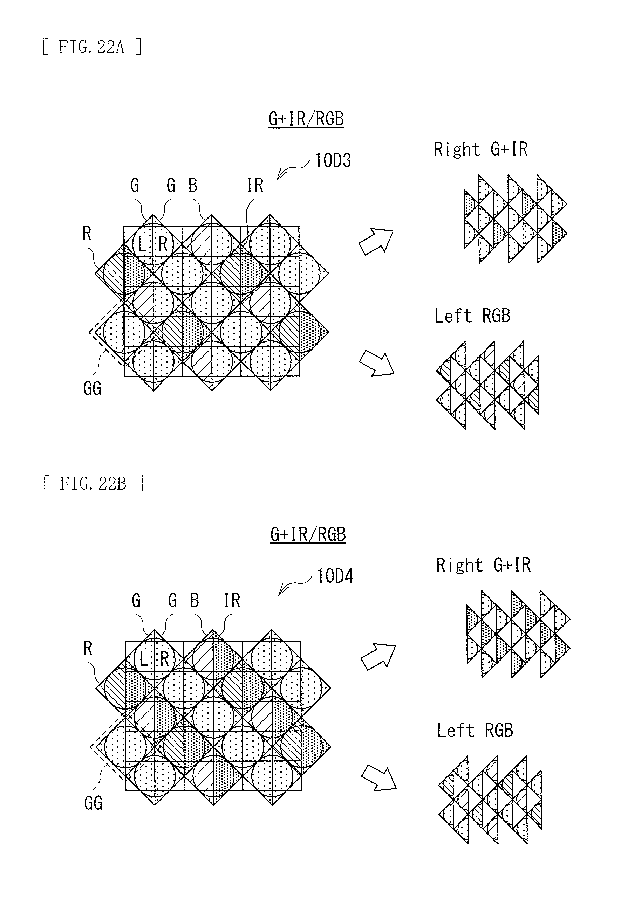

Alternatively, in image sensors 10D1 and 10D2 illustrated in FIGs. 21A and 21B, respective pixels of G, IR, R, G, and B are arranged so as to allow the G pixels and IR pixels to be assigned to the R channel and so as to allow the R pixels, G pixels, and B pixels to be assigned to the L channel. Moreover, in this example, a pixel pair GG in which the G pixel and the G pixel are arranged on the left and the right, respectively is provided. Since such a pixel pair GG is provided, even if some of the G pixels are replaced with the IR pixels, reduction in Depth precision is allowed to be suppressed. It is to be noted that an arrangement of the IR pixels and the G pixels is not limited to such an arrangement, and, for example, pixel arrangements in image sensors 10D3, and 10D4 illustrated in FIGs. 22A and 22B may be adopted.

With a configuration in which the G pixels and the IR pixels are assigned to the R channel, an image is allowed to be taken even in, for example, darkness or the like while obtaining effects (higher resolution, ease of Depth calculation, and the like) similar to those of the image sensor 10C illustrated in FIG. 11; therefore, higher sensitivity in darkness is achievable.

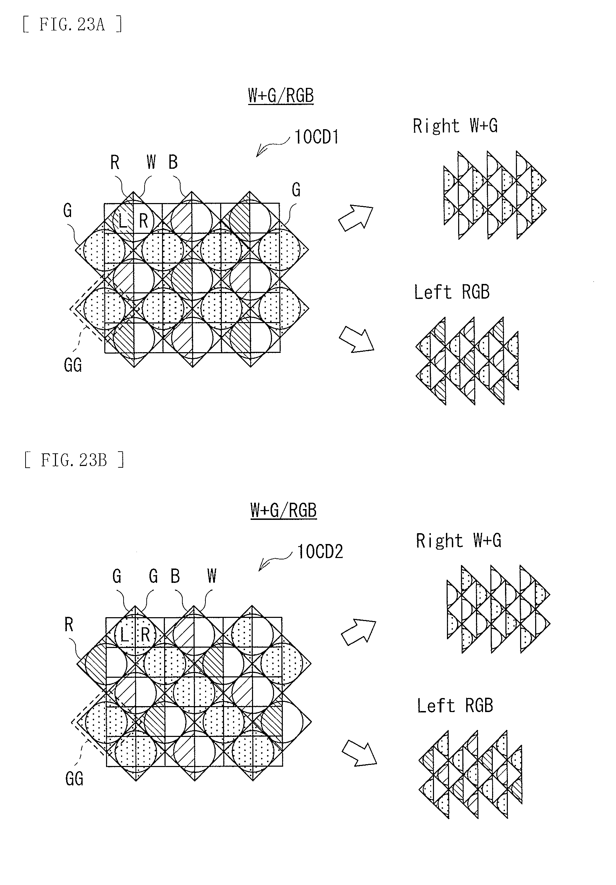

Alternatively, in image sensors 10CD1 and 10CD2 illustrated in FIGs. 23A and 23B, mixing of the W pixels and G pixels as the main component pixels for luminance may be assigned to the R channel. Even in this example, the pixel pair GG in which the G pixel and the G pixel are arranged on the left and the right, respectively is provided. Since such a pixel pair GG is provided, the Depth precision is allowed to be improved.

Thus, the W pixels and the G pixels may be assigned to the R channel, and effects of both of the image sensors 10C and 10D illustrated in FIGs. 10 and 11 are allowed to be obtained accordingly.

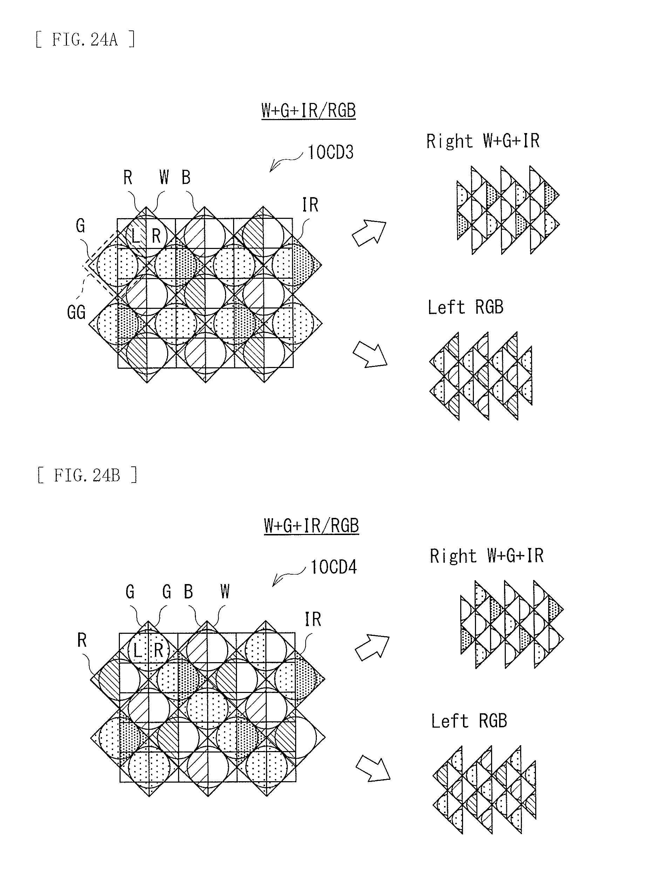

Moreover, a configuration in which W pixels and G pixels as the main component pixels for luminance, and the IR pixels may be assigned to the R channel such as image sensors 10CD3 and 10CD4 illustrated in FIGs. 24A and 24B may be adopted. Even in this example, the pixel pair GG in which the G pixel and the G pixel are arranged on the left and the right, respectively, is provided. Since such a pixel pair GG is provided, the Depth precision is allowed to be improved.

Thus, the W pixels and G pixels, and the IR pixels may be assigned to the R channel, and accordingly, an image is allowed to be taken even in, for example, darkness or the like while obtaining effects of both of the image sensors 10C and 10D illustrated in FIGs. 10 and 11; therefore, higher sensitivity in darkness is achievable.

### (4. Binocular or monocular 2-chip signal processing system)

In the above-described embodiment, the pixel arrangement and the signal processing system in the monocular case are described.

Basically, even in a binocular (compound-eye) or monocular 2-chip case, the present technology allows deterioration in luminance resolution and color resolution to be eliminated by assigning the main component pixels for luminance to one channel of L/R for stereo, and assigning color pixels to the other channel.

### (4-1. First Configuration Example of Binocular 2-chip 3D-ready Solid-state Image Pickup Device)

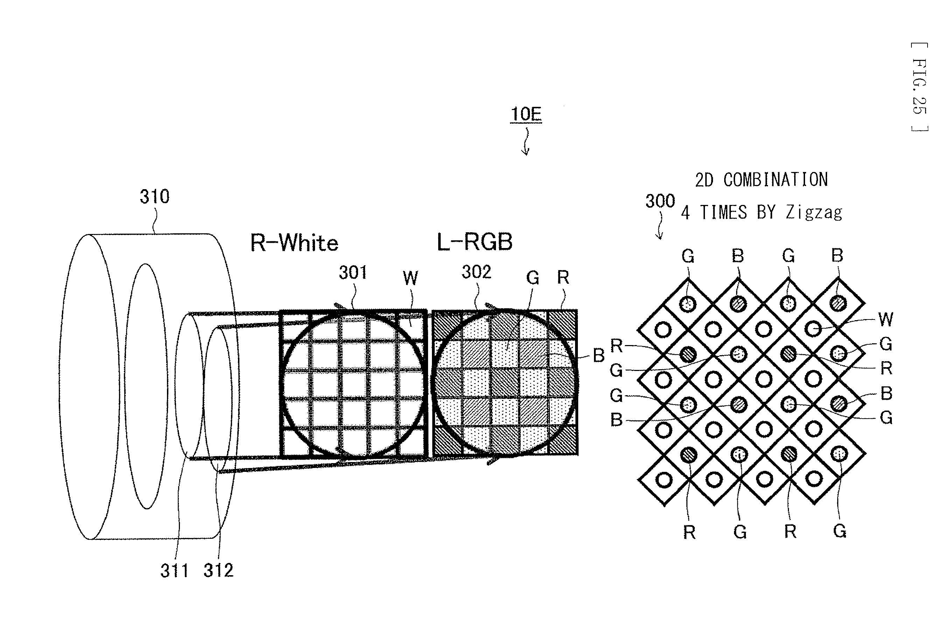

FIG. 25 is a diagram illustrating a first configuration example of a binocular 2-chip 3D-ready solid-state image pickup device (CMOS image sensor) in a case where the main component pixels for luminance are W pixels.

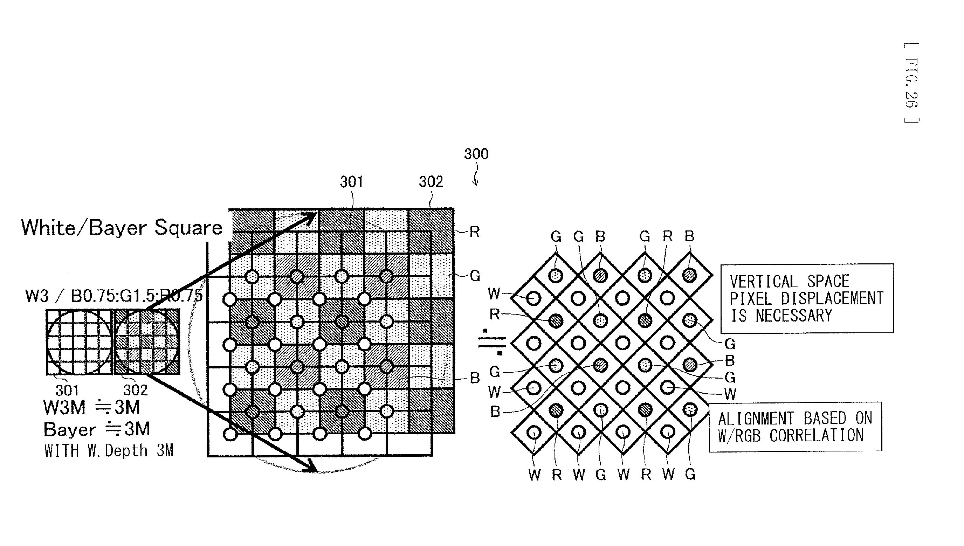

FIG. 26 is a diagram conceptually illustrating a process of performing space phase displacement on L/R images after being subjected to a parallax shift by the solid-state image pickup device in FIG. 25.

A CMOS image sensor 10E in FIG. 25 includes two chips 301 and 302 as pixel array sections of the image pickup device, and an optical system 301 including binocular-ready lenses 311 and 312 is arranged on a light incident side of the first chip 301 and the second chip 302.

In the first chip 301, W pixels as the main component pixels for luminance are arranged in a square, and in the second chip 302, RGB pixels as color pixels are formed as, for example, a Bayer square arrangement.

It is to be noted that the arrangement of the RGB pixels is not limited to the Bayer arrangement, and the RGB pixels may be arranged in an Arufa arrangement. In this case, an arrangement suitable for addition is allowed to be adopted.

A signal processing system 300 for the CMOS image sensor 10E performs space phase displacement in a zigzag manner as illustrated in FIGs. 25 and 26 on L/R pixels parallax-shifted by the parallax correction processing section in the above-described monocular 3D-ready signal processing system to combine the L/R pixels with each other.

In this case, the space phase displacement is vertical space pixel displacement, and alignment is performed by correlation of the W pixels and the RGB pixels.

This CMOS image sensor 10E for W/RGB adopts a checkerboard-like arrangement of the W pixels, and higher resolution and higher sensitivity are achievable by existing 2D signal processing.

### (4-2. Second Configuration Example of Binocular 2-chip 3D-ready Solid-state Image Pickup Device)

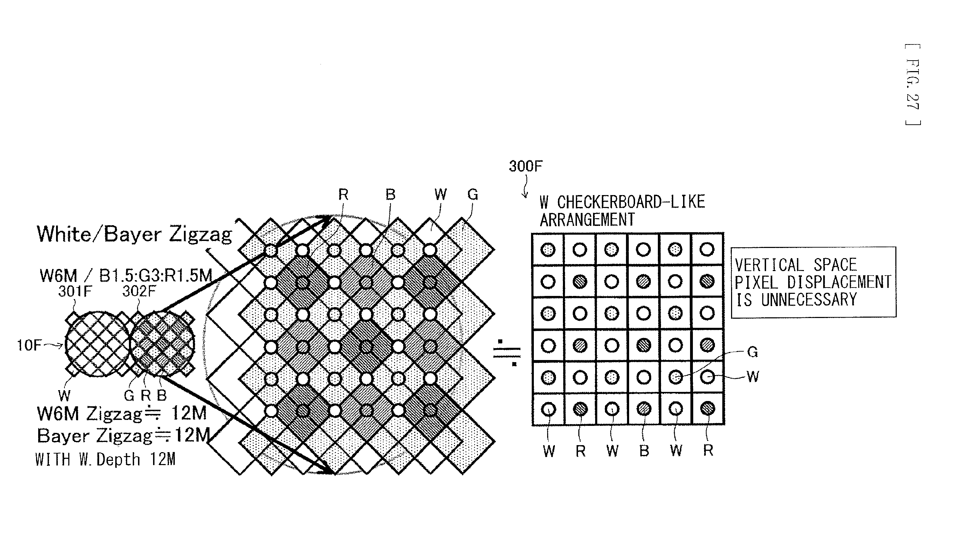

FIG. 27 is a diagram illustrating a second configuration example of the binocular 2-chip 3D-ready solid-state image pickup device (CMOS image sensor) in a case where the main component pixels for luminance are W pixels.

In a CMOS image sensor 10F in FIG. 27, W pixels in a chip 301F and RGB pixels in a chip 302F are formed as a zigzag arrangement similar to that in FIG. 10.

Thus, when the zigzag arrangement is adopted instead of the square arrangement, vertical space pixel displacement is not necessary, and displacement in the horizontal direction is achieved by parallax; therefore, the square arrangement is allowed to be formed after parallax correction, signal processing is simplified, and existing 2D signal processing is also used easily. As a result, cost reduction is achievable.

Moreover, since a view angle of one optical system is allowed to be reduced to 1/2 while having similar effects to those in the monocular case, reduction in profile of a lens is achievable.

### (4-3. Third Configuration Example of Binocular 2-chip 3D-ready Solid-state Image Pickup Device)

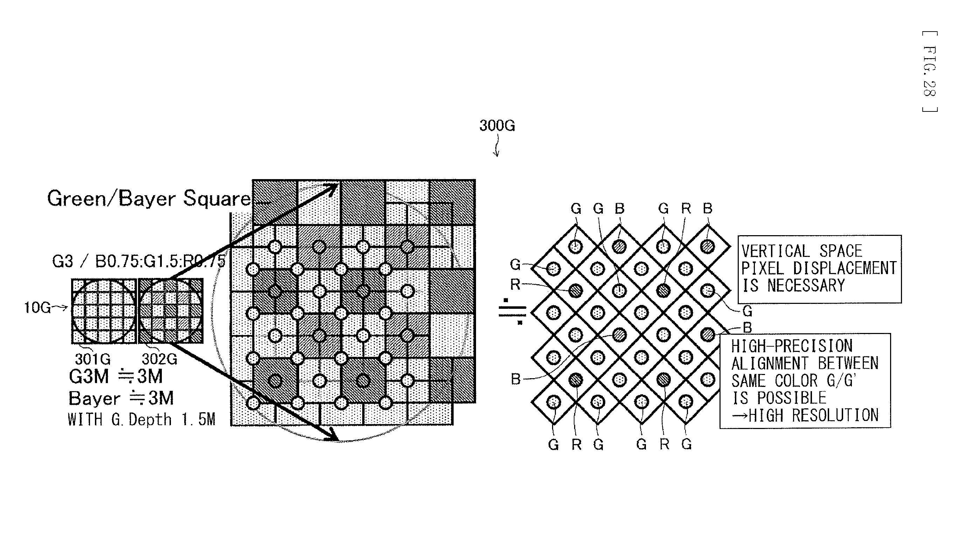

FIG. 28 is a diagram illustrating a third configuration example of the binocular 2-chip 3D-ready solid-state image pickup device (CMOS image sensor) in a case where the main component pixels for luminance are W pixels.

A CMOS image sensor 10G in FIG. 28 basically differs from the CMOS image sensor 10E in FIG. 25 in that, instead of the W pixels, G pixels are applied as the main component pixels for luminance.

In other words, in the CMOS image sensor 10G in FIG. 28, the G pixel and the R, G, or B pixel are separated for L and R, and parallax information is detected only by the G pixels.

In the CMOS image sensor 10G for G/RGB, higher resolution is achievable by existing 2D signal processing, and an parallax operation is possible only by the G pixels.

In other words, high-precise alignment between G pixels of a same color is possible, and higher resolution is achievable.

### (4-4. Fourth Configuration Example of Binocular 2-chip 3D-ready Solid-state Image Pickup Device)

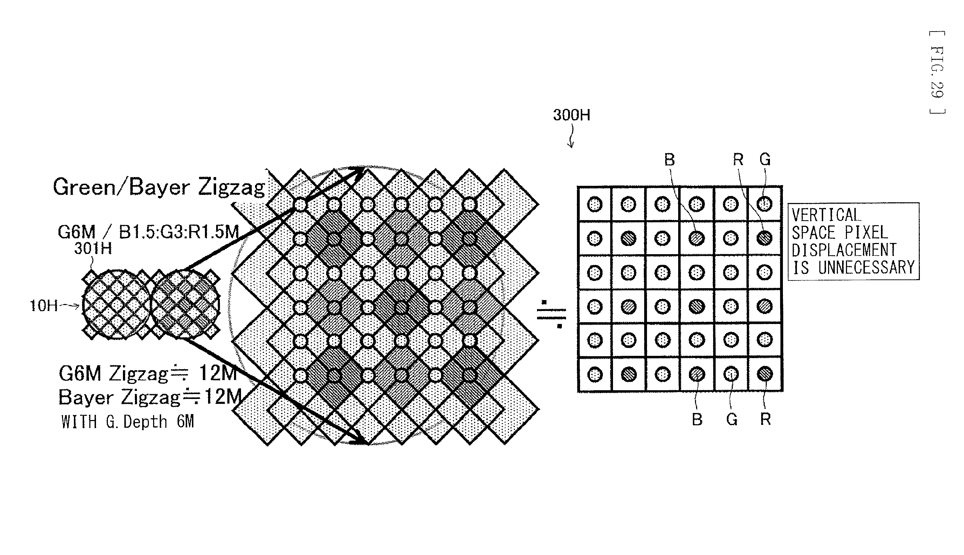

FIG. 29 is a diagram illustrating a fourth configuration example of the binocular 2-chip 3D-ready solid-state image pickup device (CMOS image sensor) in a case where the main component pixels for luminance are W pixels.

A CMOS image sensor 10H in FIG. 29 basically differs from the CMOS image sensor 10F in FIG. 27 in that, instead of the W pixels, G pixels are applied as the main component pixels for luminance.

In other words, in the CMOS image sensor 10H in FIG. 29, the G pixel and the R, G, or B pixel are separated for L and R, and parallax information is detected only by the G pixels.

In the CMOS image sensor 10H for G/RGB, higher resolution is achievable by existing 2D signal processing, and an parallax operation is possible only by the G pixels.

Moreover, even in this case, vertical space pixel displacement is not necessary, and displacement in the horizontal direction is achieved by parallax; therefore, the square arrangement is allowed to be formed after parallax correction, signal processing is simplified, and existing 2D signal processing is also used easily. As a result, cost reduction is achievable.

### (4-5. Another Configuration Example of Binocular 2-chip 3D-ready Solid-state Image Pickup Device)

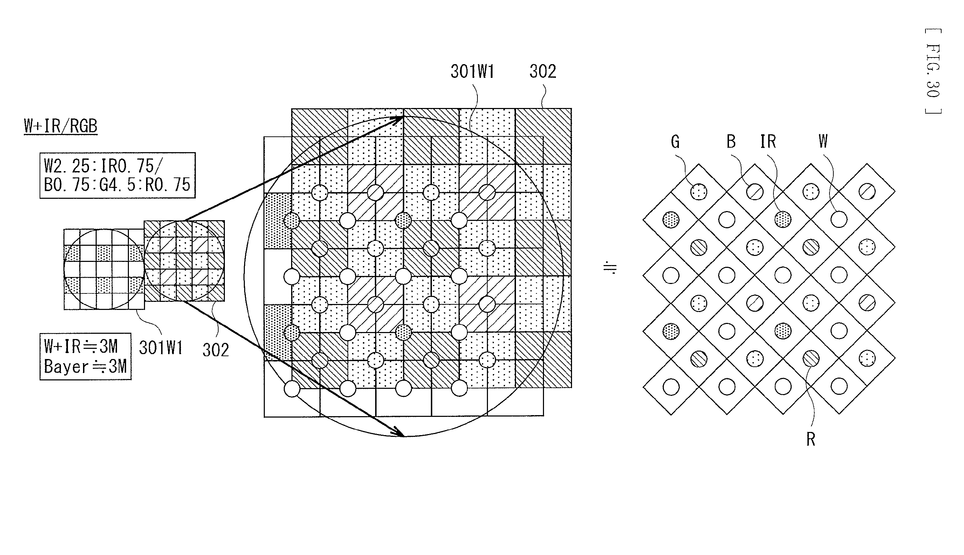

In the above-described configuration example, a case where W pixels or the G pixels are assigned as the main component pixels for luminance is described; however, pixels having sensitivity to a wavelength with a different optical spectrum from that in the main component pixels for luminance may be further assigned to a same channel as the channel to which the main component pixels for luminance are assigned. More specifically, in a binocular 2-chip configuration, for example, IR pixels may be provided to a chip corresponding to the same channel as the channel to which the main component pixels for luminance are assigned. Moreover, both the W pixel and G pixel may be provided to a same chip. FIGs. 30 to 49 illustrate examples of such a configuration. It is to be noted that, in each of the diagrams in FIGs. 30 to 49, a diagram on the right conceptually illustrates processing on a 2D signal generated with use of L/R pixels after being subjected to a parallax shift.

### (Example in which W pixels and IR pixels are arranged in one chip)

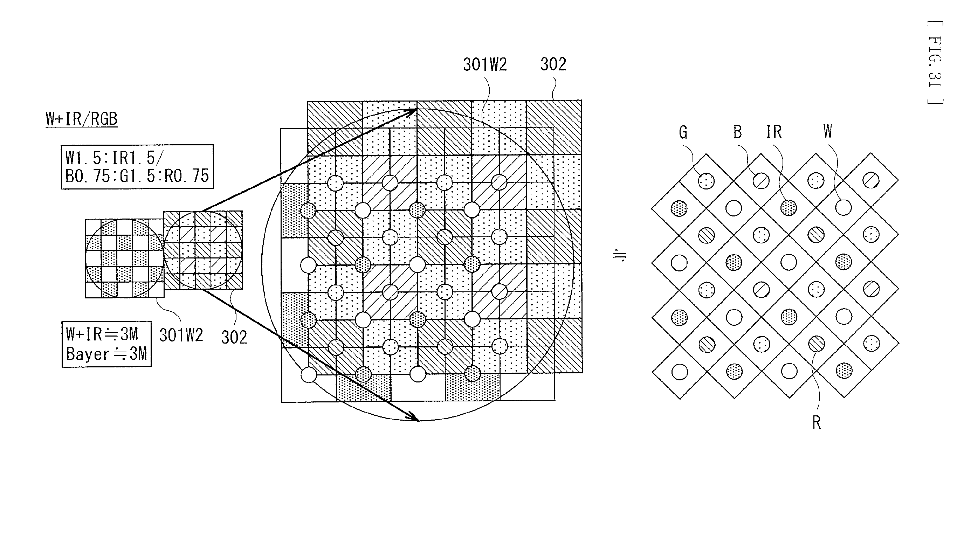

More specifically, as illustrated in FIG. 30, W pixels (main component pixels for luminance) and IR pixels may be arranged (in a square arrangement) in a first chip 301W1. In this case, in the first chip 301W1, the IR pixels equal in number to about 1/4 of all pixels are provided. The pixel arrangement in the second chip 302 is similar to the above-described first configuration example. In this case, the parallax-shifted L/R pixels are combined by performing space phase displacement (vertical space pixel displacement) in 2D signal processing. Depth detection is performed with use of the W pixels in the first chip 301W1 and the G pixels in the second chip 302. Moreover, high sensitivity is achieved by performing alignment from correlation of the W pixels and the RGB pixels. When the IR pixels are provided to a same chip (the first chip 301W1) as the chip including the main component pixels for luminance in such a configuration, for example, an image is allowed to be taken even in darkness or the like while obtaining effects similar to those in the above-described first configuration example, and high sensitivity in darkness is achievable. Moreover, for example, like a first chip 301W2 illustrated in FIG. 31, the number of IR pixels may be increased more than that in the above-described first chip 301W1 to further enhance sensitivity in darkness.

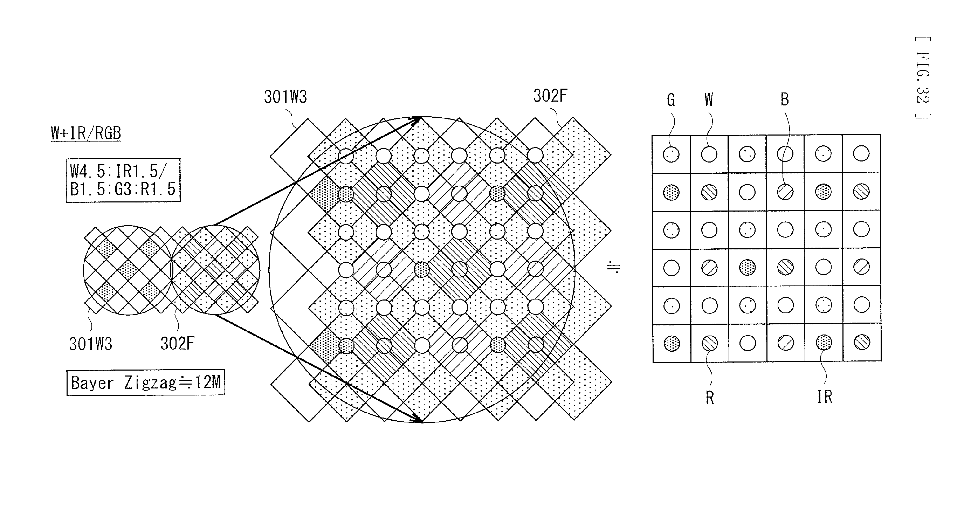

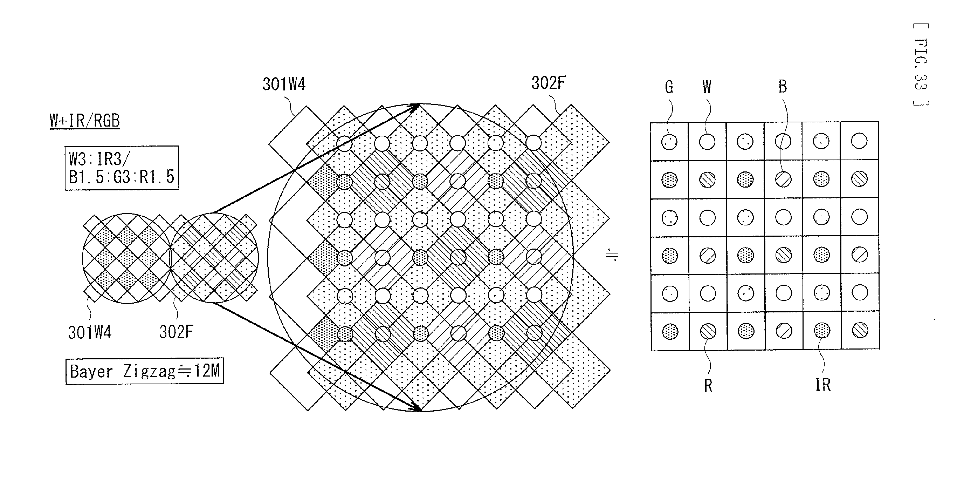

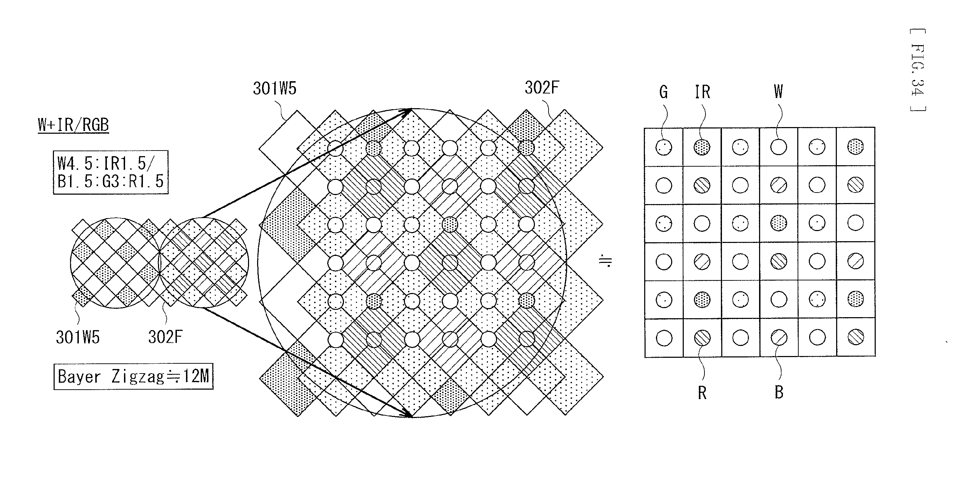

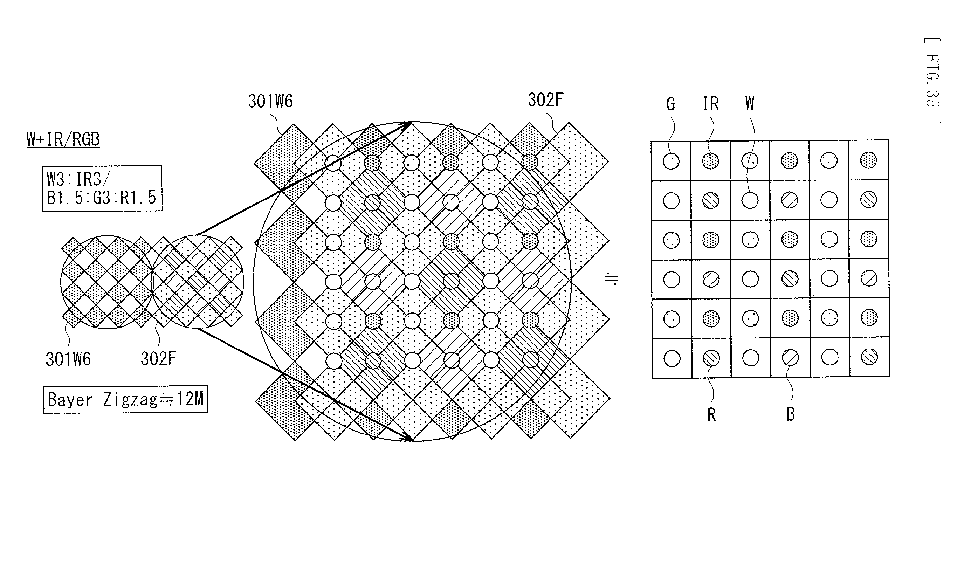

Moreover, as illustrated in FIG. 32, W pixels and IR pixels may be arranged (in a zigzag arrangement) in a first chip 301W3. The pixel arrangement in the second chip 302F is similar to that in the above-described second configuration example. In this case, the parallax-shifted L/R pixels are allowed to be combined in 2D signal processing without performing space phase displacement (vertical space pixel displacement). Depth detection is performed with use of the W pixels in the first chip 301W3 and the G pixels in the second chip 302F. A pixel arrangement in which a row of W pixels in the first chip 301W3 and a row of G pixels in the second chip 302F coincide with each other is adopted; therefore, reduction in Depth precision is allowed to be suppressed. When the IR pixels are provided to a same chip (the first chip 301W3) as the chip including the main component pixels for luminance in such a configuration, for example, an image is allowed to be taken even in darkness or the like while obtaining effects similar to those in the above-described second configuration example, and higher sensitivity in darkness is achievable. Moreover, for example, like a first chip 301W4 illustrated in FIG. 33, the number of IR pixels may be increased more than that in the above-described first chip 301W3 to further enhance sensitivity in darkness. Further, a pixel arrangement such as a first chip 301W5 illustrated in FIG. 34 or a first chip 301W6 illustrated in FIG. 35 may be adopted.

### (Examples in which G pixels and IR pixels are arranged in one chip)

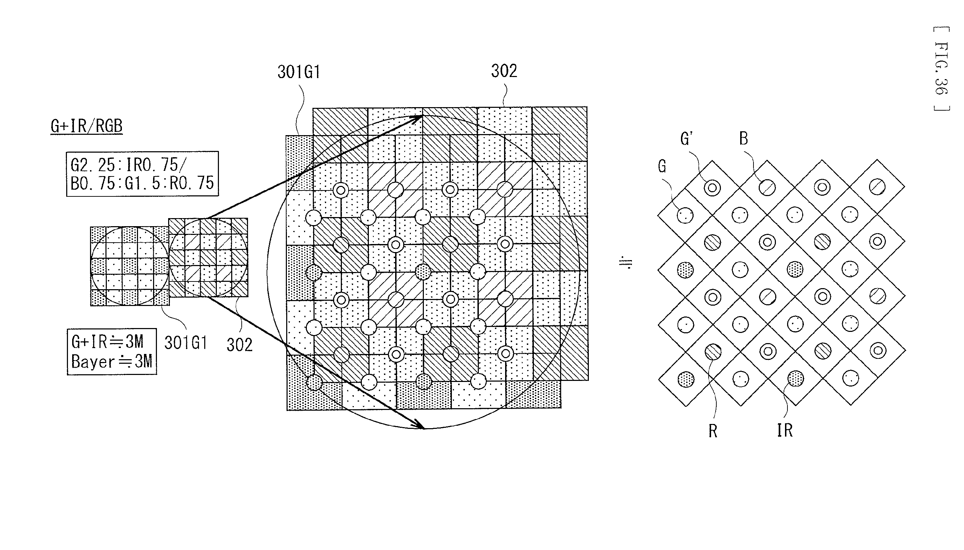

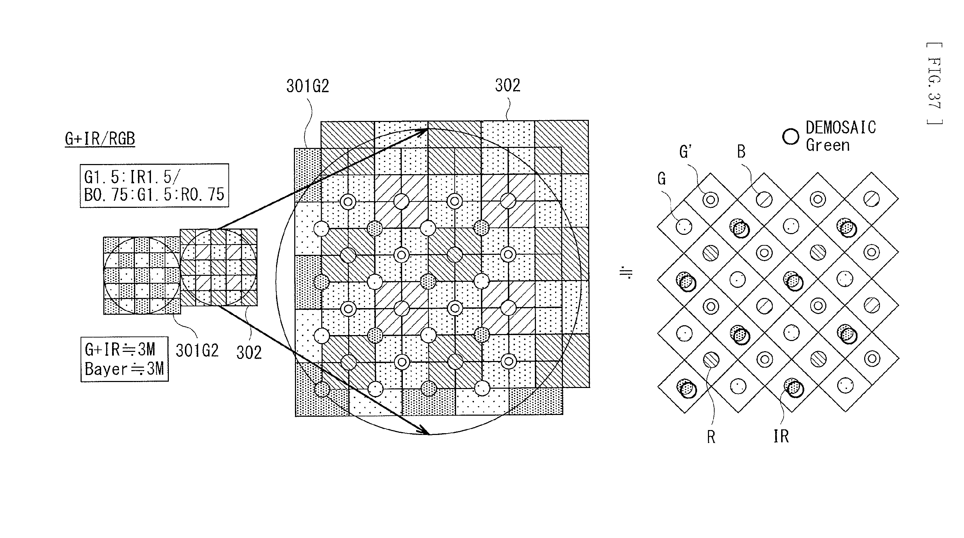

Alternatively, as illustrated in FIG. 36, G pixels (main component pixels for luminance) and IR pixels may be arranged (in a square arrangement) in a first chip 301G1. In this case, in the first chip 301G1, the IR pixels equal in number to about 1/4 of all pixels are provided. The pixel arrangement in the second chip 302 is similar to that in the above-described first configuration example. In this case, the parallax-shifted L/R pixels are combined by performing space phase displacement (vertical space pixel displacement) in 2D signal processing. Depth detection is performed with use of the G pixels (indicated by "G" in the diagram) in the first chip 301G1 and the G pixels (indicated by "G"' in the diagram) in the second chip 302. When the G pixels and the G' pixels on the left and the right are aligned, Depth precision is maintained, and a luminance signal is not necessary in Depth calculation; therefore, simple processing is possible. Moreover, alignment is allowed to be performed with use of the G pixels and G' pixels on the left and the right. When IR Pixels are provided to a same chip (the first chip 301G1) as the chip including the main component pixels for luminance in such a configuration, for example, an image is allowed to be taken even in darkness or the like while obtaining effects similar to those in the above-described third configuration example; therefore, higher sensitivity in darkness is achievable. Moreover, for example, like a first chip 301G2 illustrated in FIG. 37, the number of IR pixels may be increased more than that in the above-described first chip 301G1 to further enhance sensitivity in darkness. It is to be noted that a 2D signal arrangement equivalent to that in the above-described FIG. 36 is obtainable by demosaic processing.

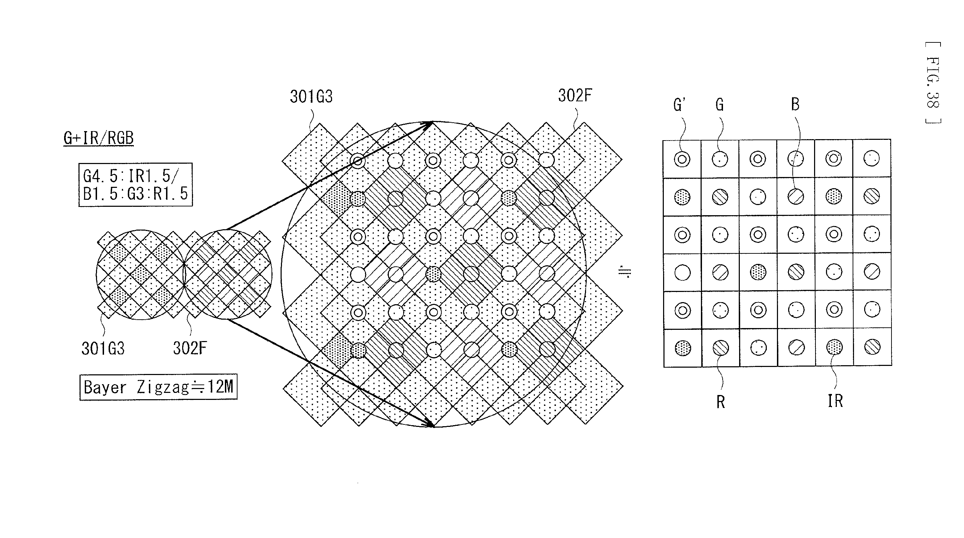

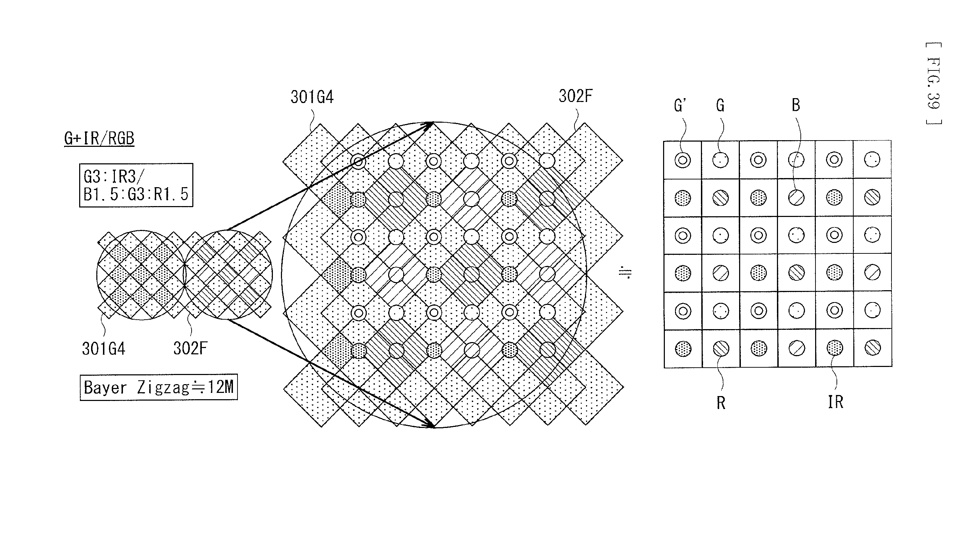

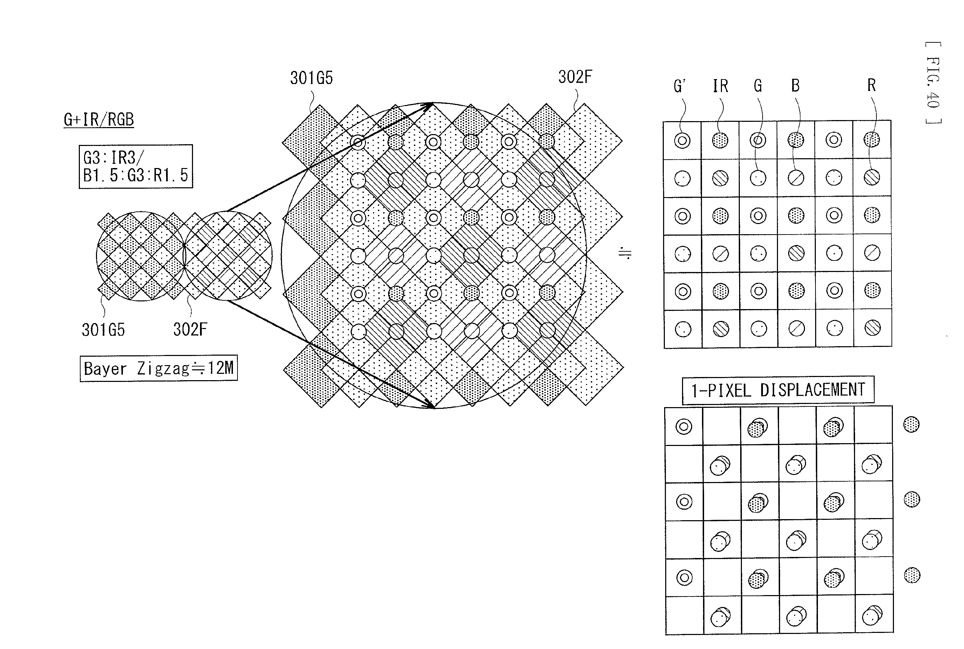

Moreover, as illustrated in FIG. 38, G pixels and IR pixels may be arranged (in a zigzag arrangement) in a first chip 301G3. The pixel arrangement in the second chip 302F is similar to that in the above-described second configuration example. In this case, the parallax-shifted L/R pixels are allowed to be combined in 2D signal processing without performing space phase displacement (vertical space pixel displacement). Depth detection is performed with use of the G pixels ("G" in the diagram) in the first chip 301G3 and the G pixels ("G"' in the diagram) in the second chip 302F. When the G pixels and the G' pixels on the left and the right are aligned, Depth precision is maintained, and a luminance signal is not necessary in Depth calculation; therefore, simple processing is possible. When the IR pixels are provided to a same chip (the first chip 301G3) as the chip including the main component pixels for luminance in such a configuration, for example, an image is allowed to be taken even in darkness or the like while obtaining effects similar to those in the above-described fourth configuration example, and higher sensitivity in darkness is achievable. Moreover, for example, like a first chip 301G4 illustrated in FIG. 39, the number of IR pixels may be increased more than that in the above-described first chip 301G3 to further enhance sensitivity in darkness. Further, when a pixel arrangement in which a row of G pixels in the first chip 301G5 and a row of R pixels and B pixels in the second chip 302F coincide with each other is adopted as illustrated in FIG. 40, a G checkerboard-like arrangement is formed even if parallax displacement by one pixel occurs during combination; therefore, G resolution is improved.

### (Examples in which W pixels and G pixels are arranged in one chip)

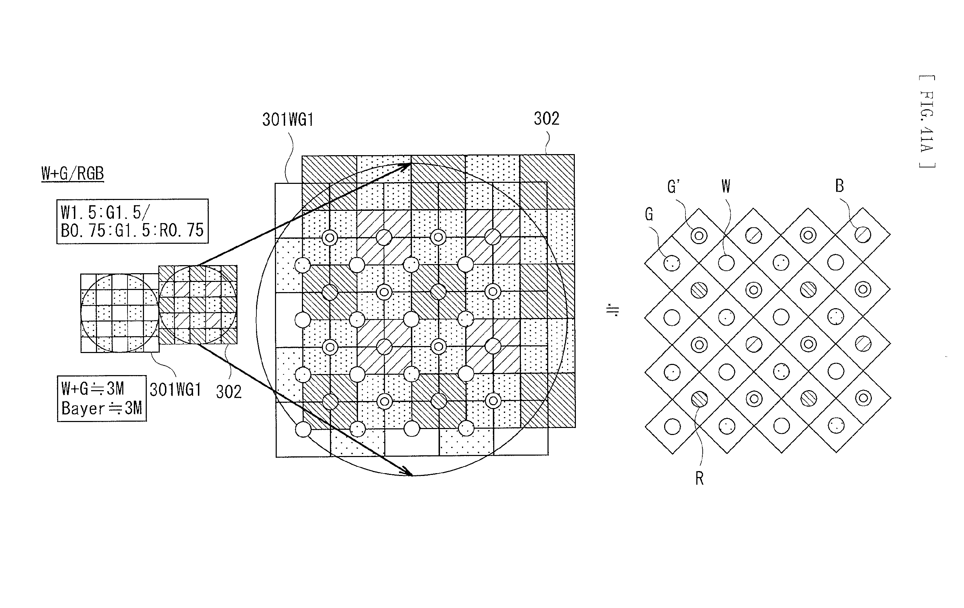

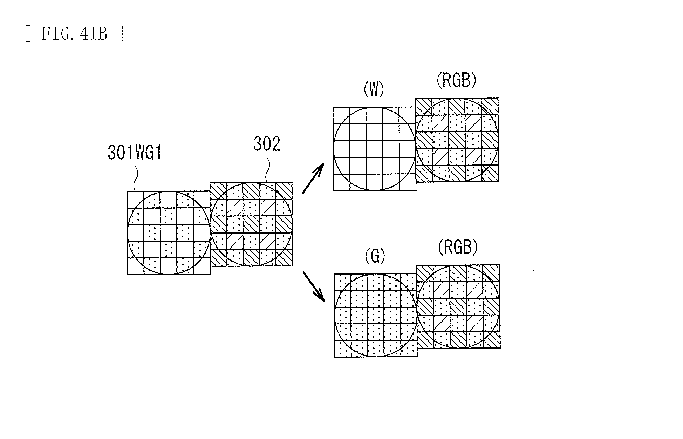

Alternatively, as illustrated in FIG. 41A, the W pixels and the G pixels as the main component pixels for luminance may be arranged (in a square arrangement) in a first chip 301WG1. The pixel arrangement in the second chip 302 is similar to the above-described first configuration example. In this case, the parallax-shifted L/R pixels are allowed to be combined by performing space phase displacement (vertical space pixel displacement) in 2D signal processing. Depth detection is performed with use of the G pixels ("G" in the diagram) in the first chip 301G1 and the G pixels ("G"' in the diagram) in the second chip 302. When the G pixels and the G' pixels on the left and the right are aligned, Depth precision is maintained. Moreover, alignment is allowed to be performed with use of the G pixels and G' pixels on the left and the right. With such a configuration, higher precision and higher sensitivity of Depth detection and higher resolution are compatible. Moreover, in this case, as illustrated in FIG. 41B, characteristics in a W arrangement (higher sensitivity and higher resolution) and characteristics in a G arrangement (improvement in or maintenance of Depth precision) are allowed to be used together by performing demosaic processing of W and G on a signal obtained from the first chip 301WG1.

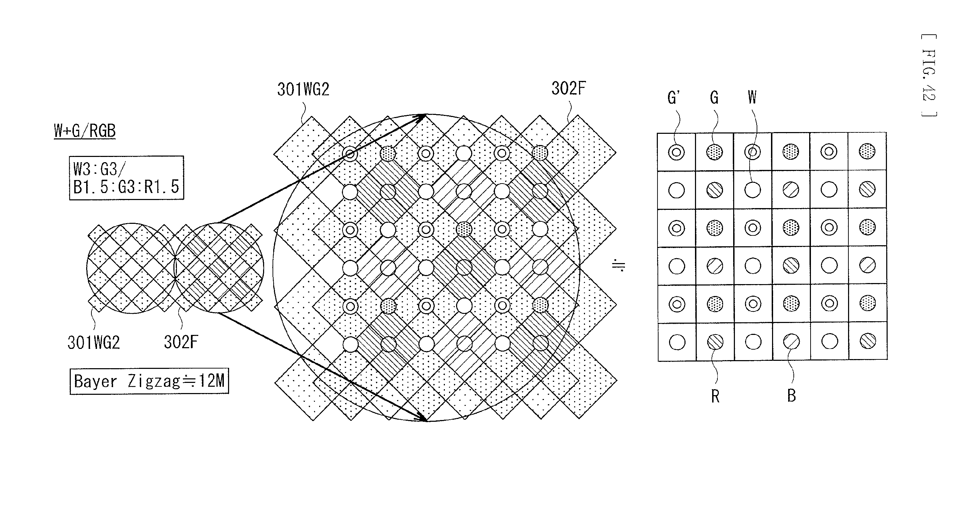

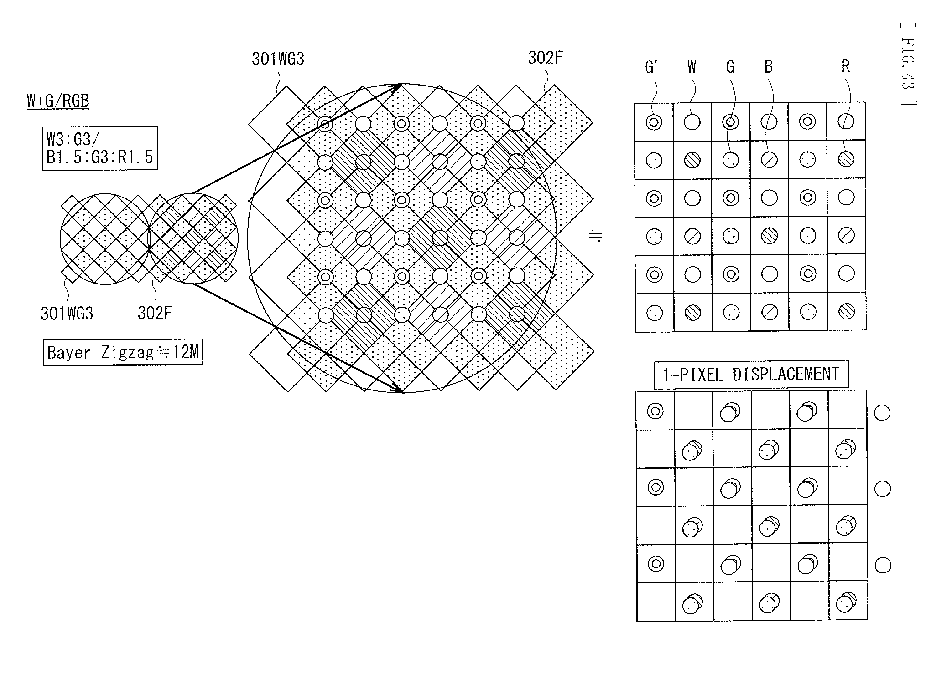

Moreover, as illustrated in FIG. 42, the W pixels and G pixels may be arranged (in a zigzag arrangement) in a first chip 301WG2. A pixel arrangement in the second chip 302F is similar to that in the above-described second configuration example. In this case, the parallax-shifted L/R pixels are allowed to be combined without performing space phase displacement (vertical space pixel displacement) in 2D signal processing. Depth detection is performed with use of the G pixels ("G" in the diagram) in the first chip 301G3 and the G pixels ("G"' in the diagram) in the second chip 302. When the G pixels and G' pixels on the left and the right are aligned, Depth precision is maintained, and a luminance signal is not necessary in Depth calculation; therefore, simple processing is possible. With such a configuration, maintenance of (or an improvement in) precision and higher sensitivity in Depth detection and higher resolution are compatible. Moreover, for example, when a pixel arrangement in which a row of G pixels in the first chip 301WG3 and a row of R pixels and B pixels in the second chip 302F coincide with each other is adopted as illustrated in FIG. 43, G checkerboard-like arrangement is formed even if parallax displacement by one pixel occurs during combination; therefore, G resolution is improved.

### (Example in which W and G pixels and IR pixels are arranged in one chip)

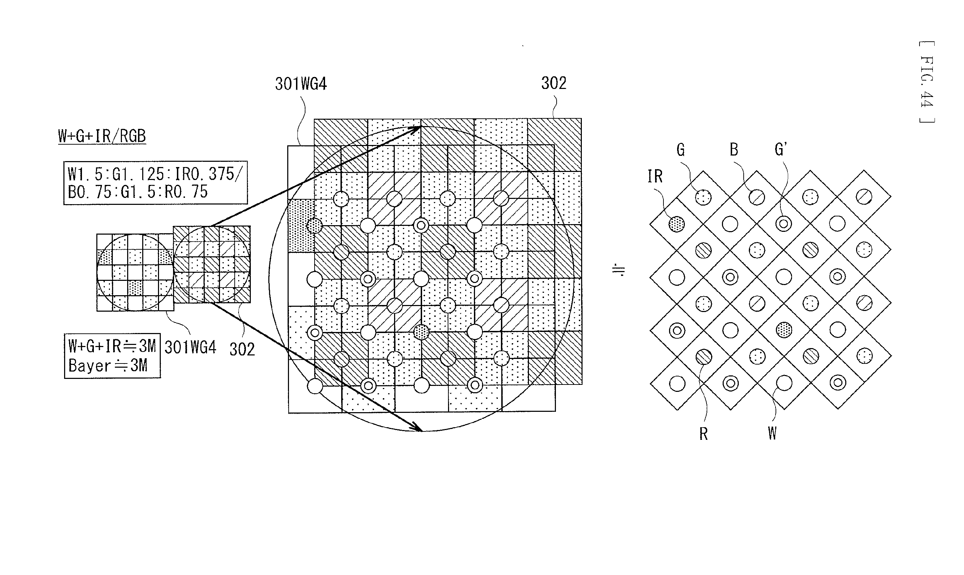

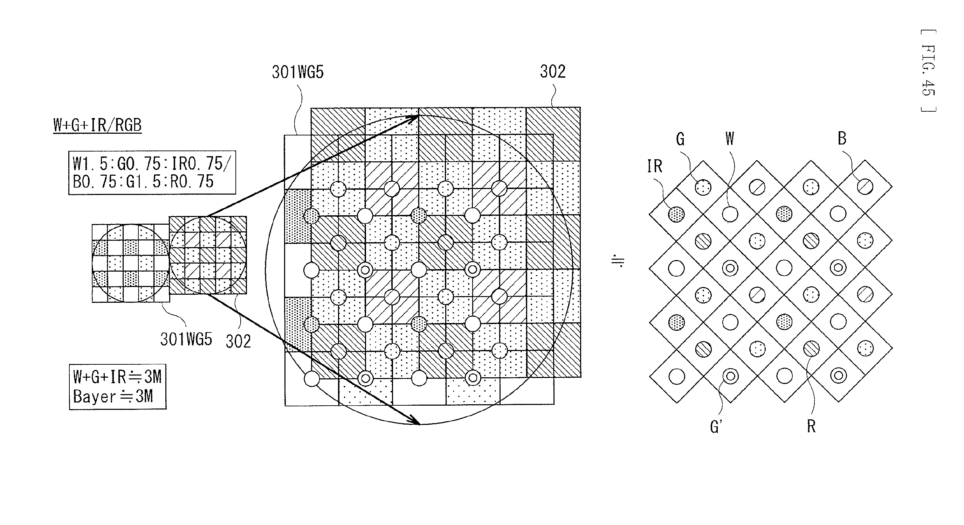

Alternatively, as illustrated in FIG. 44, the W pixels and G pixels as the main component pixels for luminance and the IR pixels may be arranged (in a square arrangement) in a first chip 301WG4. The pixel arrangement in the second chip 302 is similar to that in the above-described first configuration example. In this case, the parallax-shifted L/R pixels are allowed to be combined by performing space phase displacement (vertical space pixel displacement) in 2D signal processing. Depth detection is performed with use of the G pixels ("G" in the diagram) in the first chip 301G1 and the G pixels ("G"' in the diagram) in the second chip 302. Moreover, alignment is allowed to be performed with use of the G pixels and the G' pixels on the left and the right. With such a configuration, maintenance of (an improvement in) precision of Depth detection, higher sensitivity in brightness and darkness, and higher resolution are achievable by providing the IR pixels to a same chip (the first chip 301WG4) as the chip including the main component pixels for luminance. Further, for example, like a first chip 301WG5 illustrated in FIG. 45, the number of IR pixels may be increased more than that in the above-described first chip 301WG4 to further enhance sensitivity in darkness.

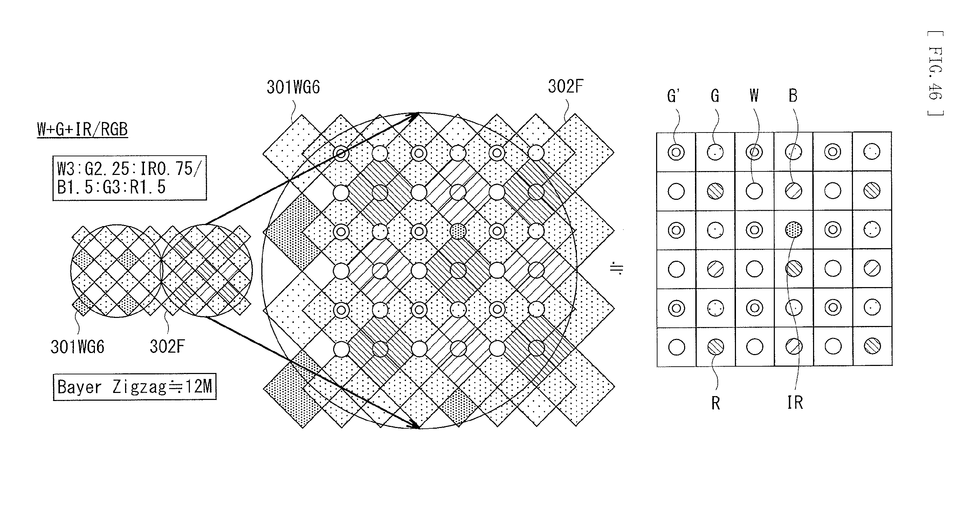

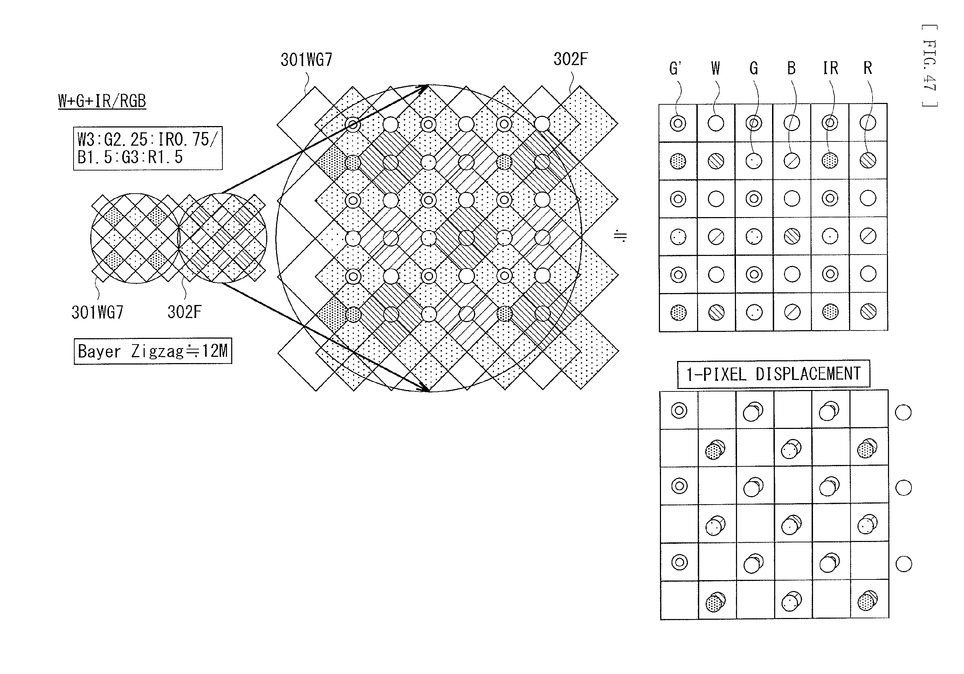

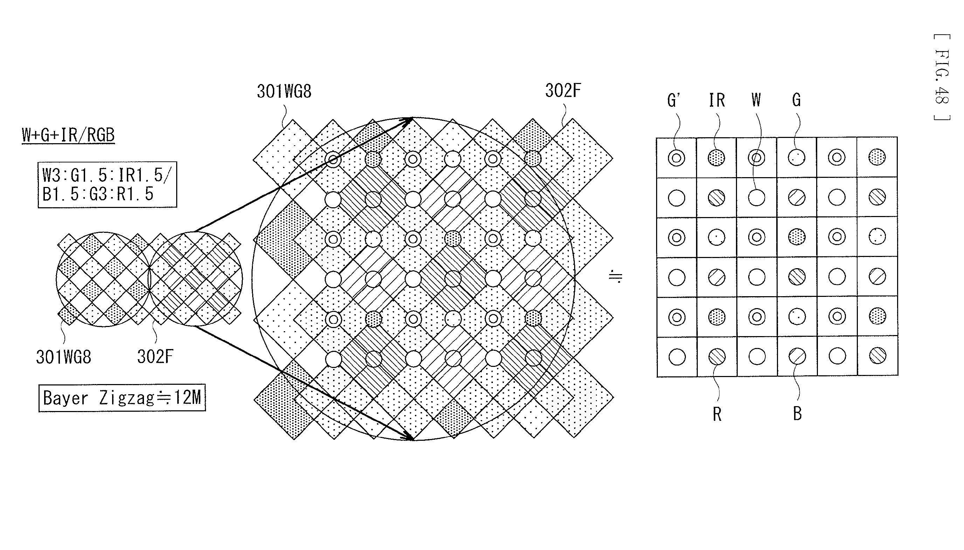

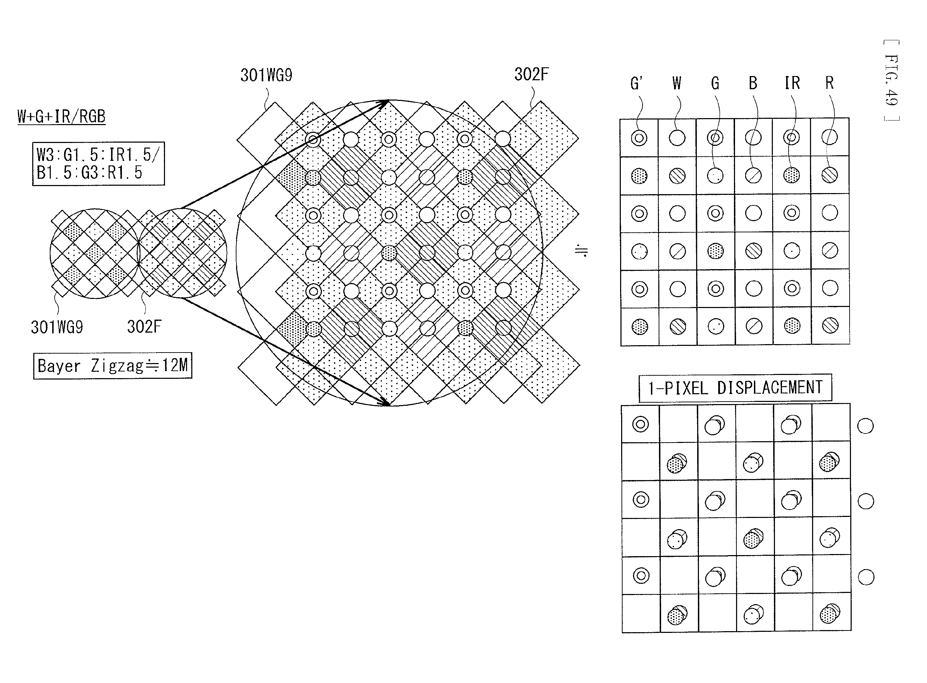

Moreover, as illustrated in FIG. 46, the W pixels and the G pixels, and the IR pixels may be arranged (in a zigzag arrangement) in a first chip 301WG6. The pixel arrangement in the second chip 302F is similar to that in the above-described second configuration example. In this case, the parallax-shifted L/R pixels are allowed to be combined without performing space phase displacement (vertical space pixel displacement) in 2D signal processing. Depth detection is performed with use of the G pixels ("G" in the diagram) in the first chip 301G3 and the G pixels ("G"' in the diagram) in the second chip 302F. Moreover, the G pixels in a first chip WG6 and G' pixels in the second chip 302F are arranged in succession in the vertical and horizontal directions. With such a configuration, an improvement in Depth detection precision, higher sensitivity in brightness and darkness, and higher resolution are achievable. Further, for example, like a first chip WG7 illustrated in FIG. 47, a configuration in which some of the G pixels in the first chip WG3 illustrated in FIG. 43 are replaced with IR pixels may be adopted. Furthermore, for example, like a first chip 301WG8 illustrated in FIG. 48 and a first chip 301WG9 illustrated in FIG. 49, the number of IR pixels may be increased more than that in the above-described first chip 301WG6 to further enhance sensitivity in darkness.

### (4-6. First Example of Binocular 2-chip 3D-ready Signal Processing System to which Super-resolution Technology is Applied)

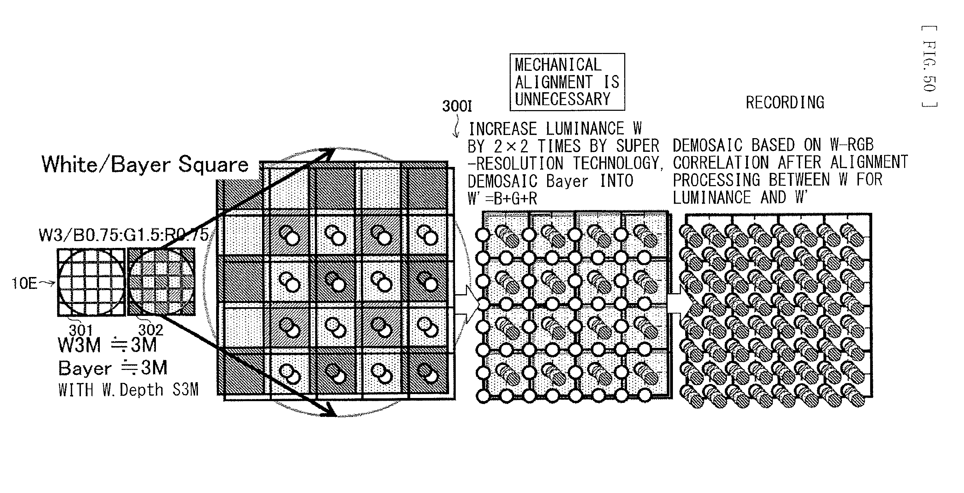

FIG. 50 is a diagram conceptually illustrating a process in which super-resolution technology is applied to the signal processing system of the solid-state image pickup device (MOS image sensor) in FIG. 25.

The signal processing system 300 for the CMOS image sensor 10E in FIG. 25 performs space phase displacement on the L/R pixels parallax-shifted by the parallax correction processing section in a zigzag manner to combine the L/R pixels with each other.

However, in space phase displacement, lens alignment is extremely difficult.

Therefore, in the configuration in FIG. 50, when the number of virtual pixels is increased by 2x2=4 times on a single-color luminance channel (Rch in the present embodiment) side by demosaic technology and super-resolution technology, parallax correction with Lch on RGB side is enabled without performing space phase displacement.

Moreover, a final color image is allowed to be formed as a 2x2=4-times super-resolution image by performing demosaic from correlation of the RGB pixels and the W pixels as the main component pixels for luminance.

### (4-7. Second Example of Binocular 2-chip 3D-ready Signal Processing System to which Super-resolution Technology is Applied)

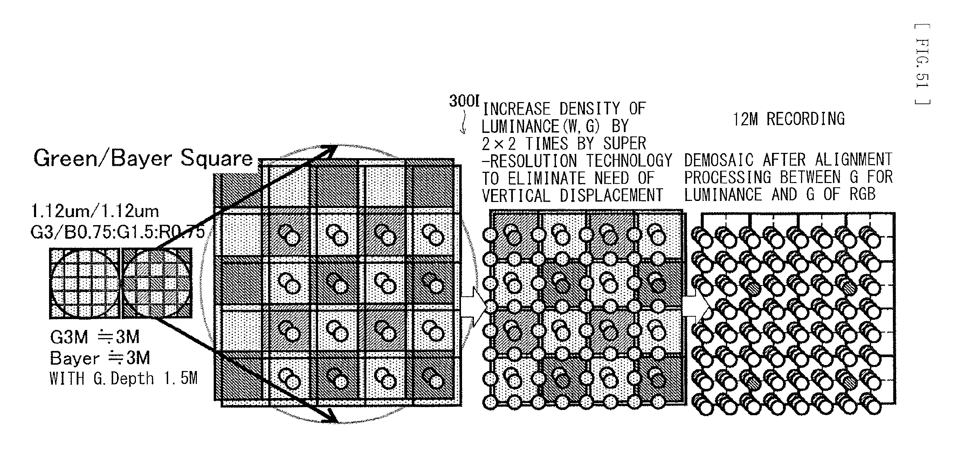

FIG. 51 is a diagram conceptually illustrating a process in which super-resolution technology is applied to the signal processing system of the solid-state image pickup device (MOS image sensor) in FIG. 28.

A signal processing system 300G for the CMOS image sensor 10G in FIG. 28 performs space phase displacement on the L/R pixels parallax-shifted by the parallax correction processing section in a zigzag manner to combine the L/R pixels with each other.

However, in space phase displacement, lens alignment is extremely difficult.

Therefore, in the configuration in FIG. 51, when the number of virtual pixels is increased by 2x2=4 times on a single-color luminance channel (Rch in the present embodiment) side by demosaic technology and super-resolution technology, parallax correction with Lch on RGB side is enabled without performing space phase displacement.

Moreover, a final color image is allowed to be formed as a 2x2=4-times super-resolution image by performing demosaic from correlation of the RGB pixels and the W pixels as the main component pixels for luminance.

As described above, according to the present embodiment, the following effects are allowed to be obtained.

Since luminance of the W pixel and the G pixel is not separated for L and R, 2D resolution is not deteriorated.

In the monocular case, since parallax light condensing is 1/2 with a doubled MLA size, sensitivity is not changed.

A luminance signal is present in one of channels (L/R), density is easily doubled by super-resolution technology, vertical pixel displacement is enabled, and higher resolution is achievable.

High-precision parallax (Depth) information is allowed to be generated by L-RGB addition=full pixel luminance signals of W' and R-W. The present embodiment is applicable to not only 3D but also blurring (panning) and the like with use of the parallax information.

Moreover, in a 2D image, RGB are included only in Lch, and are not displaced (a color artifact is less likely to occur).

Parallax displacement between the luminance W/G' and color pixels RGB does not occur on a focus plane (monocular).

Parallax displacement is allowed to be corrected from a parallax map (Depth map).

Then, according to the present embodiment, a solid-state image pickup device capable of suppressing deterioration in resolution and sensitivity caused by stereo, and reduction in speed and electric power without need for a complicated configuration and complicated signal processing is achievable.

It is to be noted that a back-illuminated type pixel configuration is described as an example in the above-described respective embodiments; however, a laminate type pixel configuration including a photoelectric conversion film may be adopted.

In this case, in the pixel array section 12, basically, photoelectric conversion films that are parts of the unit pixels are arranged in a checkerboard-like zigzag arrangement in which each unit pixel is rotated by, for example, 45° from a square arrangement as a reference.

The solid-state image pickup device having such effects is applicable as an image pickup device of a digital camera or a video camera.

### (5. Configuration Example of Camera System)

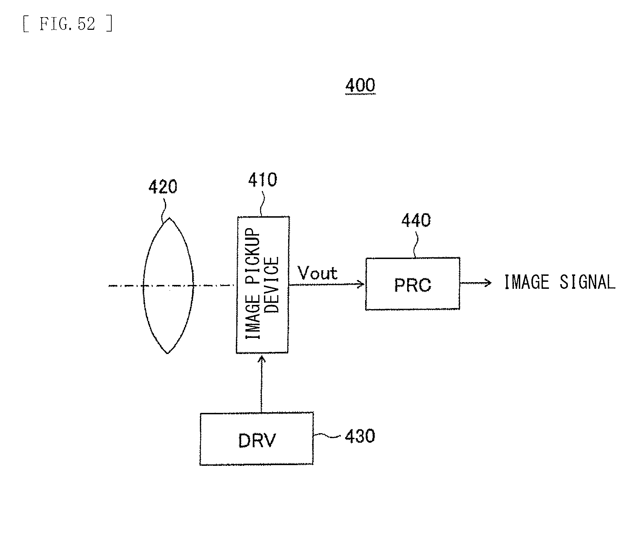

FIG. 52 is a diagram illustrating an example of a configuration of a camera system to which the solid-state image pickup device according to the present embodiment is applied.

As illustrated in FIG. 52, a present camera system 400 includes an image pickup device 410 to which any of the CMOS image sensors (solid-state image pickup devices) 10 and 10A to 10I according to the present embodiment is applicable.

The camera system 400 includes an optical system configured to guide incident light to a pixel region of the image pickup device 410 (to form an image of an object), for example, a lens 420 configured to form an image of the incident light (image light) on an image pickup plane.

The camera system 400 further includes a drive circuit (DRV) 430 configured to drive the image pickup device 410 and a signal processing circuit (PRC) 440 configured to process an output signal of the image pickup device 410.

The drive circuit 430 includes a timing generator (not illustrated) configured to generate various timing signals including a start pulse and a clock pulse for driving of a circuit in the image pickup device 410, and drives the image pickup device 410 by a predetermined timing signal.

Further, the signal processing circuit 440 performs predetermined signal processing on the output signal of the image pickup device 410.

The image signal processed by the signal processing circuit 440 may be recorded in a recording medium such as a memory. A hard copy of image information recorded in the recording medium is produced by a printer or the like. Further, the image signal processed by the signal processing circuit 440 is displayed as a moving image on a monitor configured of a liquid crystal display or the like.

As described above, in an image pickup unit such as a digital still camera, a camera with low power consumption and high precision is achievable by including any one of the above-described solid-state image pickup devices 10, and 10A to 10I as the image pickup device 410.

It is to be noted the present technology may have the following configurations.
(1) A solid-state image pickup device including:
   a pixel array section including a plurality of color pixels and a plurality of main component pixels for luminance that are arranged in an array, the color pixels and the main component pixels for luminance each having a photoelectric conversion function,
   in which the pixel array section includes first and second pixel groups each including a plurality of pixels, the first and second pixel groups having parallax therebetween, and
   the main component pixels for luminance are assigned to the first pixel group, and the color pixels are assigned to the second pixel group.
(2) The solid-state image pickup device according to (1), in which the main component pixels for luminance are pixels having a sensitivity characteristic that has a light reception wavelength peak around a wavelength of 550 nm.
(3) The solid-state image pickup device according to (2), in which the main component pixels for luminance are one or both of W pixels and G pixels.
(4) The solid-state image pickup device according to any one of (1) to (3), in which a pixel having a sensitivity characteristic different from that of the main component pixel for luminance is further assigned to the first pixel group.
(5) The solid-state image pickup device according to (4), in which the pixel having sensitivity characteristic different from that of the main component pixels for luminance is an IR pixel.
(6) The solid-state image pickup device according to any one of (1) to (5), in which
   a plurality of complex pixels in which the color pixel and the main component pixel for luminance each having the photoelectric conversion function are arranged adjacent to each other in a first direction are arranged in an array in the pixel array section,
   the pixel array section includes a multi-lens array in which multi-lenses where light is incident are arranged over the plurality of complex pixels, and
   in each of the complex pixels of the pixel array section, the main component pixel for luminance is disposed on one side in the first direction, and the color pixel is disposed on the other side.
(7) The solid-state image pickup device according to (6), in which the pixel array section is arranged in a state rotated by a predetermined angle from the first direction and a second direction orthogonal to the first direction as references.
(8) The solid-state image pickup device according to any one of (1) to (7), including a signal processing system that generates parallax information based on a main component pixel signal for luminance and a color pixel signal, and generates a two-dimensional image or a three-dimensional image based on the parallax information.
(9) The solid-state image pickup device according to (8), in which the signal processing system performs parallax correction processing by shifting the color pixels based on the parallax information, and generates a two-dimensional image by a signal after the parallax correction processing.
(10) The solid-state image pickup device according to (9), in which the signal processing system generates a three-dimensional image by two-dimensional-to-three-dimensional conversion on the generated two-dimensional image, based on the parallax information.
(11) The solid-state image pickup device according to (8), in which the signal processing system performs parallax correction processing by shifting the main component pixels for luminance based on the parallax information, and generates two-dimensional image by a signal after the parallax correction processing.
(12) The solid-state image pickup device according to (8), in which the signal processing system performs parallax correction processing by shifting the main component pixels for luminance based on the parallax information and combines a signal after the parallax correction processing with the color pixel to generate a parallax image, and directly generates a three-dimensional image.
(13) The solid-state image pickup device according to (8), in which the signal processing system performs parallax correction, when a parallax shift amount is smaller than a horizontal color arrangement cycle, by controlling weighting of a correlation filter coefficient when the main component pixels and the color pixels are combined with each other.
(14) The solid-state image pickup device according to any one of (1) to (13), in which the pixel array section includes
   a first chip in which the main component pixels for luminance are arranged in an array, and
   a second ship in which the color pixels are arranged in an array.
(15) The solid-state image pickup device according to (14), in which, in the pixel array section, the first chip is formed as a square arrangement of the main component pixels for luminance, and the second chip is formed as a square arrangement of the color pixels.
(16) The solid-state image pickup device according to (15), including a signal processing system that generates parallax information based on a main component pixel signal for luminance and a color pixel signal, and performs parallax correction processing by shifting at least one of the main component pixels for luminance and the color pixels based on the parallax information to generate a two-dimensional image or a three-dimensional image,
   in which the signal processing system performs space phase displacement, in a zigzag manner, on a parallax-shifted first parallax image and a parallax-shifted second parallax image to combine the first parallax image and the second parallax image with each other.
(17) The solid-state image pickup device according to (16), in which the signal processing system obtains the number of virtual pixels by increasing the number of main component pixels for luminance by a plurality of times in a first direction and a second direction orthogonal to the first direction to form a super-resolution image.
(18) The solid-state image pickup device according to (14), in which, in the pixel array section, the first chip is formed in a state in which the main component pixels for the luminance are rotated by a predetermined angle from a first direction and a second direction orthogonal to the first direction as references, and the second chip is formed in a state in which the color pixels are rotated at a predetermined angle from the first direction and the second direction orthogonal to the first direction as references.
(19) The solid-state image pickup device according to (18), including a signal processing system that generates parallax information based on a main component pixel signal for luminance and a color pixel signal, and performs parallax correction processing by shifting at least one of the main component pixels for luminance and the color pixels based on the parallax information to generate a two-dimensional image or a three-dimensional image,
   in which the signal processing system combines a parallax-shifted first parallax image and a parallax-shifted second parallax image with each other without performing space phase displacement.
(20) A camera system provided with a solid-state image pickup device and an optical system configured to form an image of an object on the solid-state image pickup device, the solid-state image pickup device including:
   a pixel array section including a plurality of color pixels and a plurality of main component pixels for luminance that are arranged in an array, the color pixels and the main component pixels for luminance each having a photoelectric conversion function,
   in which the pixel array section includes first and second pixel groups each including a plurality of pixels, the first and second pixel groups having parallax therebetween, and
   the main component pixels for luminance are assigned to the first pixel group, and the color pixels are assigned to the second pixel group.

The present disclosure contains subject matter related to that disclosed in Japanese Priority Patent Application No. 2012-6162 filed in the Japan Patent Office on January 16, 2012, the entire content of which is hereby incorporated by reference.

It should be understood by those skilled in the art that various modifications, combinations, sub-combinations, and alterations may occur depending on design requirements and other factors insofar as they are within the scope of the appended claims or the equivalents thereof.

## Claims

1. A solid-state image pickup device comprising:
a pixel array section including a plurality of color pixels and a plurality of main component pixels for luminance that are arranged in an array, the color pixels and the main component pixels for luminance each having a photoelectric conversion function,
wherein the pixel array section includes first and second pixel groups each including a plurality of pixels, the first and second pixel groups having parallax therebetween, and
the main component pixels for luminance are assigned to the first pixel group, and the color pixels are assigned to the second pixel group.

2. The solid-state image pickup device according to claim 1, wherein the main component pixels for luminance are pixels having a sensitivity characteristic that has a light reception wavelength peak around a wavelength of 550 nm.

3. The solid-state image pickup device according to claim 2, wherein the main component pixels for luminance are one or both of W pixels and G pixels.

4. The solid-state image pickup device according to claim 1, wherein a pixel having a sensitivity characteristic different from that of the main component pixel for luminance is further assigned to the first pixel group.

5. The solid-state image pickup device according to claim 4, wherein the pixel having sensitivity characteristic different from that of the main component pixels for luminance is an IR pixel.

6. The solid-state image pickup device according to claim 1, wherein
a plurality of complex pixels in which the color pixel and the main component pixel for luminance each having the photoelectric conversion function are arranged adjacent to each other in a first direction are arranged in an array in the pixel array section,
the pixel array section includes a multi-lens array in which multi-lenses where light is incident are arranged over the plurality of complex pixels, and
in each of the complex pixels of the pixel array section, the main component pixel for luminance is disposed on one side in the first direction, and the color pixel is disposed on the other side.

7. The solid-state image pickup device according to claim 6, wherein the pixel array section is arranged in a state rotated by a predetermined angle from the first direction and a second direction orthogonal to the first direction as references.

8. The solid-state image pickup device according to claim 1, comprising a signal processing system that generates parallax information based on a main component pixel signal for luminance and a color pixel signal, and generates a two-dimensional image or a three-dimensional image based on the parallax information.

9. The solid-state image pickup device according to claim 8, wherein the signal processing system performs parallax correction processing by shifting the color pixels based on the parallax information, and generates a two-dimensional image by a signal after the parallax correction processing.

10. The solid-state image pickup device according to claim 9, wherein the signal processing system generates a three-dimensional image by two-dimensional-to-three-dimensional conversion on the generated two-dimensional image, based on the parallax information.

11. The solid-state image pickup device according to claim 8, wherein the signal processing system performs parallax correction processing by shifting the main component pixels for luminance based on the parallax information, and generates two-dimensional image by a signal after the parallax correction processing.

12. The solid-state image pickup device according to claim 8, wherein the signal processing system performs parallax correction processing by shifting the main component pixels for luminance based on the parallax information and combines a signal after the parallax correction processing with the color pixel to generate a parallax image, and directly generates a three-dimensional image.

13. The solid-state image pickup device according to claim 8, wherein the signal processing system performs parallax correction, when a parallax shift amount is smaller than a horizontal color arrangement cycle, by controlling weighting of a correlation filter coefficient when the main component pixels and the color pixels are combined with each other.

14. The solid-state image pickup device according to claim 1, wherein the pixel array section includes
a first chip in which the main component pixels for luminance are arranged in an array, and
a second ship in which the color pixels are arranged in an array.

15. The solid-state image pickup device according to claim 14, wherein, in the pixel array section, the first chip is formed as a square arrangement of the main component pixels for luminance, and the second chip is formed as a square arrangement of the color pixels.

16. The solid-state image pickup device according to claim 15, comprising a signal processing system that generates parallax information based on a main component pixel signal for luminance and a color pixel signal, and performs parallax correction processing by shifting at least one of the main component pixels for luminance and the color pixels based on the parallax information to generate a two-dimensional image or a three-dimensional image,
wherein the signal processing system performs space phase displacement, in a zigzag manner, on a parallax-shifted first parallax image and a parallax-shifted second parallax image to combine the first parallax image and the second parallax image with each other.

17. The solid-state image pickup device according to claim 16, wherein the signal processing system obtains the number of virtual pixels by increasing the number of main component pixels for luminance by a plurality of times in a first direction and a second direction orthogonal to the first direction to form a super-resolution image.

18. The solid-state image pickup device according to claim 14, wherein, in the pixel array section, the first chip is formed in a state in which the main component pixels for the luminance are rotated by a predetermined angle from a first direction and a second direction orthogonal to the first direction as references, and the second chip is formed in a state in which the color pixels are rotated at a predetermined angle from the first direction and the second direction orthogonal to the first direction as references.

19. The solid-state image pickup device according to claim 18, comprising a signal processing system that generates parallax information based on a main component pixel signal for luminance and a color pixel signal, and performs parallax correction processing by shifting at least one of the main component pixels for luminance and the color pixels based on the parallax information to generate a two-dimensional image or a three-dimensional image,
wherein the signal processing system combines a parallax-shifted first parallax image and a parallax-shifted second parallax image with each other without performing space phase displacement.

20. A camera system provided with a solid-state image pickup device and an optical system configured to form an image of an object on the solid-state image pickup device, the solid-state image pickup device comprising:
a pixel array section including a plurality of color pixels and a plurality of main component pixels for luminance that are arranged in an array, the color pixels and the main component pixels for luminance each having a photoelectric conversion function,
wherein the pixel array section includes first and second pixel groups each including a plurality of pixels, the first and second pixel groups having parallax therebetween, and
the main component pixels for luminance are assigned to the first pixel group, and the color pixels are assigned to the second pixel group.
